(19) Europäisches Patentamt
European Patent Office
Office européen des brevets

(11) EP 2 472 319 B1

(12) **EUROPEAN PATENT SPECIFICATION**

(45) Date of publication and mention of the grant of the patent:
**19.04.2017 Bulletin 2017/16**

(21) Application number: **11195569.6**

(22) Date of filing: **23.12.2011**

(51) Int Cl.:
***G03F 7/00*** *(2006.01)*
***G03F 7/033*** *(2006.01)*
***G03F 7/105*** *(2006.01)*
***C01G 23/00*** *(2006.01)*
***C09C 1/36*** *(2006.01)*
***H01L 27/146*** *(2006.01)*

(54) **Titanium black dispersion composition for a solid state imaging element, black radiation-sensitive composition containing the same, use of the composition for forming a black cured film, method of producing a black cured film**

Titanschwarz-Dispersionszusammensetzung für Abbildungselement in festem Zustand, diese enthaltende schwarze strahlenempfindliche Zusammensetzung, Verwendung dieser Zusammensetzung zur Herstellung eines schwarzen gehärteten Films, Verfahren zur Herstellung eines schwarzen gehärteten Films

Composition de dispersion au noir de titane pour élément d’imagerie à l’état solide, composition noire sensible au rayonnement la contenant, utilisation de la composition pour produire un film durci noir, et procédé de production d’un film durci noir

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **28.12.2010 JP 2010294046**

(43) Date of publication of application:
**04.07.2012 Bulletin 2012/27**

(73) Proprietor: **Fujifilm Corporation**
**Minato-ku**
**Tokyo (JP)**

(72) Inventors:
- **Kubota, Makoto**
**Shizuoka-ken (JP)**
- **Nagata, Yuzo**
**Shizuoka-ken (JP)**

(74) Representative: **Hoffmann Eitle**
**Patent- und Rechtsanwälte PartmbB**
**Arabellastraße 30**
**81925 München (DE)**

(56) References cited:
**EP-A2- 2 490 262**
**WO-A1-2011/049090**
**JP-A- 2001 083 315**
**JP-A- 2006 182 627**

Remarks:
The file contains technical information submitted after the application was filed and not included in this specification

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

**Description**

BACKGROUND OF THE INVENTION

Field of the Invention

The present invention relates to a titanium black dispersion composition, a black radiation-sensitive composition containing the same and a method for producing a black cured film.

Description of the Related Art

Digital cameras and the like are equipped with an imaging unit having high resolution. Such an imaging unit is generally equipped with a solid state imaging element such as a CCD (charge coupled device) image sensor or a CMOS (complementary metal-oxide semiconductor) image sensor. In the solid state imaging element (hereinafter, also referred to as the "image sensor"), an optical black region (dark current measuring region) peripheral circuit is provided at a peripheral edge of a light receiving unit in which many photoelectric conversion elements are arranged, to perform transfer of electric charges, measurement of dark current, magnification of signals, or the like. When light enters this portion, noise may be generated and the image quality of the image sensor may deteriorate. In order to prevent these problems, a light-shielding unit (a black matrix) is provided on the light incident side of this region.

The black matrix is produced through preparing a black radiation-sensitive composition including a black dispersion composition which contains a black coloring material having a light-shielding property dispersed therein, a polymerizable compound, a photopolymerization initiator, and other components, and then forming a pattern using the black radiation-sensitive composition by means of photolithography or the like.

As the composition for forming the black matrix for use in a solid state imaging element, a black radiation-sensitive composition containing a black coloring material such as carbon black, titanium black, or the like is known.

Conventionally, carbon black has been almost exclusively used as a black matrix having a light-shielding property. However, in order to heighten the light-shielding property by using carbon black, it is necessary to increase the filling amount of carbon black. For this reason, a dispersion composition or black radiation-sensitive composition having a high concentration of carbon black, that is a light-shielding material, is required for the pattern formation of a light-shielding layer. However, when the content of carbon black is increased in order to obtain a higher light-shielding property, dispersion of the carbon black becomes difficult, and a problem such as deterioration in pattern formability has also occurred.

The use of titanium black has been proposed as a black coloring material that is capable of providing a high light-shielding property even when used in a thin film (see, for example, Japanese Patent Application Laid-Open (JP-A) No. 2007-115921). However, since titanium black has a large specific gravity, it is difficult to disperse titanium black, and even if titanium black is dispersed, the titanium black may precipitate by aging, and therefore, improvement in dispersibility and dispersion stability has been required.

In order to obtain the high light-shielding property that titanium black has, various techniques of conducting a surface treatment on titanium black particles have also been proposed (see, for example, JP-A Nos. 2002-285007 and 2007-302836). However, even if these techniques are used, the dispersibility is insufficient, and development of a titanium black dispersion composition having a higher dispersion stability has been greatly desired.

On the other hand, since black radiation-sensitive composition layers have light-shielding properties, the exposure light, such as ultraviolet rays, hardly transmits the black radiation-sensitive composition layer when performing pattern formation by photolithography. Therefore, pattern formability is likely to deteriorate, and thus, there have been problems in that development residues are likely to be generated at the peripheral portion of a light-shielding film and sensitivity is low.

As described above, to meet the requirements in terms of the quality of a black matrix having a high light-shielding property, a titanium black dispersion composition having a high light-shielding property has been greatly desired.

WO-A-2011/049090, corresponding to EP-A-2 492 716, prior art pursuant to Article 54(3) EPC, teaches a titanium black dispersion for a wafer level lens comprising: titanium black particles; a dispersant; and an organic solvent, wherein dispersed objects including titanium black particles contain Si atoms. The content ratio of Si atoms to Ti atoms (Si/Ti) in the dispersed objects is 0.05 or higher, preferably from 0.07 to 0.4.

JP-A-2006-182627 discloses a black pigment particle containing a complex of titanium oxynitride and silicon oxide obtained by mixing titanium dioxide and sodium silicate, and subjecting the mixture to a high-temperature reduction treatment. The obtained particles have a specific surface area measured using the BET method of 50-100 $m^2/g$ and a particle diameter between 10 and 30 nm. The Si content of the particle is around 9 wt.%. Such particles may be used in a photosensitive curable resin composition which may further comprise a dispersant, a solvent, a photoinitiator and a curable monomer or oligomer.

SUMMARY OF THE INVENTION

The present invention has been made in view of the above circumstances and aims to accomplish the following.
Namely, an aspect of the present invention provides a titanium black dispersion composition for a solid state imaging element, the titanium black dispersion composition including titanium black and having a high storage stability.
Another aspect of the present invention provides a black radiation-sensitive composition which is capable of providing a pattern that has no roughness at the upper surface thereof and that has good flatness, when the pattern is formed using the black radiation-sensitive composition. Other aspects of the present invention provide a cured film having a colored pattern with a high light-shielding property, which is obtained using the black radiation-sensitive composition, a solid state imaging element having a high image quality by using the same, and a method for producing the cured film.
According to a first aspect, the present invention provides a titanium black dispersion composition for a solid state imaging element, the composition comprising:

(A) particles, or aggregates of particles, which comprise Si atoms and titanium black in the form of black particles having titanium atoms, the particles or aggregates of particles having a BET specific surface area in the range of from 55 $m^2/g$ to 84 $m^2/g$, and a ratio of Si atoms to Ti atoms (Si atoms/Ti atoms) in the range from 0.20-0.41:1 measured in accordance with the method set out in the section headed "Si/Ti Ratio" in the Examples section of the description;
(B) an amphoteric copolymer dispersant of a monomer (b-1) having at least one group selected from an amino group or a nitrogen-containing heterocyclic group, a monomer (b-2) having a carboxyl group, and a macromonomer (b-3) having a weight average molecular weight of from 1,000 to 50,000; and
(C) an organic solvent.

Preferably the macromonomer (b-3) is a polyester macromonomer represented by the formula:

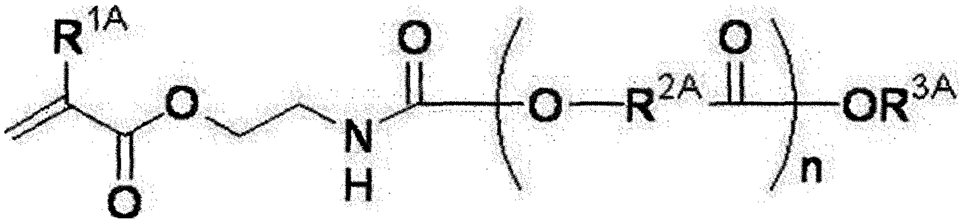

wherein $R^{1A}$ represents a hydrogen atom or a methyl group; $R^{2A}$ represents an alkylene group; $R^{3A}$ represents an alkyl group; n represents an integer of 5 to 100; and plural $R^{2A}$'s present in a molecule may be the same as or different from each other.
According to a second aspect, the present invention provides a black radiation-sensitive composition for a solid state imaging element comprising the titanium black dispersion composition according to the above first aspect, (D) a polymerizable compound, and (E) a photopolymerisation initiator.
According to a third aspect, the present invention provides the use of the black radiation-sensitive composition according to the above second aspect for forming a black cured film.
According to a fourth aspect, the present invention provides a method of producing a black cured film comprising the steps of:

applying the black radiation-sensitive composition according to the above second aspect onto a silicone substrate to form a black radiation-sensitive composition layer,
subjecting the black radiation-sensitive composition layer to pattern light exposure, and
developing the black radiation-sensitive composition layer after the light exposure to form a pattern.

DETAILED DESCRIPTION OF THE INVENTION

Hereinafter, a titanium black dispersion composition for a solid state imaging element according to the invention and a black radiation sensitive composition of the invention containing the same are described in detail.
The titanium black dispersion composition and the radiation sensitive composition of the invention are preferably used for the formation of a light-shielding film which may be provided on a silicone substrate in a solid state imaging element, an anti-reflection film, a light-shielding film disposed at a peripheral region of an effective pixel region (imaging

unit) of a solid state imaging element, or other films.

*Titanium Black Dispersion Composition for Solid State Imaging Element and Black Radiation Sensitive Composition Containing the Same*

The titanium black dispersion composition (hereinafter, may merely be referred to as the "dispersion composition") for a solid state imaging element of the present invention contains at least: (A) particles, or aggregates of particles, which comprise Si atoms and titanium black in the form of black particles having titanium atoms as a substance to be dispersed including titanium black and an Si atom (hereinafter, suitably referred to as a "substance to be dispersed"); (B) a dispersant in the form of a specific amphoteric copolymer dispersant; and (C) an organic solvent, in which the (A) substance to be dispersed has a BET (Brunauer-Emmett-Teller) specific surface area in a range of from 55 $m^2/g$ to 84 $m^2/g$, and the content mass ratio (Si/Ti) of Si atoms and Ti atoms in the substance to be dispersed is in a range of from 0.20 to 0.41.

The black radiation sensitive composition (hereinafter, may merely be referred to as the "radiation sensitive composition") for a solid state imaging element of the present invention is a black radiation sensitive composition containing at least: the titanium black dispersion composition of the present invention; (D) a photopolymerizable compound; and (E) a photopolymerization initiator.

Namely, the radiation sensitive composition of the present invention includes the (A) substance to be dispersed including titanium black and an Si atom, the (B) dispersant, and the (C) organic solvent, which are components of the titanium black dispersion composition of the present invention, in which the (A) substance to be dispersed has a BET specific surface area in a range of from 55 $m^2/g$ to 84 $m^2/g$, and the content mass ratio (Si/Ti) of Si atoms and Ti atoms in the substance to be dispersed is in a range of from 0.20 to 0.41.

Hereinafter, the components which may be included in the titanium black dispersion composition or radiation sensitive composition of the present invention are described one by one.

*(A) Substance to be Dispersed Including Titanium Black and Si Atom*

The titanium black dispersion composition of the invention contains (A) a substance to be dispersed including titanium black and an Si atom. The substance to be dispersed is included in the dispersion composition as a substance to be dispersed and, in the present invention, it is required that the BET specific surface area of the substance to be dispersed is in a range of from 55 $m^2/g$ to 84 $m^2/g$, and the content mass ratio (i.e., Si/Ti) of Si atoms and Ti atoms in the substance to be dispersed is in a range of from 0.20 to 0.41.

Here, the term "substance to be dispersed" used in the invention encompasses both a substance to be dispersed in the state of primary particles and a substance to be dispersed in the state of aggregates (secondary particles).

With regard to the method of preparing the (A) substance to be dispersed, for example, the (A) substance to be dispersed may be obtained through mixing titanium oxide and silica particles, dispersing them using a disperser to obtain a dispersion composition, and then subjecting this dispersion composition to a reduction treatment at a high temperature.

In the present invention, the BET specific surface area of the substance to be dispersed is a value which is measured according to the following method.

The titanium black dispersion composition of the present invention is coated on an arbitrary substrate, and dried to provide a composition layer, then the obtained composition layer is chipped off from the substrate, and then the powder thus obtained is treated in an electric furnace under an oxygen atmosphere at 600°C for 3 hours, thereby removing organic components such as a dispersant by thermal decomposition. Then, 0.2 g of the obtained powder are pre-dried using a mantle heater at 200°C for 12 hours, and then the measurement of specific surface area is carried out using $N_2$ as the atmosphere gas and using AUTOSURB 1MP (trade name, manufactured by Quantachrome Instruments) in accordance with the BET three-point method.

In the present invention, the BET specific surface area of the substance to be dispersed is in a range of from 55 $m^2/g$ to 84 $m^2/g$, and is preferably in a range of from 60 $m^2/g$ to 84 $m^2/g$.

When the BET specific surface area is smaller than the above ranges, the particle diameter is too large, which causes deterioration in stability over time of the dispersion liquid, and when BET specific surface area is larger than the above ranges, the substance to be dispersed is hardly dispersed.

In the present invention, the content mass ratio (Si/Ti) of Si atoms and Ti atoms in the substance to be dispersed is in a range of from 0.20 to 0.41, and is preferably in a range of from 0.20 to 0.35. When the content mass ratio is within the above ranges, production of the titanium black dispersion composition including the substance to be dispersed is easy, dispersion stability is improved, and when a light-shielding film is formed by means of photolithography from a radiation sensitive composition prepared by using the substance to be dispersed, the obtained pattern does not have surface roughness and has good flatness, whereby a high light-shielding property may be obtained.

The substance to be dispersed having a BET specific surface area in a range of from 55 $m^2/g$ to 84 $m^2/g$, and an Si/Ti ratio in a range of from 0.20 to 0.41, may be prepared, for example, by the following method.

For example, in the method including mixing titanium oxide and silica particles, dispersing them to obtain a dispersion composition, and then subjecting this dispersion composition to a reduction treatment at a high temperature, as described above, the intended substance to be dispersed can be obtained by changing the mixing ratio of titanium oxide and silica particles.

For example, the intended substance to be dispersed may be prepared by a method similar to the methods described in (6), paragraph [0005], and paragraphs [0016] to [0021] in JP-A No. 2008-266045.

The substance to be dispersed may have a form in which silica particles are adsorbed to the outside of titanium black particles, a form in which silica particles are fused to the outside of titanium black particles, or the like, and further, a form in which the surfaces of titanium black particles are thoroughly covered, a form in which the surfaces of titanium black particles are partially covered, a form in which silica particles have got into the holes of titanium black particles, or the like may be employed.

The radiation sensitive composition of the present invention contains a substance to be dispersed, which is derived from the titanium black dispersion composition of the present invention. Also with regard to the substance to be dispersed contained in the black radiation sensitive composition or in a cured film (light-shielding film) which is obtained by curing the black radiation sensitive composition, the BET specific surface area of the substance to be dispersed is in a range of from 55 $m^2/g$ to 84 $m^2/g$, and the content ratio (Si/Ti) of Si atoms and Ti atoms in the substance to be dispersed is in a range of from 0.20 to 0.41, and the preferable ranges are also the same as those described above.

In the present invention, the BET specific surface area of the substance to be dispersed is in a range of from 55 $m^2/g$ to 84 $m^2/g$, and the content mass ratio (Si/Ti) of Si atoms and Ti atoms in the substance to be dispersed is in a range of from 0.20 to 0.41. By having such a configuration, the storage stability of the radiation sensitive composition of the invention containing the substance to be dispersed is good, and when a light-shielding film is formed using the radiation sensitive composition, surface roughness of the pattern formed from the radiation sensitive composition is not generated, in the area other than the region where the light-shielding film is formed, and flatness is good. Note that, the residues include a component, which is derived from the black radiation sensitive composition, such as a substance to be dispersed, a resin component, or the like.

The reason why the surface roughness is not generated on the pattern and the flatness is good is not clear, but it is assumed as follows. Namely, the substance to be dispersed as described above tends to have a smaller particle diameter (for example, the particle diameter is 30 nm or less), and further, when the amount of a component including an Si atom in the substance to be dispersed is increased, the interaction between the substance to be dispersed and the dispersant gets greater. As a result, resistance to a developing solution of the upper face of the formed pattern is improved, whereby the surface roughness on the upper face of the pattern is reduced.

Moreover, since titanium black has excellent light-shielding property with respect to light in a wavelength region over a wide range of from ultraviolet to infrared, the light-shielding film, which is formed using the titanium black dispersion composition or the radiation sensitive composition of the present invention, exerts excellent light-shielding property.

Regarding the substance to be dispersed which is incorporated in the titanium black dispersion composition or the radiation sensitive composition of the present invention, to judge whether the BET specific surface area is within the range of from 55 $m^2/g$ to 84 $m^2/g$ or not, it is enough to use the method of measuring the specific surface area and judge whether the obtained specific surface area is within the range of from 55 $m^2/g$ to 84 $m^2/g$ or not.

Hereinafter, titanium black is described in more detail.

In the present invention, titanium black refers to black particles having a titanium atom, and preferably black particles of low-order titanium oxide, titanium oxinitride, or the like.

The particle surfaces of titanium black may be modified depending on the purposes such as improvement in dispersibility, suppression of aggregation property, or the like. Specifically, examples of the modification of the particle surfaces include a coating treatment with silicon oxide, titanium oxide, germanium oxide, aluminum oxide, magnesium oxide, zirconium oxide, or the like, and a treatment with a water-repellent substance such as described in JP-A No. 2007-302836. The Si/Ti ratio may be changed by a surface treatment with a material including silicon; however, the Si amount detected in the surface treatment using a silicon compound is extremely small, so that it may be ignored.

Examples of commercially available products of titanium black particles include TITANIUM BLACK 10S, 12S, 13R, 13M, 13M-C, 13R, 13R-N, and 13M-T (all trade names, manufactured by Mitsubishi Materials Corporation), and TILACK D (trade name, manufactured by Ako Kasei Co., Ltd.).

Examples of a method for producing titanium black include, but are not limited to, a method of heating and reducing a mixture of titanium dioxide and metal titanium in a reducing atmosphere (for example, a method described in JP-A No. 49-5432); a method of subjecting ultra-fine titanium dioxide obtained through high-temperature hydrolysis of titanium tetrachloride to a reduction treatment in a hydrogen-containing reducing atmosphere (for example, a method described in JP-A No. 57-205322); a method of reducing titanium dioxide or titanium hydroxide at a high temperature in the presence of ammonia (for example, a method described in JP-A Nos. 60-65069 or 61-201610); and a method of

adhering titanium dioxide or titanium hydroxide to a vanadium compound, followed by carrying out a high temperature reduction in the presence of ammonia (for example, a method described in JP-A No. 61-201610).

Concerning the titanium black to be applied to the present invention, it is preferable that the primary particle diameter of each particle and the average primary particle diameter are both small.

In the present invention, the titanium black dispersion composition and the radiation sensitive composition may include only one type of the substance to be dispersed, or may include two or more types of the substances to be dispersed.

As far as the effects of the present invention are not impaired, at least one black pigment formed from a composite oxide of Cu, Fe, Mn, V, Ni, or the like, cobalt oxide, iron oxide, carbon black, aniline black, or the like may be used as a substance to be dispersed in combination with the substance to be dispersed, for the purpose of adjusting dispersibility, coloring property, or the like.

In this case, it is preferable that the substance to be dispersed (i.e., the substance to be dispersed (A) in the invention) occupies 50% by mass or more of the total black pigments to be used.

As described below, as far as the effects of the present invention are not impaired, other colorants (such as organic pigments, dyes, or the like) may also be used together with the substance to be dispersed, as desired, for the purpose of adjusting the light-shielding property or the like.

The content of the substance to be dispersed in the titanium black dispersion composition is preferably from 5% by mass to 60% by mass, and more preferably from 10% by mass to 50% by mass, with respect to the total content of solids in the dispersion composition.

Further, the content of the substance to be dispersed in the radiation sensitive composition is preferably from 2.5% by mass to 30% by mass, and more preferably from 5% by mass to 20% by mass, with respect to the total content of solids in the radiation sensitive composition.

Herein, the expression the "total content of solids in the dispersion composition" or the "total content of solids in the radiation sensitive composition" means the mass calculated by removing the mass of organic solvent from the total mass of the dispersion composition or the radiation sensitive composition.

In the present invention, it is required that the content ratio (Si/Ti) of Si atoms and Ti atoms in the substance to be dispersed in terms of mass is in a range of from 0.20 to 0.41 in terms of mass.

Hereinafter, the material used in the introduction of Si atom into the substance to be dispersed is described. To introduce an Si atom into the substance to be dispersed, an Si-containing substance such as silica may be used.

Examples of the silica which may be used in the present invention may include precipitated silica, foamed silica, colloidal silica, and synthetic silica, and one or more among them may be selected as appropriate and used.

Silica is also commercially available, and examples of commercially available products which can be used include HS-101, His-102, HS-103, HS-104, HS-105, HS-106, HS-107, HS-201, HS-202, HS-203, HS-204, HS-205, HS-301, HS-302, HS-303, HS-304, and HS-305 (all trade names, manufactured by Nippon Steel Materials Co., Ltd.); HIPRESICA SS, HIPRESICA TS, HIPRESICA BS, HIPRESICA SP, and HIPRESICA FQ (all trade names, manufactured by Ube-Nitto Kasei Co., Ltd.); and CAB-O-SIL (registered trademark) LM-150, and CAB-O-SIL (registered trademark) S-17D (all trade names, manufactured by Cabot Corporation).

In the formation of a light-shielding film according to the present invention, when the particle diameter of a silica particle is almost the same as the film thickness, deterioration in light-shielding property may be induced. Therefore, it is preferable to use fine particle silica as the silica particles. Examples of the fine particle silica which can be used include, but are not limited to, AEROSIL (registered trademark) 90, AEROSIL (registered trademark) 130, AEROSIL (registered trademark) 150, AEROSIL (registered trademark) 200, AEROSIL (registered trademark) 300, AEROSIL (registered trademark) 380, AEROSIL (registered trademark) OX 50, AEROSIL (registered trademark) EG 50, AEROSIL (registered trademark) TT 600, AEROSIL (registered trademark) 200 SP, AEROSIL (registered trademark) 300 SP, AEROPERL (registered trademark) 300/30, AEROSIL (registered trademark) R 972, AEROSIL (registered trademark) R 974, AEROSIL (registered trademark) R 104, AEROSIL (registered trademark) R 106, AEROSIL (registered trademark) R 202, AEROSIL (registered trademark) R 805, AEROSIL (registered trademark) R 812, AEROSIL (registered trademark) R 812 S, AEROSIL (registered trademark) R 816, AEROSIL (registered trademark) R 7200, AEROSIL (registered trademark) R 8200, AEROSIL (registered trademark) R 9200, AEROSIL (registered trademark) MOX 80, AEROSIL (registered trademark) MOX 170, AEROSIL (registered trademark) COK 84, AEROSIL (registered trademark) RY 50, AEROSIL (registered trademark) NY 50, AEROSIL (registered trademark) RY 200, AEROSIL (registered trademark) RX 50, AEROSIL (registered trademark) NAX 50, AEROSIL (registered trademark) RX 200, AEROSIL (registered trademark) RX 300, AEROSIL (registered trademark) R 504, AEROPERL (registered trademark) 300/30, and VP AEROPERL (registered trademark) P 25/20M05 (all trade names); S6, MA1004, MA1006, MA1010, MA1013, MX030W, MX050W, MX100W, KE-E30, KE-E40, KE-E50, KE-E70, KE-E150, KE-P10, KE-P30, KE-P50, KE-P100, KE-P150, and KE-P250 (all trade names, manufactured by Catalysts & Chemicals Industries, Co., Ltd.); HS-101, HS-102, HS-103, HS-104, HS-105, HS-106, HS-107, HS-201, HS-202, HS-203, HS-204, HS-205, HS-301, HS-302, HS-303, HS-304, and HS-305 (all trade names, manufactured by Nippon Steel Materials Co., Ltd.); HIPRESICA SS, HIPRESICA TS, HIPRESICA BS, HIPRESICA SP, and HIPRESICA FQ (all trade names, manufactured by Ube-Nitto Kasei Co., Ltd.); and CAB-O-SIL (registered

trademark) LM-150, and CAB-O-SIL (registered trademark) S-17D (all trade names, manufactured by Cabot Corporation).

*(B) Dispersant*

The titanium black dispersion composition and the radiation sensitive composition of the present invention contain the amphoteric copolymer described below as the dispersant (B). Namely, a copolymer (hereinafter, suitably referred to as "specific resin B") of (b-1) a monomer having at least one group selected from an amino group or a nitrogen-containing heterocyclic group, (b-2) a monomer having a carboxyl group, and (b-3) a macromonomer having a weight average molecular weight of from 1,000 to 50,000.

Hereinafter, the specific resin B is described in detail.

The specific resin B is produced through copolymerization using, as raw materials, (b-1) a monomer having at least one group selected from an amino group or a nitrogen-containing heterocyclic group, (b-2) a monomer having a carboxyl group, (b-3) a macromonomer having a weight average molecular weight of from 1,000 to 50,000 and, if necessary, any other monomer.

In what follows, the (b-1) monomer having at least one group selected from an amino group or a nitrogen-containing heterocyclic group, the (b-2) monomer having a carboxyl group, and the (b-3) macromonomer having a weight average molecular weight of from 1,000 to 50,000, which are the raw materials used to obtain the specific resin B, are described.

*(b-1) Monomer Having at Least One Group Selected from Amino Group or Nitrogen-Containing Heterocyclic Group*

The (b-1) monomer having at least one group selected from an amino group or a nitrogen-containing heterocyclic group (hereinafter, suitably referred to as the "monomer (b-1)" is a monomer which has at least one group selected from an amino group or a nitrogen-containing heterocyclic group and has a molecular weight of from 50 to 1,000.

Examples of the amino group in the monomer (b-1) include primary, secondary, and tertiary amino groups. From the viewpoint of dispersion stability, the amino group is preferably a secondary amino group or a tertiary amino group, and more preferably a tertiary amino group. As the amino group, an amino group which has a straight chain or branched alkyl group having 1 to 10 carbon atoms, a cycloalkyl group having 3 to 10 carbon atoms, or an aryl group having 6 to 15 carbon atoms is preferable, and an amino group which has a straight chain or branched alkyl group having 1 to 5 carbon atoms is most preferable. Specific examples of the amino group include -NHMe, -NHEt, -NHPr, -NHiPr, -NHBu, -NH(tert-Bu), $-NMe_2$, $-NEt_2$, $-NPr_2$, $-NPh_2$, and a morpholino group. (Here, Me represents a methyl group; Et represents an ethyl group; Pr represents a propyl group; Bu represents a butyl group; and Ph represents a phenyl group.)

The nitrogen-containing heterocyclic group in the monomer (b-1) is a cyclic substituent having at least one nitrogen atom in the ring structure. The ring structure may be a saturated ring or an unsaturated ring, may be a monocycle or a condensed ring, and may be unsubstituted or substituted. Further, the nitrogen-containing heterocyclic group derived from the monomer (b-1) may be contained in the side chain structure or may be contained in the main chain structure in the specific resin B, but is preferably contained in the side chain structure from the viewpoints of dispersibility and dispersion stability.

Specific examples of the nitrogen-containing heterocyclic group include pyrrolizine, pyrroline, tetrahydropyridine, piperazine, homopiperazine, piperidine, triazine, morpholine, hexamethylenetetramine, diazabicycloundecene, decahydroquinoline, diazabicyclooctane, pyrrolidinone, $\delta$-valerolactam, succinimide, glutarimide, imidazolidone, tetrahydropyrimidone, urazole, dihydrouracil, barbituric acid, indole, carbazole, julolidine, phenoxazine, phenothiazine, oxindole, phenanthridinone, isatine, phthalimide, diiminoisoindoline, iminoisoindolinone, diiminobenzisoindoline, naphthalimide, quinazolinedione, pyrrole, porphyrin, a porphyrin metal complex, phthalocyanine, a phthalocyanine metal complex, naphthalocyanine, a naphthalocyanine metal complex, pyrazole, imidazole, triazole, tetrazole, isoxazole, oxazole, isothiazole, thiazole, thiadiazole, thiatriazole, iminostilbene, azaindole, indazole, benzimidazole, benzotriazole, azabenzimidazole, anthranil, benzisoxazole, benzoxazole, benzothiazole, benzofurazan, benzothiadiazole, triazole-pyrimidine, triazole-pyridine, purine, xanthine, pyridine, pyridazine, pyrimidine, pyrimidone, uracil, pyrazine, quinoline, acridine, cinnoline, benzocinnoline, quinoxaline, quinazoline, quinoxaline, phenazine, phenanthroline, perimidine, and acridone. These nitrogen-containing heterocyclic groups may be unsubstituted or substituted.

More preferable examples of the nitrogen-containing heterocyclic group include indole, carbazole, phenoxazine, phenothiazine, oxindole, phenanthridinone, isatine, phthalimide, diiminoisoindoline, iminoisoindolinone, diiminobenzisoindoline, naphthalimide, quinazolinedione, pyrrole, pyrazole, imidazole, triazole, tetrazole, isoxazole, oxazole, isothiazole, thiazole, thiadiazole, thiatriazole, iminostilbene, azaindole, indazole, benzimidazole, benzotriazole, azabenzimidazole, anthranil, benzisoxazole, benzoxazole, benzothiazole, benzofurazan, benzothiadiazole, triazole-pyrimidine, triazole-pyridine, purine, xanthine, pyridine, pyridazine, pyrimidine, pyrimidone, uracil, pyrazine, quinoline, acridine, cinnoline, benzocinnoline, quinoxaline, quinazoline, quinoxaline, phenazine, phenanthroline, and acridone.

Examples of the substituent that the nitrogen-containing heterocyclic group in the monomer (b-1) may have

include a halogen atom, an alkyl group, a cycloalkyl group, an alkenyl group, a cycloalkenyl group, an alkynyl group, an aryl group, a heterocyclic group, a cyano group, a hydroxyl group, a nitro group, a carboxyl group, an alkoxy group, an aryloxy group, a silyloxy group, a heterocyclic oxy group, an acyloxy group, a carbamoyloxy group, an alkoxycarbonyloxy group, an aryloxycarbonyloxy group, an amino group (including an alkylamino group and an anilino group), an acylamino group, an aminocarbonylamino group, an alkoxycarbonylamino group, an aryloxycarbonylamino group, a sulfamoylamino group, an alkylsulfonylamino group, an arylsulfonylamino group, a mercapto group, an alkylthio group, an arylthio group, a heterocyclic thio group, a sulfamoyl group, a sulfo group, an alkylsulfinyl group, an arylsulfinyl group, an alkylsulfonyl group, an arylsulfonyl group, an acyl group, an aryloxycarbonyl group, an alkoxycarbonyl group, a carbamoyl group, an arylazo group, a heterocyclic azo group, an imido group, a phosphino group, a phosphinyl group, a phosphinyloxy group, a phosphinylamino group, and a silyl group.

Hereinafter, the substituents which the nitrogen-containing heterocyclic group may have will be described in more detail.

Examples of the substituent include:

a halogen atom such as a fluorine atom, a chlorine atom, a bromine atom or an iodine atom;

a linear or branched, substituted or unsubstituted alkyl group, and preferably an alkyl group having 1 to 30 carbon atoms, such as a methyl group, an ethyl group, a n-propyl group, an isopropyl group, a t-butyl group, a n-octyl group, a 2-chloroethyl group, a 2-cyanoethyl group or a 2-ethylhexyl group;

a cycloalkyl group, and preferably, a substituted or unsubstituted cycloalkyl group having 3 to 30 carbon atoms, such as a cyclohexyl group or a cyclopentyl group, or a cycloalkyl group having a polycyclic structure, such as a bicycloalkyl group (preferably a substituted or unsubstituted bicycloalkyl group having 5 to 30 carbon atoms, for example, bicyolo[1,2,2]heptan-2-yl or bicyclo[2,2,2]octan-3-yl) and a tricycloalkyl group, and more preferably, a monocyclic cycloalkyl group and a bicycloalkyl group, and particularly preferably a monocyclic cycloalkyl group;

an alkenyl group (a straight chain or branched, substituted or unsubstituted alkenyl group, and preferably an alkenyl group having 2 to 30 carbon atoms, for example, a vinyl group, an allyl group, a prenyl group, a geranyl group, or an oleyl group);

a cycloalkenyl group (preferably, a substituted or unsubstituted cycloalkenyl group having 3 to 30 carbon atoms, for example, 2-cyclopenten-1-yl or 2-cyclohexen-1-yl, or a cycloalkenyl group having a polycyclic structure, for example, a bicycloalkenyl group (preferably a substituted or unsubstituted bicycloalkenyl group having 5 to 30 carbon atoms, for example, bicyclo[2,2,1]hept-2-en-1-yl, or bicyclo[2,2,2]oct-2-en-4-yl) or a tricycloalkenyl group, and particularly preferably a monocyclic cycloalkenyl group);

an alkynyl group (preferably, a substituted or unsubstituted cycloalkynyl group having 2 to 30 carbon atoms, for example, an ethynyl group, a propargyl group, or a trimethylsilylethynyl group);

an aryl group (preferably, a substituted or unsubstituted aryl group having 6 to 30 carbon atoms, for example, a phenyl group, a p-tolyl group, a naphthyl group, a m-chlorophenyl group, or an o-hexadecanoylaminophenyl group);

a heterocyclic group (preferably a 5- to 7-membered, substituted or unsubstituted, saturated or unsaturated, aromatic or non-aromatic, monocyclic or condensed heterocyclic group, and more preferably a heterocyclic group in which the constituent atoms of the ring are selected from the group consisting of a carbon atom, a nitrogen atom, and a sulfur atom, and which has at least one heteroatom of a nitrogen atom, an oxygen atom, or a sulfur atom, and more preferably a 5- or 6-membered aromatic heterocyclic group having 3 to 30 carbon atoms, for example, a 2-furyl group, a 2-thienyl group, a 2-pyridyl group, a 4-pyridyl group, a 2-pyrimidinyl group, or a 2-benzothiazolyl group); a cyano group; a hydroxyl group; a nitro group; a carboxyl group;

an alkoxy group (preferably, a substituted or unsubstituted alkoxy group having 1 to 30 carbon atoms, for example, a methoxy group, an ethoxy group, an isopropoxy group, a t-butoxy group, a n-octyloxy group, or a 2-methoxyethoxy group); an aryloxy group (preferably, a substituted or unsubstituted aryloxy group having 6 to 30 carbon atoms, for example, a phenoxy group, a 2-methylphenoxy group, a 2,4-di-t-aminophenaxy group, a 4-t-butylphenoxy group, a 3-nitrophenoxy group, or a 2-tetradecanoylaminophenoxy group); a silyloxy group (preferably, a silyloxy group having 3 to 20 carbon atoms, for example, a trimethylsilyloxy group or a t-butyldimethylsilyloxy group); a heterocyclic oxy group (preferably, a substituted or unsubstituted heterocyclic oxy group having 2 to 30 carbon atoms, in which the heterocycle moiety is preferably the heterocycle moiety described above for the heterocyclic group, for example, a 1-phenyltetrazol-5-oxy group or a 2-tetrahydropyranyloxy group);

an acyloxy group (preferably, a formyloxy group, a substituted or unsubstituted alkylcarbonyloxy group having 2 to 30 carbon atoms, or a substituted or unsubstituted arylcarbonyloxy group having 6 to 30 carbon atoms, for example, a formyloxy group, an acetyloxy group, a pivaloyloxy group, a stearoyloxy group, a benzoyloxy group, or a p-methoxyphenylcarbonyloxy group); a carbamoyloxy group (preferably, a substituted or unsubstituted carbamoyloxy group having 1 to 30 carbon atoms, for example, a N,N-dimethylcarbamoyloxy group, a N,N-diethylcarbamoyloxy group, a morpholinocarbonyloxy group, a N,N-di-n-octylaminocarbonyloxy group, or a N-n-octylcarbamoyloxy group); an alkoxycarbonyloxy group (preferably, a substituted or unsubstituted alkoxycarbonyloxy group having 2

to 30 carbon atoms, for example, a methoxycarbonyloxy group, an ethoxycarbonyloxy group, a t-butoxycarbonyloxy group, or a n-octylcarbonyloxy group); an aryloxycarbonyloxy group (preferably, a substituted or unsubstituted aryloxycarbonyloxy group having 7 to 30 carbon atoms, for example, a phenoxycarbonyloxy group, a p-methoxyphenoxycarbonyloxy group, or a p-n-hexadecyloxyphenoxycarbonyloxy group);
an amino group (preferably, an amino group, a substituted or unsubstituted alkylamino group having 1 to 30 carbon atoms, a substituted or unsubstituted arylamino group having 6 to 30 carbon atoms, or a heterocyclic amino group having 0 to 30 carbon atoms, for example, an amino group, a methylamino group, a dimethylamino group, an anilino group, a N-methylanilino group, a diphenylamino group, or a N-1,3,5-triazin-2-ylamino group); an acylamino group (preferably, a formylamino group, a substituted or unsubstituted alkylcarbonylamino group having 1 to 30 carbon atoms, or a substituted or unsubstituted arylcarbonylamino group having 6 to 30 carbon atoms, for example, a formylamino group, an acetylamino group, a pivaloylamino group, a lauroylamino group, a benzoylamino group, or a 3,4,5-tri-n-octyloxyphenylcarbonylamino group); an aminocarbonylamino group (preferably, a substituted or unsubstituted aminocarbonylamino group having 1 to 30 carbon atoms, for example, a carbamoylamino group, a N,N-dimethylaminocarbonylamino group, a N,N-diethylaminocarbonylamino group, or a morpholinocarbonylamino group); an alkoxycarbonylamino group (preferably, a substituted or unsubstituted alkoxycarbonylamino group having 2 to 30 carbon atoms, for example, a methoxycarbonylamino group, an ethoxycarbonylamino group, a t-butoxycarbonylamino group, a n-octadecyloxycarbonylamino group, a or N-methyl-methoxycarbonylamino group);
an aryloxycarbonylamino group (preferably, a substituted or unsubstituted aryloxycarbonylamino group having 7 to 30 carbon atoms, for example, a phenoxycarbonylamino group, a p-chlorophenoxycarbonylamino group, or a m-n-octyloxyphenoxycarbonylamino group); a sulfamoylamino group (preferably, a substituted or unsubstituted sulfamoylamino group having 0 to 30 carbon atoms, for example, a sulfamoylamino group, a N,N-dimethylaminosulfonylamino group, or a N-n-octylaminosulfonylamino group); an alkylsulfonylamino group and an arylsulfonylamino group (preferably, a substituted or unsubstituted alkylsulfonylamino group having 1 to 30 carbon atoms and a substituted or unsubstituted arylsulfonylamino group having 6 to 30 carbon atoms, for example, a methylsulfonylamino group, a butylsulfonylamino group, a phenylsulfonylamino group, a 2,3,5-trichlorophenylsulfonylamino group, or a p-methylphenylsulfonylamino group); a mercapto group;
an alkylthio group (preferably, a substituted or unsubstituted alkylthio group having 1 to 30 carbon atoms, for example, a methylthio group, an ethylthio group, or a n-hexadecylthio group); an arylthio group (preferably, a substituted or unsubstituted arylthio group having 6 to 30 carbon atoms, for example, a phenylthio group, a p-chlorophenylthio group, or a m-methoxyphenylthio group); a heterocyclic thio group (preferably, a substituted or unsubstituted heterocyclic thio group having 2 to 30 carbon atoms, in which the heterocycle moiety is preferably the heterocycle moiety described above for the heterocyclic group, for example, a 2-benzothiazolylthio group or a 1-phenyltetrazol-5-ylthio group); a sulfamoyl group (preferably, a substituted or unsubstituted sulfamoyl group having 0 to 30 carbon atoms, such as a N-ethylsulfamoyl group, a N-(3-dodecyloxypropyl)sulfamoyl group, a N,N-dimethylsulfamoyl group, a N-acetylsufamoyl group, a N-benzoylsulfamoyl group, or a N-(N'-phenylcarbamoyl)sulfamoyl group); a sulfo group;
an alkylsulfinyl group and an arylsulfinyl group (preferably, a substituted or unsubstituted alkylsulfinyl group having 1 to 30 carbon atoms and a substituted or unsubstituted arylsulfinyl group having 6 to 30 carbon atoms, for example, a methylsulfinyl group, an ethylsulfinyl group, a phenylsulfinyl group, or a p-methylphenylsulfinyl group); an alkylsulfinyl group and an arylsulfonyl group (preferably, a substituted or unsubstituted alkylsulfonyl group having 1 to 30 carbon atoms and a substituted or unsubstituted arylsulfonyl group having 6 to 30 carbon atoms, for example, a methylsulfonyl group, an ethylsulfonyl group, a phenylsulfonyl group, or a p-methylphenylsulfonyl group); an acyl group (preferably a formyl group, a substituted or unsubstituted alkylcarbonyl group having 2 to 30 carbon atoms, or a substituted or unsubstituted arylcarbonyl group having 7 to 30 carbon atoms, for example, an acetyl group, a pivaloyl group, a 2-chloroacetyl group, a stearoyl group, a benzoyl group, or a p-n-octyloxyphenylcarbonyl group); an aryloxycarbonyl group (preferably, a substituted or unsubstituted aryloxycarbonyl group having 7 to 30 carbon atoms, for example, a phenoxycarbonyl group, an o-chlorophenoxycarbonyl group, a m-nitrophenoxycarbonyl group, or a p-t-butylphenoxycarbonyl group);
an alkoxycarbonyl group (preferably, a substituted or unsubstituted alkoxycarbonyl group having 2 to 30 carbon atoms, for example, a methoxycarbonyl group, an ethoxycarbonyl group, a t-butoxycarbonyl group, or a n-octadecyloxycarbonyl group); a carbamoyl group (preferably, a substituted or unsubstituted carbamoyl group having 1 to 30 carbon atoms, for example, a carbamoyl group, a N-methylcarbamoyl group, a N,N-dimethylcarbamoyl group, a N,N-di-n-octylcarbamoyl group, or a N-(methylsulfonyl)carbamoyl group); an arylazo group and a heterocyclic azo group (preferably, a substituted or unsubstituted arylazo group having 6 to 30 carbon atoms and a substituted or unsubstituted heterocyclic azo group having 3 to 30 carbon atoms (in which the heterocycle moiety is preferably the heterocycle moiety described above for the heterocyclic group), for example, a phenylazo group, a p-chlorophenylazo group, or a 5-ethylthio-1,3,4-thiadiazol-2-ylazo group); an imido group (preferably, a substituted or unsubstituted imido group having 2 to 30 carbon atoms, for example, a N-succinimido group or a N-phthalimido group); a phosphino group (preferably, a substituted or unsubstituted phosphino group having 2 to 30 carbon atoms, for

example, a dimethylphosphino group, a diphenylphosphino group, or a methylphenoxyphosphino group): a phosphinyl group (preferably, a substituted or unsubstituted phosphinyl group having 2 to 30 carbon atoms, for example, a phosphinyl group, a dioctyloxyphosphinyl group, or a diethoxyphosphinyl group);
a phosphinyloxy group (preferably, a substituted or unsubstituted phosphinyloxy group having 2 to 30 carbon atoms, for example, a diphenoxyphosphinyloxy group or a dioctyloxyphosphinyloxy group); a phosphinylamino group (preferably, a substituted or unsubstituted phosphinylamino group having 2 to 30 carbon atoms, for example, a dimethoxyphosphinylamino group or a dimethylaminophosphinylamino group); and a silyl group (preferably, a substituted or unsubstituted silyl group having 3 to 30 carbon atoms, for example, a trimethylsilyl group, a t-butyldimethylsilyl group, or a phenyldimethylsilyl group).

Among the functional groups described above, the functional groups having a hydrogen atom may be substituted by any of the groups described above, after removing the hydrogen atom. Examples of such functional groups include an alkylcarbonylaminosulfonyl group, an arylcarbonylaminosulfonyl group, an alkylsulfonylaminocarbonyl group, and an arylsulfonylaminocarbonyl group, and specific examples thereof include a methylsulfonylaminocarbonyl group, a p-methylphenylsulfonylaminocarbonyl group, an acetylaminosulfonyl group, and a benzoylaminosulfonyl group.

The monomer (b-1) is preferably a monomer having an amino group, a pyridinyl group, an imidazoyl group, a phthalimido group, a naphthalimido group, a benzimidazole group, or an acridone group, from the viewpoints of dispersion stability, developability, and light fastness. The monomer (b-1) is more preferably a monomer having an amino group or a naphthalimido group.

As the monomer (b-1), a known monomer which has at least one group selected from an amino group or a nitrogen-containing heterocyclic group and has a molecular weight of from 50 to 1,000 may be used. From the viewpoint of polymerizability, the monomer is preferably an acrylic monomer or a styrene monomer, and most preferably an acrylic ester monomer represented by the following Formula (K) or a styrene monomer represented by the following Formula (L). When such a monomer is used, the specific resin B has an amino group or a nitrogen-containing heterocyclic group, which is capable of strongly interacting with a substance to be dispersed, in the side chain portion. As a result, dispersion stability and light fastness of the titanium black dispersion composition and the radiation-sensitive composition may be improved.

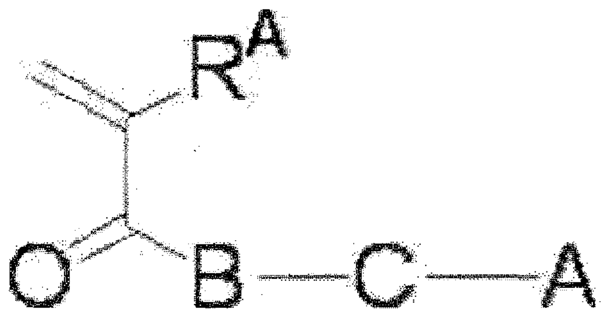

(K)

In Formula (K), $R^A$ represents a hydrogen atom, a methyl group, a trifluoromethyl group, a hydroxymethyl group, a fluorine atom, or a chlorine atom; B represents an oxygen atom or -N($R^B$)-, in which $R^B$ represents a hydrogen atom, an alkyl group, a cycloalkyl group, or an aryl group; C represents a divalent linking group; and A represents an amino group or a nitrogen-containing heterocyclic group.

$R^A$ in Formula (K) is preferably a hydrogen atom or a methyl group.

The divalent linking group represented by C is preferably an alkylene group having 2 to 20 carbon atoms, an alkylene aminocarbonyl group having 2 to 20 carbon atoms, a cycloalkylene group having 5 to 10 carbon atoms, or an arylene group having 6 to 10 carbon atoms, and most preferably an alkylene group having 2 to 10 carbon atoms or an alkylene aminocarbonyl group having 2 to 10 carbon atoms.

Examples of the alkyl group represented by $R^B$ include an alkyl group having 1 to 10 carbon atoms, and an alkyl group having 1 to 5 carbon atoms is particularly preferable. The amino group or nitrogen-containing heterocyclic group represented by A has the same definition as those described for the amino group or heterocyclic group of the monomer (b-1), and preferable ranges (including preferable examples) thereof are also the same.

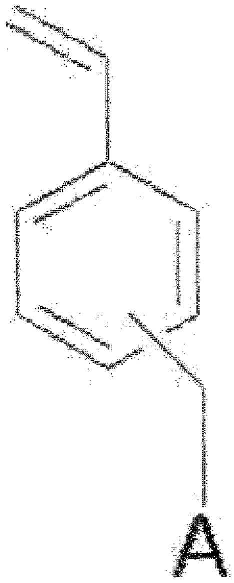

(L)

In Formula (L), A represents an amino group or a nitrogen-containing heterocyclic group. The amino group or heterocyclic group represented by A has the same definition as those described for the amino group or heterocyclic group of the monomer (b-1), and preferable ranges (including preferable examples) thereof are also the same.

One type of the monomer (b-1) may be used alone, or a combination of two or more types of them may be used.

Specific examples of the monomer (b-1) are shown below, however it should be construed that the present invention is not limited to these specific examples. In specific examples (M-1) to (M-23) and (M-31) to (M-50), $R^A$ represents a hydrogen atom, a methyl group, a trifluoromethyl group, a hydroxymethyl group, a fluorine atom, or a chlorine atom.

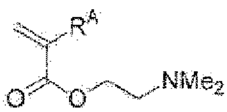

(M-1)

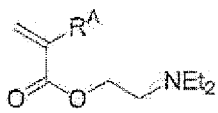

(M-2)

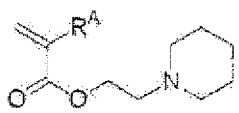

(M-3)

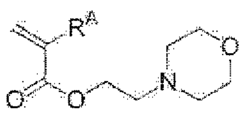

(M-4)

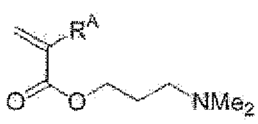

(M-5)

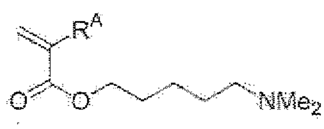

(M-6)

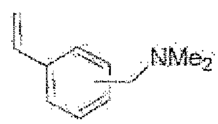

(M-7)

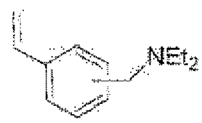

(M-8)

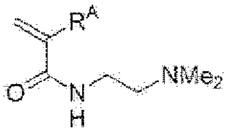

(M-9)

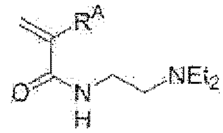

(M-10)

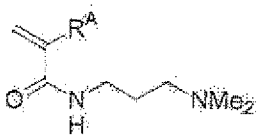

(M-11)

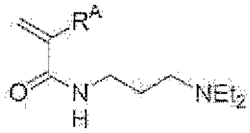

(M-12)

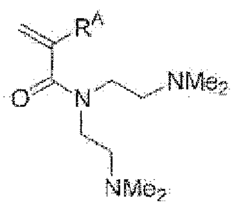 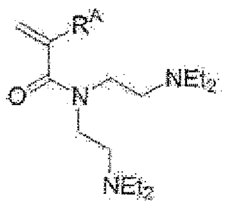 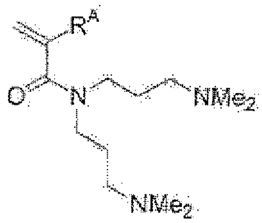 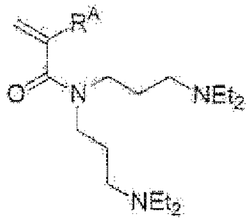

(M-13) (M-14) (M-15) (M-16)

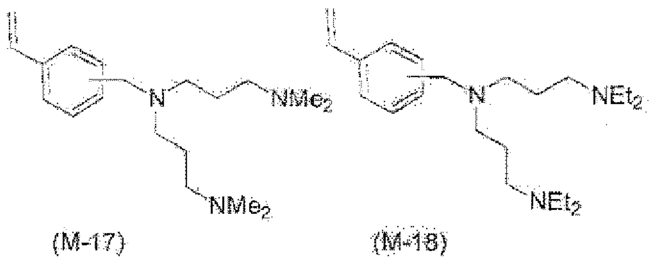 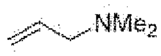 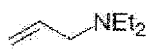

(M-17) (M-18) (M-19) (M-20)

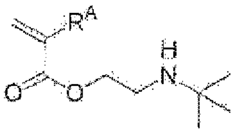

(M-21)

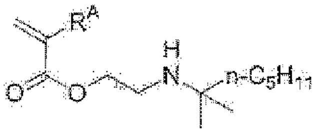

(M-22)

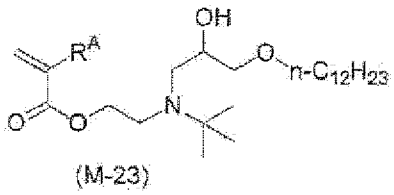

(M-23)

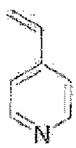 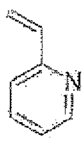 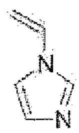

(M-31) (M-32) (M-33)

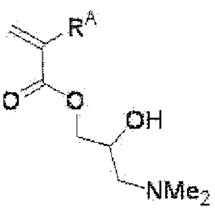 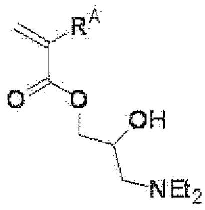 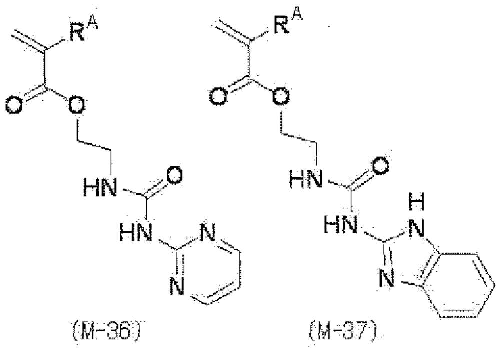

(M-34) (M-35) (M-36) (M-37)

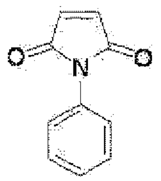
(M-38)

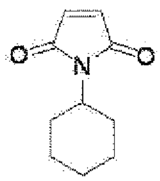
(M-39)

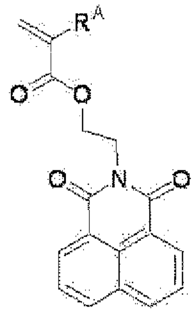
(M-40)

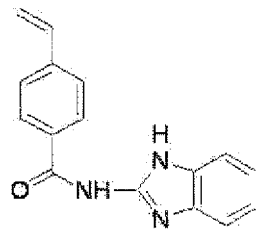
(M-41)

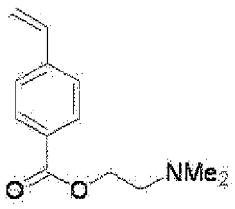
(M-42)

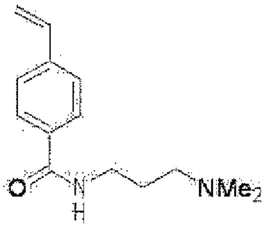
(M-43)

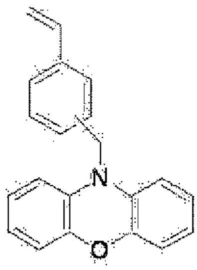
(M-44)

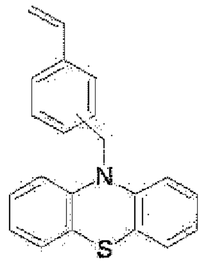
(M-45)

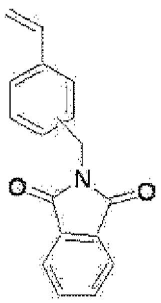
(M-46)

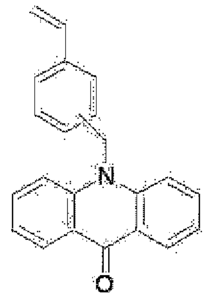
(M-47)

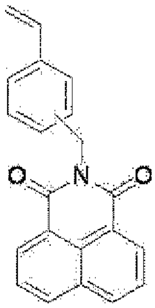
(M-48)

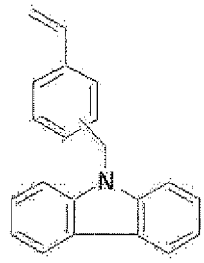
(M-49)

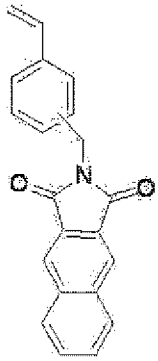
(M-50)

Among the specific examples (M-1) to (M-23) and (M-31) to (M-50), the specific examples (M-1) to (M-6), (M-9) to (M-16). (M-21) to (M-23), (M-37), (M-40), (M-47), (M-48), and (M-49), in which $R^A$ represents a hydrogen atom or a methyl group, are preferable, and the specific examples (M-1), (M-2), (M-11), (M-12), (M-37), (M-47), and (M-48) are particularly preferable from the viewpoints of dispersion stability of the dispersion composition and developability exhibited by the radiation sensitive composition containing the dispersion composition.

*(b-2) Monomer Having Carboxyl Group*

The (b-2) monomer having a carboxyl group (hereinafter, suitably referred to as the "monomer (b-2)") is a monomer which has at least one carboxyl group and has a molecular weight of from 50 to 500.

As the monomer (b-2), a known monomer which has at least one carboxyl group and has a molecular weight of from 50 to 500 may be used. From the viewpoint of polymerizability, the monomer (b-2) is preferably an acrylic monomer or a styrene monomer, and most preferably a meth)acrylic ester monomer or a (meth)acrylamide monomer.

One type of the monomer (b-2) may be used alone, or a combination of two or more types of them may be used.

Specific examples of the monomer (b-2) are shown below, however the present invention is not limited to these specific examples. In specific examples (M-24) to (M-30), (M-51), and (M-52), $R^A$ represents a hydrogen atom, a methyl group, a trifluoromethyl group, a hydroxymethyl group, a fluorine atom, or a chlorine atom.

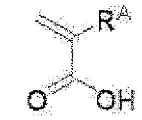

(M-24)

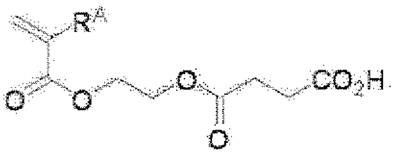

(M-25)

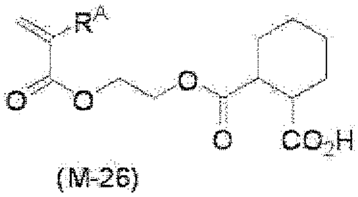

(M-26)

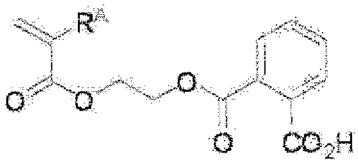

(M-27)

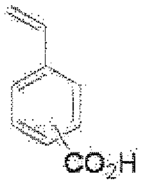

(M-28)

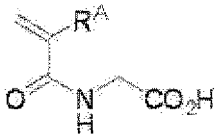

(M-29)

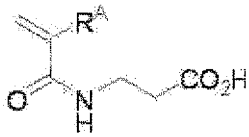

(M-30)

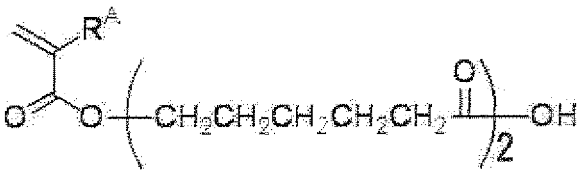

(M-51)

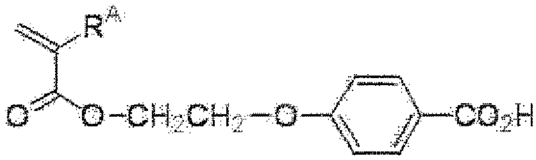

(M-52)

Among the specific examples (M-24) to (M-30), (M-51), and (M-52), the specific examples (M-24) and (M-29), in which $R^A$ represents a hydrogen atom or a methyl group, are particularly preferable from the viewpoints of the dispersion stability of the dispersion composition and the developability exhibited by the radiation sensitive composition containing the dispersion composition. Further, (M-24) in which $R^A$ represents a hydrogen atom or a methyl group is most preferable.

*(b-3) Macromonomer Having Weight Average Molecular Weight of from 1.000 to 50,000*

The (b-3) macromonomer having a weight average molecular weight of from 1,000 to 50,000 (hereinafter, suitably referred to as the "macromonomer (b-3)") is an oligomer or polymer which has the above-mentioned weight average molecular weight and has a polymerizable group at the terminal.

The weight average molecular weight of the macromonomer (b-3) is from 1,000 to 50,000, preferably from 1,000 to 20,000, more preferably from 2,000 to 10,000, and most preferably from 2,000 to 5,000. When the weight average molecular weight of the macromonomer (b-3) is within the above ranges, the dispersibility and dispersion stability of the dispersion composition and the developability exhibited by the radiation sensitive composition containing the dispersion composition are improved.

The weight average molecular weight in the present specification is a value as measured by GPC (gel permeation chromatography) and expressed in terms of polystyrene.

As the macromomer (b-3), a known macromonomer may be used.

Examples of the macromonomer (b-3) include MACROMONOMER AA-6 (trade name; polymethyl methacrylate, in which the terminal group is a methacryloyl group), AS-6 (trade name; polystyrene in which the terminal group is a methacryloyl group), AN-6S (trade name; a copolymer of styrene and acrylonitrile, in which the terminal group of the copolymer is a methacryloyl group), and AB-6 (trade name; polybutyl acrylate in which the terminal group is a methacryloyl group) (all manufactured by Toa Gosei Co., Ltd.); PLACCEL FM5 (trade name; an adduct of 2-hydroxyethyl methacrylate and 5 molar equivalents of ε-caprolactone) and FA-10L (trade name; an adduct of 2-hydroxyethyl acrylate and 10 molar equivalents of ε-caprolactone) (all manufactured by Daicel Chemical Industries Inc.); and polyester macromonomers described in JP-A No. 2-272009. Among them, polyester macromonomers having excellent flexibility and solvent philicity (or solvent compatibility) is particularly preferable from the viewpoints of dispersibility and dispersion stability of the dispersion composition and developability and light fastness exhibited by the radiation sensitive composition containing the dispersion composition. Further, the macromonomer (b-3) is most preferably a polyester macromonomer represented by the following Formula (M).

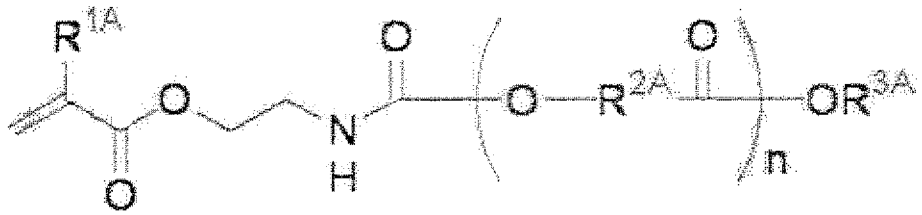

(M)

In Formula (M), $R^{1A}$ represents a hydrogen atom or a methyl group; $R^{2A}$ represents an alkylene group; $R^{3A}$ represents an alkyl group; and n represents an integer of 5 to 100; and plural $R^{2A}$'s present in a molecule may be the same as or different from each other.

In particular, $R^{2A}$ preferably represents a straight chain or branched alkylene group having 5 to 20 carbon atoms, and most preferably $-(CH_2)_5-$. $R^{3A}$ preferably represents a straight chain or branched alkyl group having 5 to 20 carbon atoms. n preferably represents an integer of from 5 to 30, and most preferably an integer of from 10 to 20.

One type of the macromonomer (b-3) may be used alone, or a combination of two or more types of them may be used.

The specific resin B preferably contains the repeating unit derived from the monomer (b-1) in an amount of from 10% by mass to 50% by mass, more preferably from 15% by mass to 45% by mass, and most preferably from 20% by mass to 40% by mass, with respect to the total mass of the specific resin B. When the content of the repeating unit derived from the monomer (b-1) is within the above ranges, the dispersibility and dispersion stability of the dispersion composition and resistance to the developing solution exhibited by the radiation sensitive composition containing the dispersion composition are further improved.

It is preferable that the repeating unit derived from the monomer (b-1) in the specific resin B essentially contains an amino group, from the viewpoints of dispersibility and dispersion stability.

From the viewpoints of further improvement in dispersibility and dispersion stability, the repeating unit derived from the monomer (b-1) in the specific resin B more preferably contains both an amino group and a nitrogen-containing heterocyclic group, and even more preferably contains the nitrogen-containing heterocyclic group in the side chain structure of the specific resin B.

The content ratio of the amino group and the nitrogen-containing heterocyclic group (i.e., amino group : nitrogen-containing heterocyclic group, mass ratio) in the repeating unit derived from the monomer (b-1) of the specific resin B is preferably from 100:0 to 5:95, more preferably from 100:0 to 10:90, and most preferably from 100:0 to 15:85.

The acid value of the specific resin B is preferably from 10 mgKOH/g to 200 mgKOH/g, more preferably from 20 mgKOH/g to 150 mgKOH/g, and most preferably from 40 mgKOH/g to 150 mgKOH/g. When the acid value of the specific resin B is within the above ranges, the dispersibility and dispersion stability of the dispersion composition and the developability exhibited by the radiation sensitive composition containing the dispersion composition are improved. The acid value of the specific resin B may be measured by means of base titration.

The repeating unit derived from the monomer (b-2) is preferably contained in the specific resin B, such that the acid value of the specific resin B is within the ranges described above.

The specific resin B preferably contains the repeating unit derived from the macromonomer (b-3) in an amount of from 15% by mass to 90% by mass, more preferably from 25% by mass to 80% by mass, and most preferably from 35% by mass to 60% by mass, with respect to the total mass of the specific resin B. When the content of the repeating unit derived from the macromonomer (b-3) is within the above ranges, the dispersibility and dispersion stability of the dispersion composition and the developability exhibited by the radiation sensitive composition containing the dispersion composition are further improved.

Specific examples of the specific resin B include resins (J-1) to (J-9) and (J-12) to (J-20) which are shown below together with the synthesis examples in the Example, however the present invention is not limited to these specific examples.

The specific resin B preferably has a weight average molecular weight as measured by GPC and expressed in terms of polystyrene of from 5,000 to 30,000, more preferably from 7,000 to 25,000, and most preferably from 10,000 to 20,000. When the weight average molecular weight of the specific resin B is within the above ranges, the dispersibility and dispersion stability of the dispersion composition and the developability exhibited by the radiation sensitive composition containing the dispersion composition are further improved.

The content ratio (i.e., b-1 : b-2 : b-3, mass ratio) of the repeating unit derived from the monomer (b-1), the repeating unit derived from the monomer (b-2), and the repeating unit derived from the macromonomer (b-3) in the specific resin B is preferably (from 10 to 50): (from 2 to 30): (from 30 to 80), more preferably (from 20 to 50): (from 5 to 20): (from 40 to 70), and even more preferably (from 20 to 40): (from 8 to 20): (from 40 to 60).

The specific resin B may be a resin that exhibits curing property.

A Polymerizable group may be further introduced into the specific resin B, in order to enhance the curing

property of the specific resin B. As a method for introducing a Polymerizable group, for example, a known method such as a method of reacting the carboxyl group of the specific resin B with a (meth)acrylate containing an epoxy group (for example, glycidyl methacrylate, or the like) or a method of reacting the hydroxyl group of the specific resin B with a (meth)acrylate containing an isocyanato group or a cyclic acid anhydride containing a polymerizable group may be used.

In a case in which the specific resin B has polymerizability, the repeating unit having a polymerizable group is preferably contained in an amount of from 5% by mass to 50% by mass, and more preferable from 10% by mass to 40% by mass, with respect to the total mass of the specific resin B.

The specific resin B may contain a repeating unit other than the above repeating units, for improving solubility in the solvent or coatability. Examples of such a repeating unit include repeating units derived from alkyl (meth)acrylate, cycloalkyl (meth)acrylate, aralkyl (meth)acrylate, (meth)acrylic acid amide, 2-hydroxyethyl (meth)acrylate, styrene, or the like.

The specific resin B is preferably produced by radical polymerization using, as raw materials, the monomer (b-1), the monomer (b-2), the macromonomer (b-3) and, if necessary, any other monomer. When the specific resin B is produced by a radical polymerization method, the polymerization conditions such as temperature, pressure, the type and amount of radical initiator, the type of solvent, and the like, may be the same as those in ordinary methods.

The dispersion composition of the present invention exhibits excellent dispersibility and dispersion stability due to the incorporation of the specific resin B, and therefore it is possible to contain the substance to be dispersed at a high concentration.

The content of the dispersant (B) in the dispersion composition of the invention is preferably from 20% by mass to 80% by mass, more preferably from 20% by mass to 50% by mass, and even more preferably from 20% by mass to 45% by mass, with respect to the total mass of the substance to be dispersed. When the content of the dispersant (B) is within the above ranges, it is possible to sufficiently achieve a high concentration of the substance to be dispersed in the dispersion composition. Accordingly, for example, when the radiation sensitive composition containing the dispersion composition of the present invention is used for the production of a light-shielding film of a solid state imaging element, the resolving power is enhanced due to realization of a thin film. One type of the dispersant (B) may be used alone, or a combination of two or more types of them may be used.

The content of the dispersant (B) in the titanium black dispersion composition according to the invention is preferably from 1% by mass to 50% by mass, and more preferably from 3% by mass to 30% by mass, with respect to the total content of solids in the substance to be dispersed (including the substance to be dispersed containing titanium black, and the substance to be dispersed containing other colorant or the like).

The content of the dispersant (B) in the radiation sensitive composition of the invention is preferably from 1% by mass to 30% by mass, and more preferably from 2% by mass to 25% by mass, with respect to the total content of solids in the substance to be dispersed (including the substance to be dispersed and the particles including other colorant or the like).

*(C) Organic Solvent*

The titanium black dispersion composition and the radiation sensitive composition of the present invention contain (C) an organic solvent.

Examples of the (C) organic solvent include, but are not limited to, acetone, methyl ethyl ketone, cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 3-methoxypropanol, methoxymethoxyethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, 3-methoxypropyl acetate, N,N-dimethylformamide, dimethylsulfoxide, $\gamma$-butyrolactone, butyl acetate, methyl lactate, and ethyl lactate.

One of the organic solvents may be used alone, or a combination of two or more of them may be used.

In the case of using two or more organic solvents in combination, a mixed solvent consisting of two or more of organic solvents selected from the group consisting of methyl 3-ethoxypropionate, ethyl 3-ethoxypropionate, ethyl cellosolve acetate, ethyl lactate, diethylene glycol dimethyl ether, butyl acetate, methyl 3-methoxypropionate, 2-heptanone, cyclohexanone, ethyl carbitol acetate, butyl carbitol acetate, propylene glycol methyl ether, and propylene glycol methyl ether acetate is particularly preferable.

The amount of the (C) organic solvent contained in the titanium black dispersion composition is preferably from 10% by mass to 80% by mass, more preferably from 20% by mass to 70% by mass, and even more preferably from 30% by mass to 65% by mass, with respect to the total amount of the dispersion composition.

The amount of the (C) organic solvent contained in the radiation sensitive composition is preferably from 10%

by mass to 90% by mass, more preferably from 20% by mass to 80% by mass, and even more preferably from 25% by mass to 75% by mass, with respect to the total amount of the radiation sensitive composition.

*(D) Polymerizable Compound*

The radiation sensitive composition of the present invention contains (A) a polymerizable compound.

Specifically, the (D) polymerizable compound is selected from compounds having at least one terminal ethylenically unsaturated bond, and preferably two or more terminal ethylenically unsaturated bonds. Among them, polyfunctional polymerizable compounds of tetra-functional or higher-functional are preferable, and polyfunctional polymerizable compounds of penta-functional or higher-functional are more preferable.

Such a compound group is well known in the art, and any of these compounds may be used in the present invention without any particular limitation. These polymerizable compounds may have a chemical form of, for example, a monomer, a prepolymer, that is a dimer or a trimer, an oligomer, a mixture thereof, a polymer thereof, or the like. One type of the polymerizable compounds may be used alone, or a combination of two or more types of them may be used.

More specifically, examples of a monomer or a prepolymer thereof include unsaturated carboxylic acids (for example, acrylic acid, methacrylic acid, itaconic acid, crotonic acid, isocrotonic acid, maleic acid, or the like), esters and amides thereof, and polymers thereof. Esters of an unsaturated carboxylic acid and an aliphatic polyvalent alcohol compound, amides of an unsaturated carboxylic acid and an aliphatic polyvalent amine compound, and polymers thereof are preferable. Further, an addition reaction product of an unsaturated carboxylic acid ester or amide having a nucleophilic substituent, such as a hydroxyl group, an amino group, or a mercapto group, and a monofunctional or polyfunctional isocyanate or epoxy; a dehydration condensation product with a monofunctional or polyfunctional carboxylic acid; or the like are also preferably used. Furthermore, addition reaction products of an unsaturated carboxylic acid ester or amide having an electrophilic substituent, such as an isocyanato group or an epoxy group, and a monofunctional or polyfunctional alcohol, amine, or thiol; and a substitution reaction products of an unsaturated carboxylic acid ester or amide having a leaving substituent, such as a halogen group or a tosyloxy group, and a monofunctional or polyfunctional alcohol, amine, or thiol are also preferable. In addition, as other examples, it is possible to use a compound group in which the unsaturated carboxylic acid above is replaced by a vinylbenzene derivative, a vinyl ether, an allyl ether, or the like such as an unsaturated phosphonic acid or styrene.

Specifically, compounds described in paragraph [0095] to [0108] of JP-A No. 2009-288705 may be preferably used also in the present invention.

Moreover, as the polymerizable compound, a compound which has at least one ethylene group capable of addition polymerization, has a boiling point of 100°C or higher at a normal pressure, and has an ethylenically unsaturated group is also preferable. Examples thereof include monofunctional acrylates and methacrylates, such as polyethylene glycol mono(meth)acrylate, polypropylene glycol mono(meth)acrylate, or phenoxyethyl (meth)acrylate; polyfunctional acrylates and methacrylates, such as polyethylene glycol di(meth)acrylate, trimethylolethane tri(meth)acrylate, neopentyl glycol di(meth)acrylate, pentaerythritol tri(meth)acrylate, pentaerythritol tetra(meth)acrylate, dipentaerythritol penta(meth)acrylate, dipentaerythritol hexa(meth)acrylate, hexanediol (meth)acrylate, trimethylolpropane tri(acryloyloxypropyl) ether, tri(acryloyloxyethyl) isocyanurate, compounds obtained by adding ethylene oxide or propylene oxide to a polyfunctional alcohol such as glycerin or trimethylolethane, followed by (meth)acrylation of the addition products, urethane (meth)acrylates such as those described in Japanese Patent Application Publication (JP-B) Nos. 48-41708 and 50-6034, and JP-A No. 51-37193, polyester acrylates described in JP-A No. 48-64183, and JP-B Nos. 49-43191 and 52-30490, or epoxyacrylates which are reaction products of an epoxy resin and (meth)acrylic acid; and mixtures thereof.

Examples thereof may further include polyfunctional (meth)acrylates obtained by reacting a polyfunctional carboxylic acid with a compound having a cyclic ether group and an ethylenically unsaturated group, such as glycidyl (meth)acrylate.

As other preferable polymerizable compounds, it is also possible to use a compound having a fluorene ring and two or more ethylenically unsaturated groups, or a cardo resin, which are described in JP-A Nos. 2010-160418 and 2010-129825, and Japanese Patent No. 4364216.

Further, as the compound having a boiling point of 100°C or higher at a normal pressure, and has at least one addition-polymerizable ethylenically unsaturated group, compounds described in paragraphs [0254] to [0257] of JP-A No. 2008-292970 are also preferable.

In addition to the above compounds, radical polymerizable monomers represented by the following Formula (MO-1) to (MO-5) may also be used preferably. Note that, in the formulae, in a case in which T represents an oxyalkylene group, the terminal at the carbon atom side bonds to R.

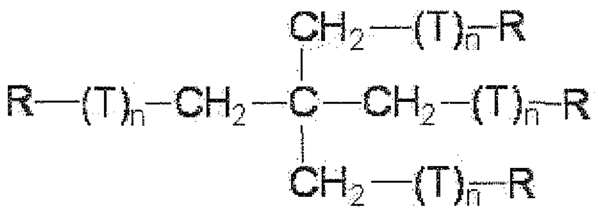

(MO-1)

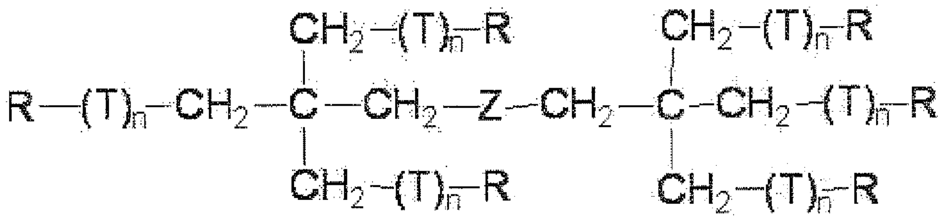

(MO-2)

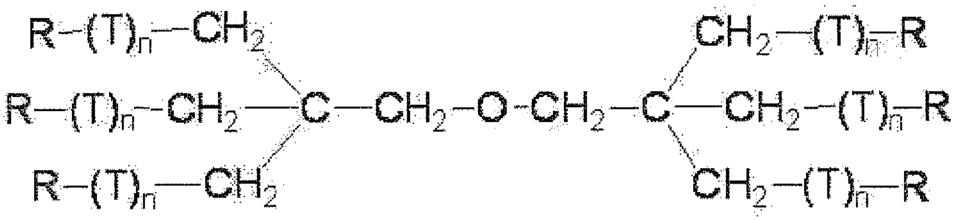

(MO-3)

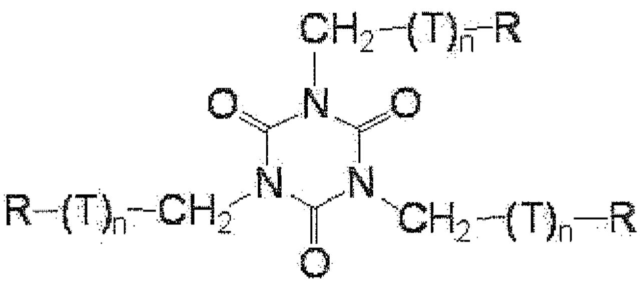

(MO-4)

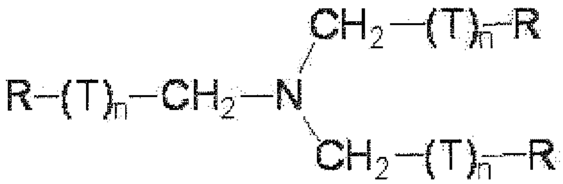

(MO-5)

R:

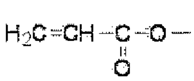, 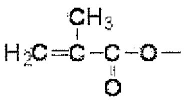, 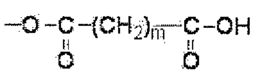, 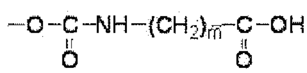.

-OH -CH3

T: *-$(CH_2)_m$-*, $-OCH_2-$, $-OCH_2CH_2-$, $-OCH_2CH_2CH_2-$, $-OCH_2CH_2CH_2CH_2-$, -O(CO)-$(CH_2)_m$-, -COO-$(CH_2)_m$-, -OCH($CH_3$)-$CH_2$-, -$OCH_2$CH($CH_3$)-

Z: -O-,

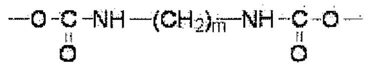

In the above formulae, n represents a number of from 0 to 14, and m represents a number of from 1 to 8. When plural Rs and Ts are present in one molecule, these may be the same as or different from each other, respectively.

In the polymerizable compounds represented by any one of Formulae (MO-1) to (MO-5), at least one of plural Rs represents $-OC(=O)CH=CH_2$ or $-OC(=O)C(CH_3)=CH_2$.

Specific examples of the polymerizable compounds represented by Formula (MO-1) to (MO-5), which may preferably be used also in the present invention, include the compounds represented in paragraph Nos. 0248 to 0251 of JP-A No. 2007-269779.

Further, the compounds obtained by adding ethylene oxide or propylene oxide to a polyfunctional alcohol, followed by (meth)acrylation of the addition products, as well as the specific examples of Formulae (1) and (2), which are described in JP-A No. 10-62986, are also usable as the polymerizable compound.

Above all, as the Polymerizable compound, dipentaerythritol triacrylate (commercially available as KAYARAD D-330 (trade name), manufactured by Nippon Kayaku Co., Ltd.), dipentaerythritol tetraacrylate (commercially available as KAYARAD D-320 (trade name), manufactured by Nippon Kayaku Co., Ltd.), dipentaerythritol penta(meth)acrylate (commercially available as KAYARAD D-310 (trade name), manufactured by Nippon Kayaku Co., Ltd.), dipentaerythritol hexa(meth)acrylate (commercially available as KAYARAD DPHA (trade name), manufactured by Nippon Kayaku Co., Ltd.), and a compound having a structure, in which the (meth)acryloyl group of the above compounds is connected via an ethylene glycol residue or a propylene glycol residue, are preferable. Further, oligomers thereof are also usable. Preferable embodiments of the polymerizable compound are described below.

The polymerizable compound is a polyfunctional monomer, and may have an acidic group such as a carboxyl group, a sulfonic acid group, a phosphoric acid group, or the like. In the case of an ethylenic compound having an unreacted carboxyl group, as in the case of being a mixture described above, the compound may be used as it is, but according to need, an acidic group may be introduced through allowing the hydroxyl group of the ethylenic compound to react with a non-aromatic carboxylic anhydride. In this case, specific examples of the non-aromatic carboxylic anhydride to be used include tetrahydrophthalic anhydride, alkylated tetrahydrophthalic anhydride, hexahydrophthalic anhydride, alkylated hexahydrophthalic anhydride, succinic anhydride, and maleic anhydride.

In the present invention, the monomer having an acidic group is an ester of an aliphatic polyhydroxy compound and an unsaturated carboxylic acid, preferably a polyfunctional monomer having an acidic group by allowing the unreated hydroxyl group of the aliphatic polyhydroxy compound to react with a non-aromatic carboxylic anhydride, and particularly preferably an ester, in which the aliphatic polyhydroxy compound in this ester is pentaerythritol and/or dipentaerythritol. Examples of a commercially available product thereof include M-510 and M-520 (all trade names, manufactured by Toa Gosei Co., Ltd.), as polybasic acid modified acrylic oligomers.

One of these monomer may be used alone, or from the viewpoint of production, since it is difficult to use a single compound, two or more of these monomers may be used by mixing them. Further, if necessary, a polyfunctional monomer that does not have an acidic group and a polyfunctional monomer having an acidic group may be used in combination as a monomer.

The acid value of the polyfuntional monomer having an acidic group is preferably from 0.1 mgKOH/g to 40 mgKOH/g, and particularly preferably from 5 mgKOH/g to 30 mgKOH/g. When the acid value of the polyfunctional monomer is too low, the development dissolution characteristics may be deteriorated, whereas when the acid value is too high, production or handling thereof may become difficult and the photopolymerization performance may be deteriorated, resulting in inferior curing property such as surface smoothness of pixels. Accordingly, in a case in which two or more types of polyfunctional monomers having different acid values are used in combination, or in a case in which a polyfunctional monomer that does not have an acidic group and a polyfunctional monomer having an acidic group are used in combination, it is preferable to adjust the acid value of the polyfunctional monomer as a whole to fall within the above ranges.

Further, in a preferable embodiment, the polymerizable monomer includes a polyfunctional monomer having a caprolactone structure.

There is no particular limitation as to the polyfunctional monomer having a caprolactone structure as far as the polyfunctional monomer has a caprolactone structure in a molecule thereof. Examples thereof include ε-caprolactone modified polyfunctional (meth)acrylates obtained by estericifation of a polyhydric alcohol such as trimethylolethane, di-trimethylolethane, trimethylolpropane, di-trimethylolpropane, pentaerythritol, di-pentaerythritol, tri-pentaerythritol, glycerin, di-glycerol, or trimethylolmelamine, with (meth)acrylic acid and ε-caprolactone. Among them, a polyfunctional monomer having a caprolactone structure represented by the following Formula (Z-1) is preferable.

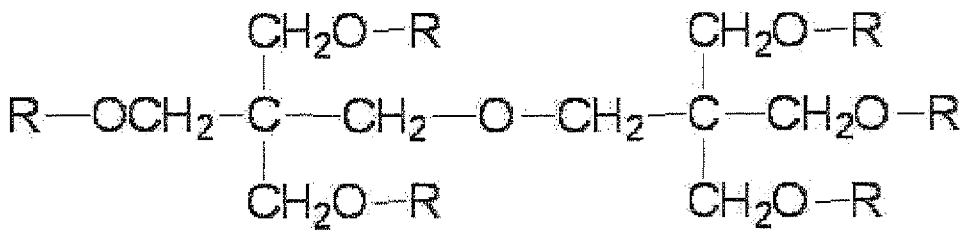

(Z-1)

In Formula (Z-1), all of the six Rs each represent a group represented by the following Formula (Z-2), or one to five among the six Rs represent(s) a group represented by the following Formula (Z-2), and the rest thereof (i.e., one to five among the six Rs) represents a group represented by the following Formula (Z-3).

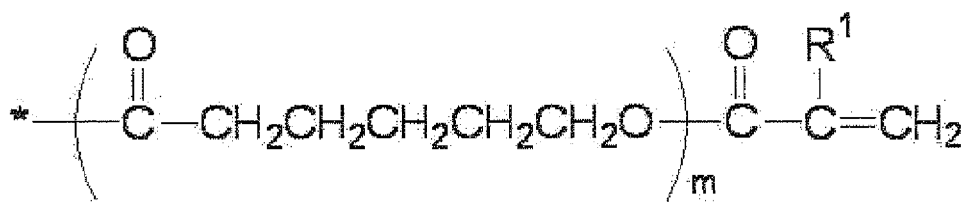

(Z-2)

In Formula (Z-2), $R^1$ represents a hydrogen atom or a methyl group, m represents a number of 1 or 2, and the "*" sign represents a bonding site.

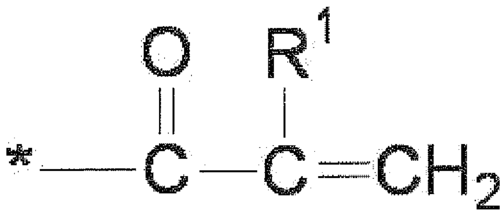

(Z-3)

In Formula (Z-3), $R^1$ represents a hydrogen atom or a methyl group, and the "*" sign represents a bonding site.

Such polyfunctional monomers having a caprolactone structure are commercially available, for example, as KAYARAD DPCA series from Nippon Kayaku Co., Ltd., and examples may include DPCA-20 (trade name; a compound, in which in Formulae (Z-1) to (Z-3) above, m = 1, the number of groups represented by Formula (Z-2) = 2, and each $R^1$ represents a hydrogen atom), DPCA-30 (trade name; a compound, in which in Formulae (Z-1) to (Z-3) above, m = 1, the number of groups represented by Formula (Z-2) = 3, and each $R^1$ represents a hydrogen atom), DPCA-60 (trade name; a compound, in which in Formulae (Z-1) to (Z-3) above, m = I, the number of groups represented by Formula (Z-2) = 6, and each $R^1$ represents a hydrogen atom), and DPCA-120 (trade name; a compound, in which in Formulae (Z-1) to (Z-3) above, m = 2, the number of groups represented by Formula (Z-2) = 6, and each $R^1$ represents a hydrogen atom).

In the present invention, the polyfunctional monomers having a caprolactone structure may be used alone or in a combination of two or more of them as a mixture.

Moreover, the specific monomer in the present invention is preferably at least one selected from the group consisting of compounds represented by the following Formula (Z-4) or (Z-5).

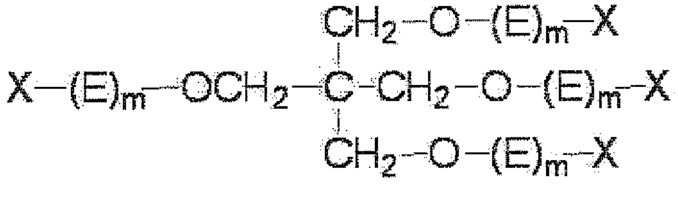

(Z-4)

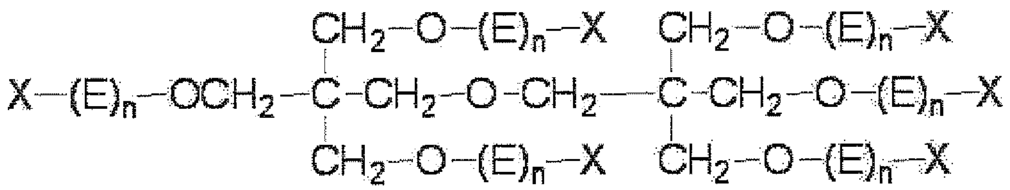

(Z-5)

In Formulae (Z-4) and (Z-5), each E independently represents $-((CH_2)yCH_2O)-$ or $-((CH_2)yCH(CH_3)O)-$; in which each y independently represents an integer of from 0 to 10; each X independently represents an acryloyl group, a methacryloyl group, a hydrogen atom, or a carboxyl group.

In Formula (Z-4), the sum of the number of the acryloyl groups and the number of the methacryloyl groups is three or four, each m independently represents an integer of from 0 to 10, and the sum of all the numbers of m is an integer of from 0 to 40. However, in a case in which the sum of all the numbers of m is 0, any one of Xs represents a carboxyl group.

In Formula (Z-5), the sum of the number of the acryloyl groups and the number of the methacryloyl groups is five or six, each n independently represents an integer of from 0 to 10, and the sum of all the numbers of n is an integer of from 0 to 60. However, in a case in which the sum of all the numbers of n is 0, any one of Xs represents a carboxyl group.

In Formula (Z-4), m preferably represents an integer of from 0 to 6, and more preferably an integer of from 0 to 4.

Further, the sum of all the numbers of m is preferably an integer of from 2 to 40, more preferably an integer of from 2 to 16, and particularly preferably an integer of from 4 to 8.

In Formula (Z-5), n preferably represents an integer of from 0 to 6, and more preferably an integer of from 0 to 4.

Further, the sum of all the numbers of n is preferably an integer of from 3 to 60, more preferably an integer of from 3 to 24, and particularly preferably an integer of from 6 to 12.

Furthermore, in Formula (Z-4) or Formula (Z-5), an embodiment in which the terminal at the oxygen atom side of $-((CH_2)yCH_2O)-$ or $-((CH_2)yCH(CH_3)O)-$ bonds to X is preferable.

One type of the compounds represented by Formula (Z-4) or Formula (Z-5) may be used alone or two or more types of them may be used in combination. Particularly, in Formula (Z-5), an embodiment in which all of the six Xs each represent an acryloyl group is preferable.

Further, the total content of the compounds represented by Formula (Z-4) or Formula (Z-5) in the polymerizable compound is preferably 20% by mass or higher, and more preferably 50% by mass or higher.

The compound represented by Formula (Z-4) or Formula (Z-5) may be synthesized by a method including a process of bonding a ring-opened skeleton to pentaerythritol) or dipentaerythritol by a ring-opening addition reaction with ethylene oxide or propylene oxide and a process of introducing a (meth)acryloyl group into the terminal hydroxyl group of the ring-opened skeleton, for example, by a reaction with (meth)acryloyl chloride, which are conventionally known processes. The respective processes are well known processes, and those skilled in the art may easily synthesize the compound represented by Formula (Z-4) or (Z-5).

Among the compounds represented by Formula (Z-4) or Formula (Z-5), pentaerythritol derivatives and/or dipentaerythritol derivatives are more preferable.

Specific examples include the compounds represented by the following Formula (a) to (f) (hereinafter, also referred to as "exemplary compounds (a) to (f)"), and among them, the exemplary compounds (a), (b), (e), and (f) are preferable.

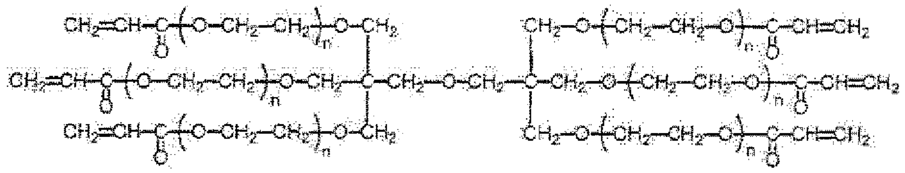

(a)

(the sum of the numbers represented by n's is 6)

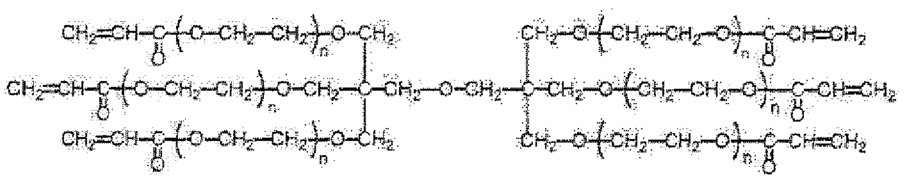

(b)

(the sum of the numbers represented by n's is 12)

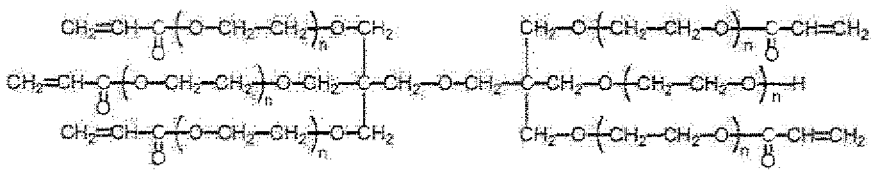

(c)

(the sum of the numbers represented by n's is 12)

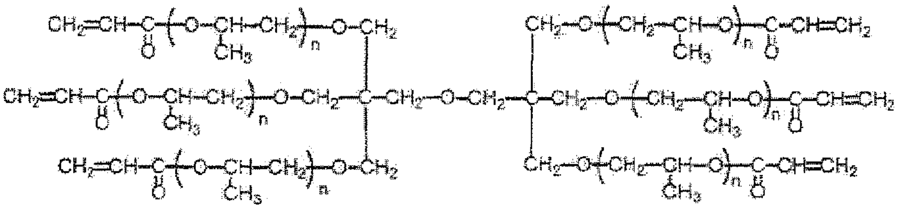

(d)

(the sum of the numbers represented by n's is 6)

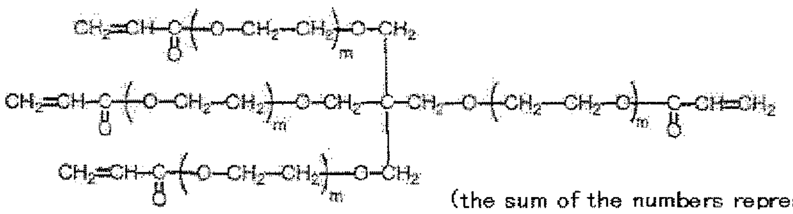

(e)

(the sum of the numbers represented by n's is 4)

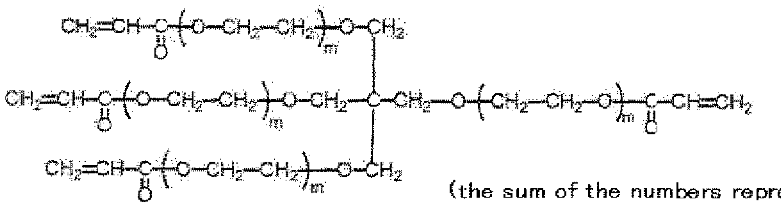

(f)

(the sum of the numbers represented by n's is 12)

Examples of commercially available products of the polymerizable compound represented by Formula (Z-4) or (Z-5) include SR-494 (trade name, manufactured by Sartomer Company), that is a tetrafunctional acrylate having four ethyleneoxy chains, and DPCA-60, that is a hexafunctional acrylate having six pentyleneoxy chains, and TPA-330, that is a trifunctional acrylate having three isobutyleneoxy chains (all trade names, manufactured by Nippon Kayaku Co., Ltd.).

Further, as the polymerizable compound, urethane acrylates such as those described in JP-B No. 48-41708, JP-A No. 51-37193, and JP-B Nos. 2-32293 and 2-16765, and urethane compounds having an ethylene oxide skeleton described in JP-B Nos. 58-49860, 56-17654, 62-39417, and 62-39418 are also preferable. Furthermore, when an addition polymerizable compound having an amino structure or a sulfide structure in a molecule thereof, which is described in JP-ANos. 63-277653, 63-260909, and 1-105238, is used as the polymerizable compound, a curable composition having an extremely excellent photosensitizing speed is obtained.

Examples of commercially available products of the polymerizable compounds include urethane oligomers UAS-10 and UAB-140 (all trade names, manufactured by Nippon Paper Industries Co., Ltd.), UA-7200 (trade name, manufactured by Shin-Nakamura Chemical Co., Ltd.), DPHA-40H (trade name, manufactured by Nippon Kayaku Co., Ltd.), and UA-306H, UA-306T, UA-306I, AH-600, T-600, and AI-600 (all trade names, manufactured by Kyoeisha Chemical Co., Ltd.).

A polyfunctional thiol compound having two ore more mercapto (SH) groups in the same molecule is also preferable as the polymerizable compound. Particularly, a compound represented by the following Formula (I) is preferable.

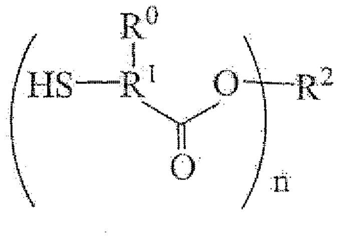

(I)

In Formula (I), $R^1$ represents an alkyl group, $R^2$ represents an n-valent aliphatic group which may contain an atom other than carbon, $R^0$ represents an alkyl group but does not represent H, and n represents a number of from 2 to 4.

Specific examples of the polyfunctional thiol compound represented by Formula (I) include 1,4-bis(3-mercaptobutylyloxy)butane [Formula (II)], 1,3,5-tris(3-mercaptobutyloxyethyl)-1,3,5-triazin-2,4,6(1H,3H,5H)-trione [Formula (III)], and pentaerythritol tetrakis(3-mercaptobutylate) [Formula (IV)], having the structure shown below. These polyfunctional thiols may be used alone or in a combination of two or more of them.

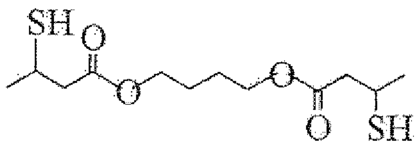

(II)

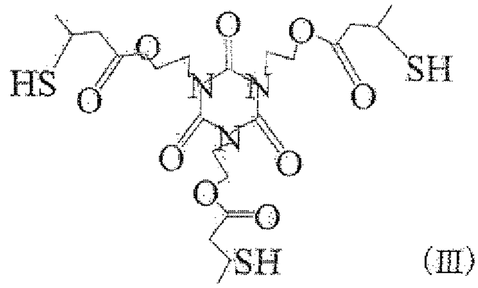

(III)

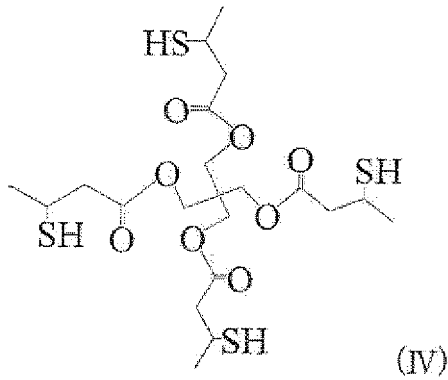

(IV)

Regarding these polymerizable compounds, details on the structure and the usage method, for example, whether these are used alone or in combination, the addition amount, or the like may be arbitrarily determined depending on the final performance design of the radiation sensitive composition. For example, from the viewpoint of sensitivity, a structure having a high content of unsaturated groups per one molecule is preferable, and in many cases, a compound having a functionality of two or more (i.e., a di-functional or higher-functional compound) is preferable. Further, from the viewpoint of enhancing the strength of the radiation sensitive composition film, a compound having a functionality of three or more (i.e., a tri-functional or higher-functional compound) is preferable. Furthermore, a method of adjusting both the sensitivity and the strength by using compounds having different number of functional groups, or different polymerizable groups (for example, an acrylic acid ester, a methacrylic acid ester, a styrene compound, or a vinyl ether compound)

in combination is also effective. When Polymerizable compounds which have a functionality of three or more and have ethylene oxide chains of different lengths, respectively, are used in combination, the developability of the radiation sensitive composition may be adjusted, which is preferable in view of obtaining excellent pattern formability.

Moreover, also with regard to mutual-solubility or dispersibility with other components (for example, a photopolymerization initiator, a substance to be dispersed, an alkali-soluble resin, or the like) contained in the radiation sensitive composition, the selection and usage method of the Polymerizable compound are significant factors. For example, there are cases in which mutual-solubility is enhanced by using a compound having low purity or by using two or more kinds in combination. In addition, a specific structure may be selected from the viewpoint of enhancing the adhesion with a hard surface such as a support.

The content of the polymerizable compound in the radiation sensitive composition of the present invention is preferably from 0.1% by mass to 70% by mass, more preferably from 1.0% by mass to 50% by mass, and particularly preferably from 2.0% by mass to 40% by mass, with respect to the content of solids in the radiation sensitive composition.

*(E) Photopolymerization Initiator*

The radiation sensitive composition of the present invention contains (E) a photopolymerization initiator.

As the (E) photopolymerization initiator used in the present invention (hereinafter, may be merely referred to as the "polymerization initiator"), those known as photopolymerization initiators, which are described below, may be used.

The photopolymerization initiator used in the present invention is not particularly limited as far as it has an ability of initiating the polymerization of the polymerizable compound, and may be selected as appropriate from known photopolymerization initiators. For example, compounds having sensitivity to light within the ultraviolet to visible region are preferable. Further, the photopolymerization initiator may be an activating agent that is capable of interacting with a photo-excited sensitizer to give an active radical, or may be an initiator which is capable of initiating cationic polymerization depending on the kind of monomer.

Further, it is preferable that the photopolymerization initiator contains at least one compound which has a molecular absorption coefficient of about 50 in the wavelength region of from about 300 nm to about 800 nm (more preferably from 330 nm to 500 nm).

Examples of the (E) photopolymerization initiator in the present invention include halogenated hydrocarbon derivatives (for example, those having a triazine skeleton, those having an oxadiazole skeleton, or the like); acyl phosphine compounds such as acyl phosphine oxide; hexaarylbiimidazole; oxime compounds such as oxime derivatives; organic peroxides; thio compounds; ketone compounds; aromatic onium salts; keto oxime ethers; aminoacetophenone compounds; and hydroxyacetophenone. Among them, oxime compounds are preferable.

Examples of the halogenated hydrocarbon compounds having a triazine skeleton include compounds described in Wakabayashi et. al., Bull. Chem. Soc. Japan, 42, 2924 (1969), compounds described in British Patent No. 1388492, compounds described in JP-A No. 53-133428, compounds described in German Patent No. 3337024, compounds described in F. C. Schaefer et. al., J. Org. Chem., 29, 1527 (1964), compounds described in JP-A No. 62-58241, compounds described in JP-A No. 5-281728, compounds described in JP-A No. 5-34920, and compounds described in U.S. Patent No. 4212976.

Examples of the compounds described in U.S. Patent No. 4212976 include compounds having an oxadiazole skeleton (for example, 2-trichloromethyl-5-phenyl-1,3,4-oxadiazole, 2-trichloromethyl-5-(4-chlorophenyl)-1,3,4-oxadiazole, 2-trichloromethyl-5-(1-naphthyl)-1,3,4-oxadiazole, 2-trichloromethyl-5-(2-naphthyl)-1,3,4-oxadiazole, 2-tribromomethyl-5-phenyl-1,3,4-oxadiazole, 2-tribromomethyl-5-(2-naphthyl)-1,3,4-oxadiazole, 2-trichloromethyl-5-styryl-1,3,4-oxadiazole, 2-trichloromethyl-5-(4-chlorostyryl)-1,3,4-oxadiazole, 2-trichloromethyl-5-(4-methoxystyryl)-1,3,4-oxadiazole, 2-trichloromethyl-5-(1-naphthyl)-1,3,4-oxadiazole, 2-trichloromethyl-5-(4-n-butoxystyryl)-1,3,4-oxadiazole, 2-tribromomethyl-5-styryl-1,3,4-oxadiazole, or the like).

Further, examples of the polymerization initiator other than those described above include acridine derivatives (for example, 9-phenylacridine, 1,7-bis(9,9'-acridinyl)heptane, or the like), N-phenylglycine and the like, polyhalogen compounds (for example, carbon tetrabromide, phenyltribromomethylsulfone, phenyl trichloromethyl ketone, or the like), coumarins (for example, 3-(2-benzofuranoyl)-7-diethylamino coumarin, 3-(2-benzofuroyl)-7-(1-pyrrolidinyl)coumarin, 3-benzayl-7-diethylamino coumarin, 3-(2-methoxybenzoyl)-7-diethylamino coumarin, 3-(4-dimethylaminobenzoyl)-7-diethylamino coumarin, 3,3'-carbonylbis(5,7-di-n-propoxycoumarin), 3,3'-carbonylbis(7-diethylamino coumarin), 3-benzoyl-7-methoxycoumarin, 3-(2-furoyl)-7-diethylamino coumarin, 3-(4-diethylamino cinnamoyl)-7-diethylamino coumarin, 7-methoxy-3-(3-pyridylcarbonyl)coumarin, 3-benzoyl-5,7-dipropoxycoumarin, 7-benzotriazol-2-ylcoumarin, or coumarin compounds described in, for example, JP-A Nos. 5-19475, 7-271028, 2002-363206, 2002-363207, 2002-363208, and 2002-363209), acylphophine oxides (for example, bis(2,4,6-trimethylbenzoyl)-phenylphosphine oxide, bis(2,6-dimethoxybenzoyl)-2,4,4-trimethyl-pentylphenylphosphine oxide, LUCIRIN TPO (trade name, manufactured by BASF Corporation), or the like), metallocenes (for example, bis(η5-2,4-cyclopentandien-1-yl)-bis(2,6-difluoro-3-(1H-pyrrol-1-yl)-phenyl) titanium, η5-cyclopentandienyl-η6-cumenyl-iron(1+)-hexafluorophosphate(1-), or the like), and compounds described in JP-ANo. 53-133428, JP-B Nos. 57-1819 and 57-6096, and U.S. Patent No. 3615455.

Examples of the ketone compounds include benzophenone, 2-methylbenzophenone, 3-methylbenzophenone, 4-methylbenzophenone, 4-methoxybenzophenone, 2-chlorobenzophenone, 4-chlorobenzophenone, 4-bromobenzophenone, 2-carboxybenzophenone, 2-ethoxycarbonylbenzophenone, benzophenone tetracarboxylic acid and tetramethyl esters thereof, 4,4'-bis(dialkylamino)benzophenones (for example, 4,4'-bis(dimethylamino)benzophenone, 4,4'-bis(dicyclohexylamino)benzophenone, 4,4'-bis(diethylamino)benzophenone, or 4,4'-bis(dihydroxyethylamino)benzophenone), 4-methoxy-4'-dimethylamino benzophenone, 4,4'-dimethoxybenzophenone, 4-dimethylamino benzophenone, 4-dimethylamino acetophenone, benzyl, anthraquinone, 2-t-butylanthraquinone, 2-methylanthraquinone, phenanthraquinone, xanthone, thioxanthone, 2-chloro-thioxanthone, 2,4-diethyl-thioxanthone, fluorenone, 2-benzyl-dimethylamino-1-(4-morpholinophenyl)-1-butanone, 2-methyl-1-[4-(methylthio)phenyl]-2-morpholino-1-propanone, 2-hydroxy-2-methyl-[4-(1-methylvinyl)phenyl] propanol oligomers, benzoin, benzoin ethers (for example, benzoin methyl ether, benzoin ethyl ether, benzoin propyl ether, benzoin isopropyl ether, benzoin phenyl ether, or benzoin dimethyl ketal), acridone, chloroacridone, N-methylacridone, N-butylacridone, and N-butyl-chloroacridone.

As the polymerization initiator, a hydroxyacetophenone compound, an aminoacetophenone compound, or an acyl phosphine compound may also be used preferably. More specifically, for example, an aminoacetophenone initiator described in JP-ANo. 10-291969, or an acyl phosphine oxide initiator described in Japanese Patent No. 4225898 are also applicable.

As the hydroxyacetophenone initiator, IRGACURE-184, DAROCUR-1173, IRGACURE-500, IRGACURE-2959, and IRGACURE-127 (all trade names, manufactured by BASF Corporation) may be used. Examples of commercially available products of the aminoacetophenone initiator include IRGACURE-907, IRGACURE-369, and IRGACURE-379 (all trade names, manufactured by BASF Corporation). As the aminoacetophenone initiator, compounds whose absorption wavelength is matched to a wavelength light source of 365 nm, 405 nm, or the like, as described in JP-A No. 2009-191179, may be used. Examples of commercially available products of the acyl phosphine initiator include IRGACURE-819 and DAROCUR-TPO (all trade names, manufactured by BASF Corporation).

The polymerization initiator is more preferably an oxime compound. Specific examples of the oxime compound, which can be used, include compounds described in JP-A No. 2001-233842, compounds described in JP-A No. 2000-80068, and compounds described in JP-A No. 2006-342156.

Examples of the oxime compound including an oxime derivative, which is preferably used as the polymerization initiator in the present invention, include 3-benzoyloxyiminobutan-2-one, 3-acetaxyiminobutan-2-one, 3-propionyloxyiminobutan-2-one, 2-acetoxyiminopentan-3-one, 2-acetoxyimino-1-phenylpropan-1-one, 2-benzoyloxyimino-1-phenylpropan-1-one, 3-(4-toluenesulfonyloxy)iminobutan-2-one, and 2-ethoxycarbonyloxyimino-1-phenylpropan-1-one.

Examples of the oxime compound include compounds described in J. C. S. Perkin II (1979) pages 1653 to 1660, J. C. S. Perkin II (1979) pages 156 to 162, Journal of Photopolymer Science and Technology (1995) pages 202 to 232, and JP-A No. 2000-66385, and compounds described in JP-A No. 2000-80068, Japanese National Phase Publication No. 2004-534797, and JP-A No. 2006-342166.

Examples of commercially available products thereof include IRGACURE OXE-01 (trade name, manufactured by BASF Corporation) and IRGACURE OXE-02 (trade name, manufactured by BASF Corporation).

Further, as the oxime compounds other than those described above, compounds in which oxime is linked to the N-position of carbazole, as described in Japanese National Phase Publication No. 2009-519904; compounds in which a hetero substituent is introduced into a benzophenone moiety, as described in U.S. Patent No. 7626957; compounds in which a nitro group is introduced into a dye moiety, as described in JP-A No. 2010-15025 and U.S. Patent Publication No. 2009-292039; ketooxime compounds described in WO 2009/131189; compounds containing a triazine skeleton and an oxime skeleton in the same molecule, as described in U.S. Patent No. 7556910; compounds which has an absorption maximum at 405 nm and has good sensitivity to a g-line light source, as described in JP-A No. 2009-221114; or the like may be used.

Further, cyclic oxime compounds described in JP-A Nos. 2007-231000 and 2007-322744 may also be used preferably. Among the cyclic oxime compounds, cyclic oxime compounds condensed to a carbazole dye, as described in JP-A Nos. 2010-32985 and 2010-185072, are particularly preferable from the viewpoints of exhibiting high absorptivity and attaining high sensitivity.

Furthermore, compounds having an unsaturated bond at a specific moiety of an oxime compound, as described in JP-A No. 2009-242469, may be used preferably because a high sensitivity is attained by regenerating an active radical from a polymerization inactive radical.

Most preferably, oxime compounds having a specific substituent as described in JP-A No. 2007-269779, and oxime compounds having a thioaryl group as described in JP-A No. 2009-191061 may be used.

Specifically, as the oxime compound, a compound represented by the following Formula (OX-1) is preferable. It should be noted that the oxime compound according to the invention may be an oxime compound in which the N-O bond of the oxime is in the (E) form or an oxime compound in which the N-O bond of the oxime is in the (Z) form, or a mixture of the (E) form and the (Z) form.

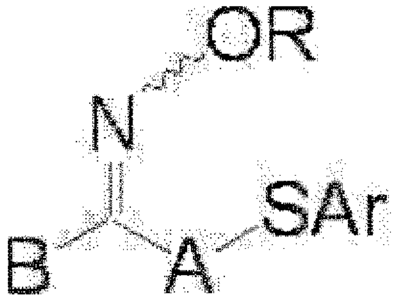

(OX-1)

In Formula (OX-1), R and B each independently represent a monovalent substituent; A represents a divalent organic group; and Ar represents an aryl group.

In Formula (OX-1), the monovalent substituent represented by R is preferably a monovalent nonmetallic atomic group.

Examples of the monovalent nonmetallic atomic group include an alkyl group, an aryl group, an acyl group, an alkoxycarbonyl group, an aryloxycarbonyl group, a heterocyclic group, an alkylthiocarbonyl group, and an arylthiocarbonyl group. These groups may have one or more substituents. Further, the substituents described above may be further substituted by another substituent.

Examples of the substituent include a halogen atom, an aryloxy group, an alkoxycarbonyl group, an aryloxycarbonyl group, an acyloxy group, an acyl group, an alkyl group, and an aryl group.

The alkyl group which may have a substituent is preferably an alkyl group having 1 to 30 carbon atoms, and specific examples thereof include a methyl group, an ethyl group, a propyl group, a butyl group, a hexyl group, an octyl group, a decyl group, a dodecyl group, an octadecyl group, an isopropyl group, an isobutyl group, a sec-butyl group, a t-butyl group, a 1-ethylpentyl group, a cyclopentyl group, a cyclohexyl group, a trifluoromethyl group, a 2-ethylhexyl group, a phenacyl group, a 1-naphthoylmethyl group, a 2-naphthoylmethyl group, a 4-methylsulfanylphenacyl group, a 4-phenylsulfanylphenacyl group, a 4-dimethylaminophenacyl group, a 4-cyanophenacyl group, a 4-methylphenacyl group, a 2-methylphenacyl group, a 3-fluorophenacyl group, a 3-trifluoromethylphenacyl group, and a 3-nitrophenacyl group.

The aryl group which may have a substituent is preferably an aryl group having 6 to 30 carbon atoms, and specific examples thereof include a phenyl group, a biphenyl group, a 1-naphthyl group, a 2-naphthyl group, a 9-anthryl group, a 9-phenanthryl group, a 1-pyrenyl group, a 5-naphthacenyl group, a 1-indenyl group, a 2-azulenyl group, a 9-fluorenyl group, a terphenyl group, a quaterphenyl group, an o-tolyl group, an m-tolyl group, a p-tolyl group, a xylyl group, an o-cumenyl group, an m-cumenyl group, a p-cumenyl group, a mesityl group, a pentalenyl group, a binaphthalenyl group, a ternaphthalenyl group, a quaternaphthalenyl group, a heptalenyl group, a biphenylenyl group, an indacenyl group, a fluoranthenyl group, an acenaphthylenyl group, an aceanthrylenyl group, a phenalenyl group, a fluorenyl group, an anthryl group, a bianthracenyl group, a teranthracenyl group, a quateranthracenyl group, an anthraquinolyl group, a phenanthryl group, a triphenylenyl group, a pyrenyl group, a chrysenyl group, a naphthacenyl group, a pleiadenyl group, a picenyl group, a perylenyl group, a pentaphenyl group, a pentacenyl group, a tetraphenylenyl group, a hexaphenyl group, a hexacenyl group, a rubicenyl group, a coronenyl group, a trinaphthylenyl group, a heptaphenyl group, a heptacenyl group, a pyranthrenyl group, and an ovalenyl group.

The acyl group which may have a substituent is preferably an acyl group having 2 to 20 carbon atoms, and specific examples thereof include an acetyl group, a propanoyl group, a butanoyl group, a trifluoroacetyl group, a pentanoyl group, a benzoyl group, a 1-naphthoyl group, a 2-naphthoyl group, a 4-methylsulfanylbenzoyl group, a 4-phenylsulfanylbenzoyl group, a 4-dimethylaminobenzoyl group, a 4-diethylaminobenzoyl group, a 2-chlorobenzoyl group, a 2-methylbenzoyl group, a 2-methoxybenzoyl group, a 2-butoxybenzoyl group, a 3-chlorobenzoyl group, a 3-trifluoromethylbenzoyl group, a 3-cyanobenzoyl group, a 3-nitrobenzoyl group, a 4-fluorobenzoyl group, a 4-cyanobenzoyl group, and a 4-methoxybenzoyl group.

The alkoxycarbonyl group which may have a substituent is preferably an alkoxycarbonyl group having 2 to 20 carbon atoms, and specific examples thereof include a methoxycarbonyl group, an ethoxycarbonyl group, a propoxycarbonyl group, a butoxycarbonyl group, a hexyloxycarbonyl group, an octyloxycarbonyl group, a decyloxycarbonyl group, an octadecyloxycarbonyl group, and a trifluoromethyloxycarbonyl group.

Specific examples of the aryloxycarbonyl group, which may have a substituent, include a phenoxycarbonyl group, a 1-naphtlryloxycarbonyl group, a 2-naphthyloxycarbonyl group, a 4-methylsulfanylphenyloxycarbonyl group, a 4-phenylsulfanylphenyloxycarbonyl group, a 4-dimethylaminophenyloxycarbonyl group, a 4-diethylaminophenyloxycarbonyl group, a 2-chlorophenyloxycarbonyl group, a 2-methylphenyloxycarbonyl group, a 2-methoxyphenyloxycarbonyl group, a 2-butoxyphenyloxycarbonyl group, a 3-chlorophenyloxycarbonyl group, a 3-trifluoromethylphenyloxycarbonyl group, a 3-cyanophenyloxycarbonyl group, a 3-nitrophenyloxycarbonyl group, a 4-fluorophenyloxycarbonyl group, a 4-cyanophenyloxycarbonyl group, and a 4-methoxyphenyloxycarbonyl group.

The heterocyclic group which may have a substituent is preferably a nitrogen atom-, oxygen atom-, sulfur atom-, or phosphorous atom-containing, aromatic or aliphatic heterocyclic group.

Specific examples thereof include a thienyl group, a benzo[b]thienyl group, a naphtho[2,3-b]thienyl group, a thianthrenyl group, a furyl group, a pyranyl group, an isobenzofuranyl group, a chromenyl group, a xanthenyl group, a phenoxathiinyl group, a 2H-pyrrolyl group, a pyrrolyl group, an imidazolyl group, a pyrazolyl group, a pyridyl group, a pyrazinyl group, a pyrimidinyl group, a pyridazinyl group, an indolizinyl group, an isoindolyl group, a 3H-indolyl group, an indolyl group, a 1H-indazolyl group, a purinyl group, a 4H-quinolizinyl group, an isoquinolyl group, a quinolyl group, a phthalazinyl group, a naphthyridinyl group, a quinoxalinyl group, a quinazolinyl group, a cinnolinyl group, a pteridinyl group, a 4aH-carbazolyl group, a carbazolyl group, a β-carbolinyl group, a phenanthridinyl group, an acridinyl group, a perimidinyl group, a phenanthrolinyl group, a phenazinyl group, a phenarsazinyl group, an isothiazolyl group, a phenothiazinyl group, an isooxazolyl group, a furazanyl group, a phenoxazinyl group, an isochromanyl group, a chromanyl group, a pyrrolidinyl group, a pyrrolinyl group, an imidazolidinyl group, an imidazolinyl group, a pyrazolidinyl group, a pyrazolinyl group, a piperidyl group, a piperazinyl group, an indolinyl group, an isoindolinyl group, a quinuclidinyl group, a morpholinyl group, and a thioxanthryl group.

Specific examples of the alkylthiocarbonyl group which may have a substituent include a methylthiocarbonyl group, a propylthiocarbonyl group, a butylthiocarbonyl group, a hexylthiocarbonyl group, an octylthiocarbonyl group, a decylthiocarbonyl group, an octadecylthiocarbonyl group, and a trifluoromethylthiocarbonyl group.

Specific examples of the arylthiocarbonyl group which may have a substituent include a 1-naphthylthiocarbonyl group, a 2-naphthylthiocarbonyl group, a 4-methylsufanylphenylthiocarbonyl group, a 4-phenylsulfanylphenylthiocarbonyl group, a 4-dimethylaminophenylthiocarbonyl group, a 4-diethylaminophenylthiocarbonyl group, a 2-chlorophenylthiocarbonyl group, a 2-methylphenylthiocarbonyl group, a 2-methoxyphenylthiocarbonyl group, a 2-butoxyphenylthiocarbonyl group, a 3-chlorophenylthiocarbonyl group, a 3-trifluoromethylphenylthiocarbonyl group, a 3-cyanophenylthiocarbonyl group, 3-nitrophenylthiocarbonyl group, a 4-fluorophenylthiocarbonyl group, 4-cyanophenylthiocarbonyl group, and a 4-methoxyphenylthiocarbonyl group.

In Formula (OX-1), the monovalent substituent represented by B represents an aryl group, a heterocyclic group, an arylcarbonyl group, or a heterocyclic carbonyl group. These groups may further have one or more substituents. Examples of the substituents include the substituents described above (i.e., the substituents which may be held by the monovalent non-metallic atomic group represented by R in Formula (OX-1)). Further, the substituents may further be substituted by another substituent.

In particular, the structures shown below are particularly preferable.

In the structures described below, Y, X, and n have the same definitions as Y, X, and n in Formula (OX-2) described below, respectively, and preferable examples thereof are also the same.

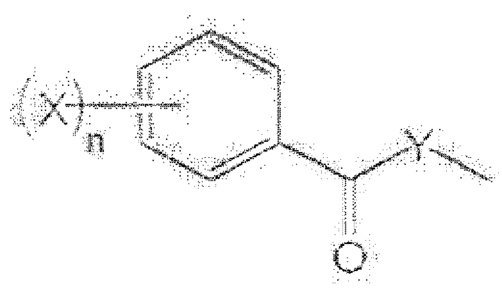
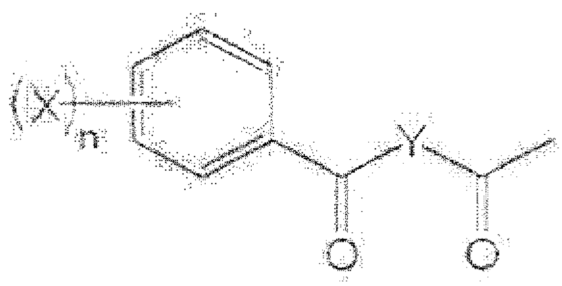

In Formula (OX-1), examples of the divalent organic group represented by A include an alkylene group having 1 to 12 carbon atoms, a cycloalkylene group, and an alkynylene group. These groups may have one or more substituents. Examples of the substituents may include the substituents described above (i.e., the substituents which may be held by the monovalent non-metallic atomic group represented by R in Formula (OX-1)). Further, the substituents may further be substituted by another substituent.

Among them, from the viewpoints of enhancing the sensitivity, and suppressing coloring due to heat-aging, A in Formula (OX-1) is preferably an unsubstituted alkylene group, an alkylene group substituted by an alkyl group (such as a methyl group, an ethyl group, a tert-butyl group, or a dodecyl group), an alkylene group substituted by an alkenyl group (such as a vinyl group or an allyl group), or an alkylene group substituted by an aryl group (such as a phenyl group, a p-tolyl group, a xylyl group, a cumenyl group, a naphthyl group, an anthryl group, a phenanthryl group, or a styryl group).

In Formula (OX-1), the aryl group represented by Ar is preferably an aryl group having 6 to 30 carbon atoms, which may have a substituent. Examples of the substituent include the same substituents as the substituents introduced into the substituted aryl groups, which are exemplified above as the specific examples of the aryl group which may have

a substituent.

Among them, from the viewpoints of enhancing the sensitivity, and suppressing coloring due to heat-aging, a substituted or unsubstituted phenyl group is preferable.

In Formula (OX-1), the structure of "SAr", which is formed by Ar and the adjacent S in Formula (OX-1), is preferably the structure shown below, from the viewpoint of sensitivity. Note that, Me represents a methyl group, and Et represents an ethyl group.

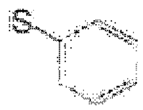
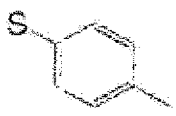
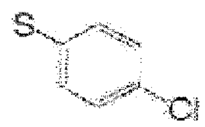
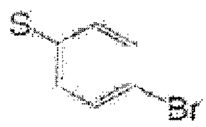
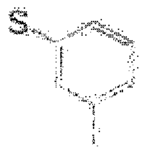
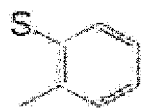
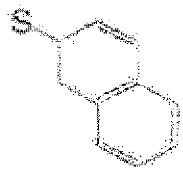
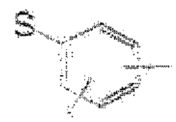
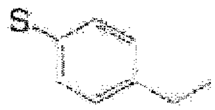
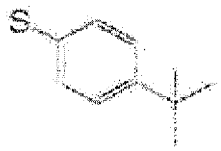
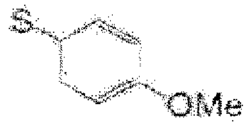
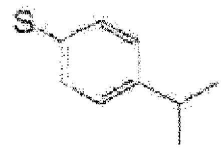
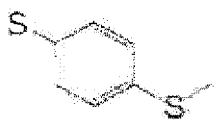
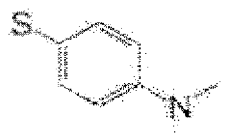
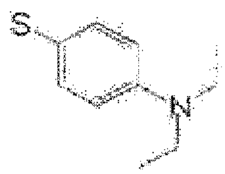
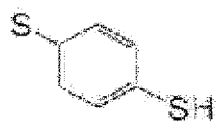
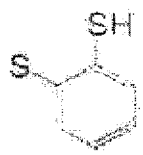
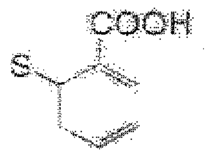
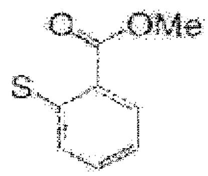
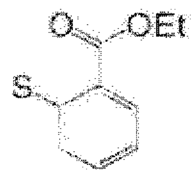
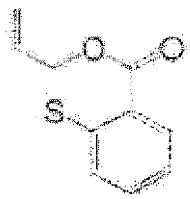

The oxime compound is preferably a compound represented by the following Formula (OX-2).

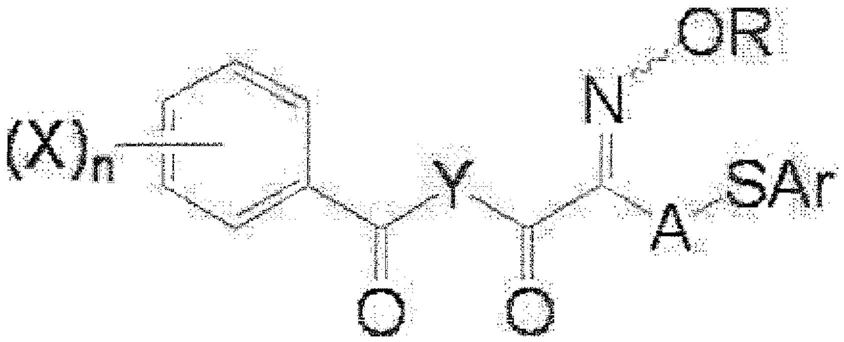

(OX-2)

In Formula (OX-2), R and X each independently represent a monovalent substituent; A and Y each independently represent a divalent organic group; Ar represents an aryl group; and n represents an integer of from 0 to 5.

R, A, and Ar in Formula (OX-2) have the same definitions as R, A, and Ar in Formula (OX-1), respectively, and preferable examples thereof are also the same.

In Formula (OX-2), examples of the monovalent substituent represented by X include an alkyl group, an aryl group, an alkoxy group, an aryloxy group, an acyloxy group, an acyl group, an alkoxycarbonyl group, an amino group, a heterocyclic group, and a halogen atom. These groups may have one or more substituents. Examples of the substituents may include the substituents described above (i.e., the substituents which may be held by the monovalent non-metallic atomic group represented by R in Formula (OX-1)). Further, the substituents may further be substituted by another substituent.

Among them, X in Formula (OX-2) is preferably an alkyl group, from the viewpoints of the solvent solubility and improvement in absorption efficiency in a long wavelength region.

Further, n in Formula (OX-2) represents an integer of from 0 to 5, and preferably represents an integer of from 0 to 2.

Examples of the divalent organic group represented by Y in Formula (OX-2) include the structures shown below. Note that, in the groups shown below, the "*" sign indicates a bonding site at which Y bonds to the adjacent carbon atom in Formula (OX-2).

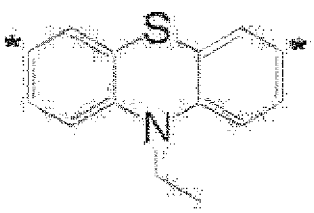 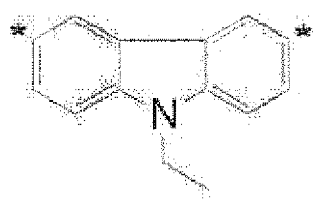 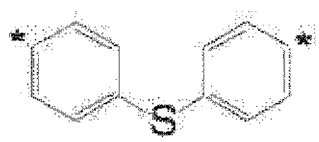

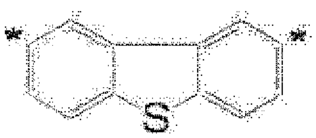 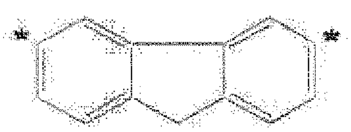 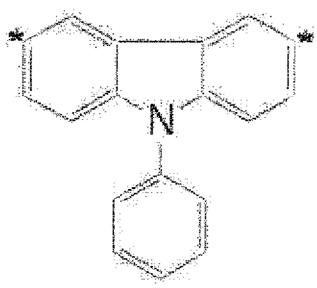

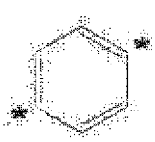 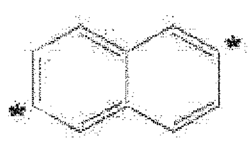 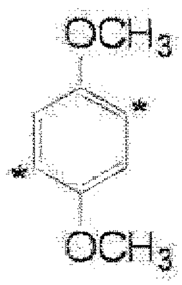

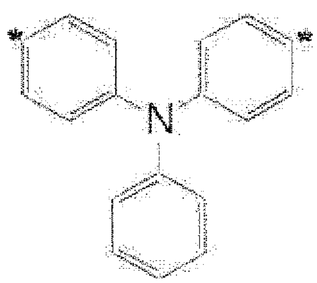

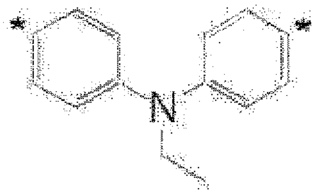

Among them, from the viewpoint of enhancement in sensitivity, the following structures are preferable.

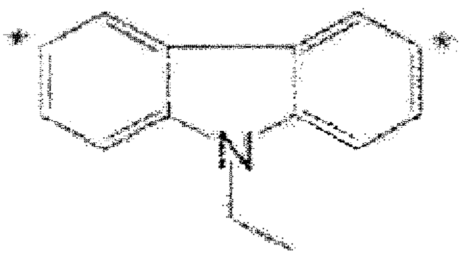

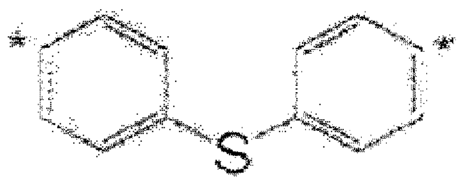

Moreover, the oxime compound is preferably a compound represented by the following Formula (OX-3).

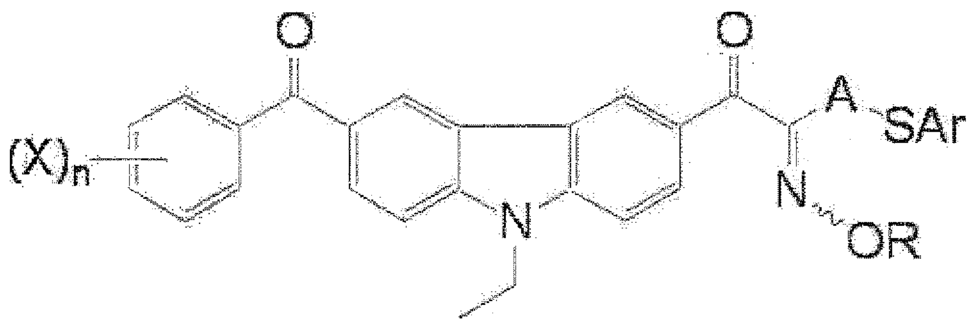

(OX-3)

In Formula (OX-3), R and X each independently represent a monovalent substituent; A represents a divalent organic group; Ar represents an aryl group; and n represents an integer of from 0 to 5.

R, X, A, Ar, and n in Formula (OX-3) have the same definitions as R, X, A, Ar, and n in Formula (OX-2), respectively, and preferable examples thereof are also the same.

Specific examples (C-4) to (C-14) of the oxime compound which is preferably used are shown below, but the present invention is not limited to these specific examples.

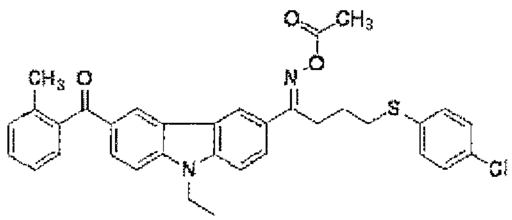

(C-4)

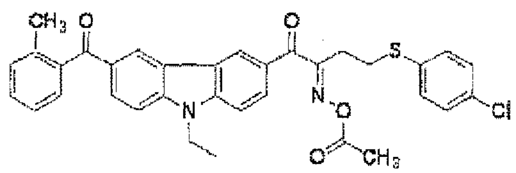

(C-5)

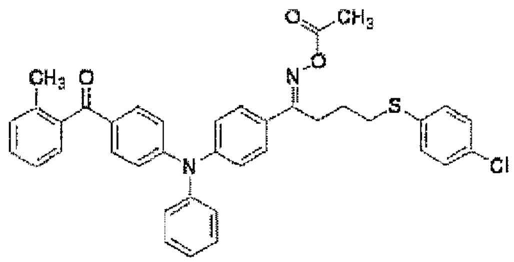

(C-6)

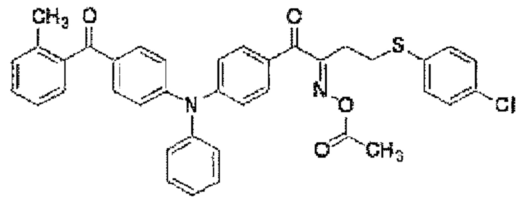

(C-7)

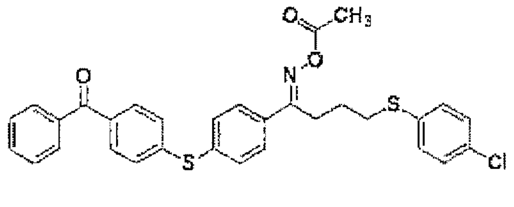

(C-8)

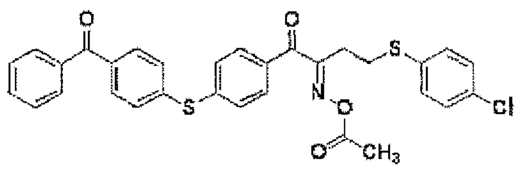

(C-9)

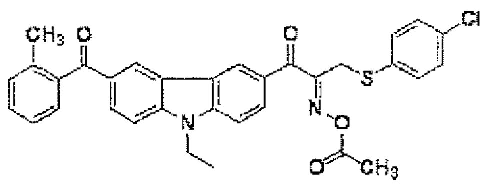

(C-10)

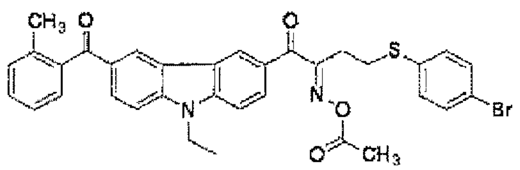

(C-11)

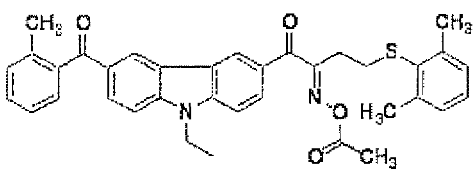

(C-12)

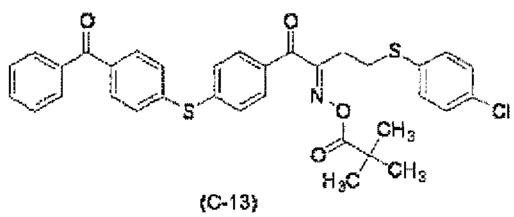

(C-13)

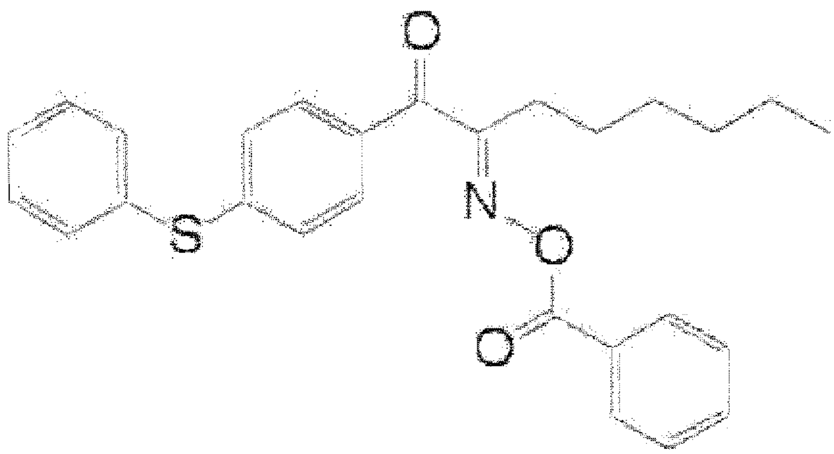

(C-14)

The oxime compound has a maximum absorption wavelength in a wavelength region of from 350 nm to 500 nm, preferably has an absorption wavelength in a wavelength region of from 360 nm to 480 nm, and particularly preferably has a high absorbance at 365 nm and 455 nm.

The molar absorption coefficient of the oxime compound at 365 nm or 405 nm is preferably from 1,000 to

300,000, more preferably from 2,000 to 300,000, and particularly preferably from 5,000 to 200,000, from the viewpoint of the sensitivity.

The molar absorption coefficient of a compound may be determined by a known method, specifically, for example, through measurement using an ultraviolet/visible light spectrophotometer (trade name: CARRY-5 SPECTROPHOTOMETER, manufactured by Varian), and using an ethyl acetate solvent, at a concentration of 0.01 g/L.

In the present invention, two or more polymerization initiators may be used in a combination, depending on needs.

From the viewpoint of exposure sensitivity, the (E) polymerization initiator used in the radiation sensitive composition of the present invention is preferably a compound selected from the group consisting of trihalomethyl triazine compounds, benzyl dimethyl ketal compounds, α-hydroxy ketone compounds, α-amino ketone compounds, acyl phosphine compounds, phosphine oxide compounds, metallocene compounds, oxime compounds, triallyl imidazole dimers, onium compounds, benzothiazole compounds, benzophenone compounds, acetophenone compounds and derivatives thereof, cyclopentadiene-benzene-iron complexes and salts thereof, halomethyl oxadiazole compounds, and 3-aryl-substituted coumarin compounds.

Trihalomethyl triazine compounds, α-amino ketone compounds, acyl phosphine compounds, phosphine oxide compounds, oxime compounds, triallyl imidazole dimers, onium compounds, benzophenone compounds, and acetophenone compounds are more preferable, and at least one compound selected from the group consisting of trihalomethyl triazine compounds, α-amino ketone compounds, oxime compounds, triallyl imidazole dimers, and benzophenone compounds is most preferable.

Especially, in a case in which the radiation sensitive composition of the present invention is used to prepare a light-shielding film of a solid state imaging element, a fine pattern should be formed in a sharp shape. Therefore it is important that the fine pattern is developed without remaining residues in the unexposed portions as well as curing property of the composition. From this point of view, it is particularly preferable to use an oxime compound as the polymerization initiator. In particular, in the case of forming a fine pattern in a solid state imaging element, a stepper exposure apparatus is used for the exposure for curing, but there are cases in which the exposure apparatus is damaged by halogen, and thus the addition amount of the polymerization initiator should also be suppressed to a low value. Considering these points, in order to form a fine pattern such as in a solid state imaging element, it is most preferable to use an oxime compound as the (E) polymerization initiator.

The content of the (E) polymerization initiator contained in the radiation sensitive composition of the present invention is preferably from 0.1% by mass to 50% by mass, more preferably from 0.5% by mass to 20% by mass, and even more preferably from 1% by mass to 15% by mass, with respect to the total content of solids in the radiation sensitive composition. When the content is within the above ranges, good sensitivity and pattern formability are obtained.

*(F) Other Additives*

The radiation sensitive composition of the present invention may further contain various additives depending on the purposes, in addition to the titanium black dispersion composition of the present invention, the (D) photopolymerizable compound, and the (E) photopolymerization initiator.

*(F-1) Alkali-Soluble Resin*

It is preferable that the radiation sensitive composition of the present invention further contains (F-1) an alkali-soluble resin. When an alkali-soluble resin is incorporated in the radiation sensitive composition, developability and pattern formability are improved.

The alkali-soluble resin is a linear organic polymer, and may be selected as appropriate from alkali-soluble resins having at least one group, that is capable of enhancing alkali solubility, in a molecule thereof (preferably, a molecule including an acrylic copolymer or a styrene copolymer as a main chain). From the viewpoint of heat resistance, a polyhydroxy styrene resin, a polysiloxane resin, an acrylic resin, an acrylamide resin, or an acryl/acrylamide copolymer resin is preferable, and from the viewpoint of controlling the developability, an acrylic resin, an acrylamide resin, or an acryl/acrylamide copolymer resin is preferable.

Examples of the group that is capable of enhancing alkali solubility (hereinafter, also referred to as the acidic group) include a carboxyl group, a phosphoric acid group, a sulfonic acid group, and a phenolic hydroxyl group. However, since the alkali-soluble resin used in the invention is preferably an alkali-soluble resin which is soluble in an organic solvent and developable by a weak alkali aqueous solution, (meth)acrylic acid is particularly preferable. The acidic groups may be used alone or in a combination of two or more of them.

Examples of a monomer capable of introducing an acidic group after polymerization include a monomer having a hydroxyl group such as 2-hydroxyethyl (meth)acrylate, a monomer having an epoxy group such as glycidyl (meth)acrylate, and a monomer having an isocyanato group such as 2-isocyanatoethyl (meth)acrylate. These monomers for

introducing the acidic group may be used alone or in a combination of two or more types of them. In order to introduce an acidic group into an alkali-soluble binder, for example, a monomer having an acidic group and/or a monomer capable of introducing an acidic group after polymerization (hereinafter, may be referred to as a "monomer for introducing an acidic group") is made to undergo polymerization as a monomer component. It should be noted that, in a case in which a monomer capable of introducing an acidic group after polymerization is used as a monomer component to introduce an acidic group, it is necessary to perform, for example, a treatment for introducing an acidic group as described below, after polymerization.

For example, a known radical polymerization method is applicable for the production of the alkali-soluble resin. When the alkali-soluble resin is produced by a radical polymerization method, the polymerization conditions such as temperature, pressure, the type and amount of radical initiator, the type of solvent, and the like may easily be determined by those skilled in the art, and the conditions may be derived experimentally.

The linear organic polymer which may be used as the alkali-soluble resin is preferably a resin having a carboxylic acid group in a side chain thereof. Examples thereof include a methacrylic acid copolymer, an acrylic acid copolymer, an itaconic acid copolymer, a crotonic acid copolymer, a maleic acid copolymer, a partially esterified maleic acid copolymer, and an alkali-soluble phenolic resin such as a novolac resin, as well as an acidic cellulose derivative having a carboxylic acid group in a side chain thereof, and a compound obtained by adding an acid anhydride to a polymer having a hydroxyl group. Particularly, a copolymer obtained by using (meth)acrylic acid and an additional monomer copolymerizable with (meth)acrylic acid is preferable as the alkali-soluble resin. Examples of the additional monomer copolymerizable with (meth)acrylic acid include an alkyl (meth)acrylate, an aryl (meth)acrylate, and a vinyl compound. Examples of the alkyl (meth)acrylate and aryl (meth)acrylate include methyl (meth)acrylate, ethyl (meth)acrylate, propyl (meth)acrylate, butyl (meth)acrylate, isobutyl (meth)acrylate, pentyl (meth)acrylate, hexyl (meth)acrylate, octyl (meth)acrylate, phenyl (meth)acrylate, benzyl (meth)acrylate, tolyl (meth)acrylate, naphthyl (meth)acrylate, and cyclohexyl (meth)acrylate. Examples of the vinyl compound include styrene, $\alpha$-methylstyrene, vinyltoluene, glycidyl methacylate, acrylonitrile, vinyl acetate, N-vinylpyrrolidone, tetrahydrofurfuryl methacrylate, a polystyrene macromonomer, a polymethyl methacrylate macromonomer, and a N-substituted maleimide monomer described in JP-A No. 10-300922 such as N-phenylmaleimide or N-cyclohexylmaleimide. One type of the additional monomer that can copolymerize with (meth)acrylic acid may be used alone, or two or more types of them may be used in combination.

The alkali-soluble resin preferably contains a polymer (a) obtained by polymerizing a monomer component that essentially includes a compound represented by the following Formula (ED) (hereinafter, may be referred to as "ether dimer"), as a polymer component (A) which is an essential component. By having such a configuration, the radiation sensitive composition of the present invention is capable of forming a cured coating film having an extremely excellent transparency as well as an extremely excellent heat resistance.

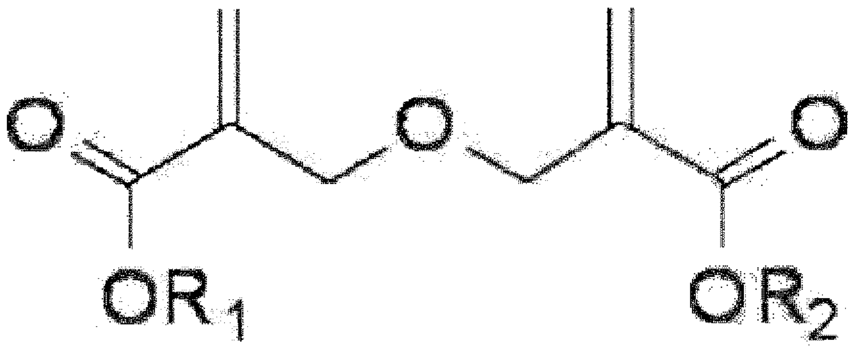

Formula (ED)

In Formula (ED), $R^1$ and $R^2$ each independently represent a hydrogen atom or a hydrocarbon group having 1 to 25 carbon atoms, which may have a substituent.

In Formula (ED) representing an ether dimer, the hydrocarbon group having 1 to 25 carbon atoms, which is represented by $R^1$ or $R^2$ and may have a substituent, is not particularly limited. Examples thereof include a straight chain or branched alkyl group, such as a methyl group, an ethyl group, a n-propyl group, an isopropyl group, a n-butyl group, an isobutyl group, a t-butyl group, a t-amyl group, a stearyl group, a lauryl group, or a 2-ethylhexyl group; an aryl group such as a phenyl group; an alicyclic group such as a cyclohexyl group, a t-butylcyclohexyl group, a dicyclopentadienyl

group, a tricyclodecanyl group, an isobornyl group, an adamantyl group, or a 2-methyl-2-adamantyl group; an alkyl group substituted by an alkoxy group, such as a 1-methoxyethyl group or a 1-ethoxyethyl group; and an alkyl group substituted by an aryl group such as a benzyl group. Among them, a substituent of primary or secondary carbon which is hardly eliminated by acid or heat, such as a methyl group, an ethyl group, a cyclohexyl group, or a benzyl group is particularly preferable in view of heat resistance.

Specific examples of the ether dimer include dimethyl-2,2'-[oxybis(methylene)] bis-2-propenoate, diethyl-2,2'-[oxybis(methylene)] bis-2-propenoate, di(n-propyl)-2,2'-[oxybis(methylene)] bis-2-propenoate, di(isopropyl)-2,2'-[oxybis(methylene)] bis-2-propenoate, di(n-butyl)-2,2'-[oxybis(methylene)] bis-2-propenoate, di(isobutyl)-2,2'-[oxybis(methylene)] bis-2-propenoate, di(t-butyl)-2,2'-[oxybis(methylene)]bis-2-propenoate, di(t-amyl)-2,2'-[oxybis(methylene)] bis-2-propenoate, di(stearyl)-2,2'-[axybis(methylene)] bis-2-propenoate, di(lauryl)-2,2'-[oxybis(methylene)]bis-2-propenoate, di(2-ethylhexyl)-2,2'-[oxybis(methylene)] bis-2-propenoate, di(1-methoxyethyl)-2,2'-[oxybis(methylene)]bis-2-propenoate, di(1-ethoxyethyl)-2,2'-[oxybis(methylene)]bis-2-propenoate, dibenzyl-2,2'-[oxybis(methylene)]bis-2-propenoate, diphenyl-2,2'-[oxybis(methylene)] bis-2-propenoate, dicyclohexyl-2,2'-[oxybis(methylene)]bis-2-propenoate, di(t-butylcyclohexyl)-2,2'-[oxybis(methylene)]bis-2-propenoate, di(dicyclopentadienyl)-2,2'-[oxybis(methylene)]bis-2-propenoate, di(tricyclodecanyl)-2,2'-[oxybis(methylene)]bis-2-propenoate, di(isobornyl)-2,2'-[oxybis(methylene)]bis-2-propenoate, diadamantyl-2,2'-[oxybis(methylene)]bis-2-propenoate, and di(2-methyl-2-adamantyl)-2,2'-[oxybis(methylene)]bis-2-propenoate. Among them, dimethyl-2,2'-[oxybis(methylene)]bis-2-propenoate, diethyl-2,2'-[oxybis(methylene)] bis-2-propenoate, dicyclohexyl-2,2'-[oxybis(methylene)]bis-2-propenoate, and dibenzyl-2,2'-[oxybis(methylene)]bis-2-propenoate are particularly preferable. One type of these ether dimers may be used alone, or two or more types of them may be used in combination. The structure unit derived from the compound represented by Formula (ED) may be copolymerized with another monomer.

The alkali-soluble phenolic resin may be preferably used in the case of preparing the radiation sensitive composition of the present invention as a positive type composition. Examples of the alkali-soluble phenolic resin include a novolac resin and a vinyl polymer.

Examples of the novolac resin include resins obtained through condensation reaction of a phenol with an aldehyde in the presence of an acid catalyst. Examples of the phenol include phenol, cresol, ethylphenol, butylphenol, xylenol, phenylphenol, catechol, resorcinol, pyrogallol, naphthol, and bisphenol A.

Examples of the aldehyde include formaldehyde, paraformaldehyde, acetaldehyde, propionaldehyde, and benzaldehyde.

The phenols and the aldehydes may be used alone or in a combination of two or more of them, respectively.

Specific examples of the novolac resin include metacresol, paracresol, and an condensation reaction product of a mixture thereof with formalin.

The molecular weight distribution of the novolac resin may be adjusted by fractionation or the like. Further, a low molecular weight component having a phenolic hydroxyl group such as bisphenol C or bisphenol A may be mixed with the novolac resin.

In order to enhance the crosslinking efficiency of the radiation sensitive composition of the present invention, an alkali-soluble resin having a polymerizable group may be used. As the alkali-soluble resin having a polymerizable group, an alkali-soluble resin containing an allyl group, a (meth)acryloyl group, an allyloxyalkyl group, or the like in a side chain thereof, and the like are useful. Examples of the polymer having a polymerizable group as described above include DIANAL NR series (trade name, manufactured by Mitsubishi Rayon Co., Ltd.); PHOTOMER 6173 (trade name, manufactured by Diamond Shamrock Co., Ltd.; COOH-containing polyurethane acrylic oligomer); VISCOAT R-264 and KS RESIST 106 (all trade names, manufactured by Osaka Organic Chemical Industry Ltd.); CYCLOMER P series and PLACCEL CF200 series (all trade names, manufactured by Daicel Chemical Industries, Ltd.), and EBECRY 13800 (trade name, manufactured by Daicel UCB Company LTD.). As the alkali-soluble resin having a polymerizable group, a urethane-modified polymerizable double bond-containing acrylic resin, which is obtained by allowing an acrylic resin having a carboxyl group to react with a compound in which isocyanato groups and OH groups have been previously reacted with each other to leave one unreacted isocyanato group and which contains a (meth)acryloyl group; an unsaturated group-containing acrylic resin which is obtained by allowing an acrylic resin having a carboxyl group to react with a compound having both an epoxy resin and a polymerizable double bond in a molecule thereof; an acid-pendant epoxy acrylate resin; a polymerizable double bond-containing acrylic resin which is obtained by allowing an acrylic resin containing an OH group to react with a dibasic acid anhydride having a polymerizable double bond; a resin obtained by allowing an acrylic resin containing an OH group to react with an isocyanate and a compound having a polymerizable group; a resin obtained by subjecting a resin having, in a side chain thereof, an ester group having a leaving group such as a halogen atom or a sulfonato group at the $\alpha$ position or $\beta$ position to a basic treatment, which is described in JP-A Nos. 2002-229207 and 2003-335814; and the like are preferable.

The alkali-soluble resin is particularly preferably a benzyl (meth)acrylate/(meth)acrylic acid copolymer or a multi-element copolymer consisting of benzyl (meth)acrylate/(meth)acrylic acid/another monomer. Other examples thereof include a copolymer obtained by copolymerizing 2-hydroxyethyl methacrylate; a 2-hydroxypropyl (meth)acrylate/

polystyrene macromonomer/ benzyl methacrylate/ methacrylic acid copolymer described in JP-A No. 7-140654; a 2-hydroxy-3-phenoxypropyl acrylate/ polymethyl methacrylate macromonomer/ benzyl methacrylate/ methacrylic acid copolymer; a 2-hydroxyethyl methacrylate/ polystyrene macromonomer/ methyl methacrylate/ methacrylic acid copolymer; and a 2-hydroxyethyl methacrylate/ polystyrene macromonomer/ benzyl methacrylate/ methacrylic acid copolymer.

As the alkali-soluble resin, among the alkali-soluble resins described above, an alkali-soluble resin having a polymerizable group in a side chain thereof is preferable.

The acid value of the alkali-soluble resin is preferably from 10 mgKOH/g to 200 mgKOH/g, more preferably from 20 mgKOH/g to 150 mgKOH/g, and most preferably from 30 mgKOH/g to 120 mgKOH/g.

Further, the weight average molecular weight (Mw) of the alkali-soluble resin is preferably from 5,000 to 30,000, more preferably from 6,000 to 25,000, and most preferably from 7,000 to 20,000.

The content of the alkali-soluble resin in the radiation sensitive composition of the present invention is preferably from 0.1% by mass to 7.0% by mass, with respect to the total content of solids in the composition, and from the viewpoint of achieving both the suppression of peeling of a light-shielding film and the suppression of generation of development residues, the content is more preferably from 0.3% by mass to 6.0% by mass, and even more preferably from 1.0% by mass to 5.0% by mass, with respect to the total content of solids in the composition. When the content of the alkali-soluble resin is within the above ranges, it becomes possible to reduce the surface roughness of the light-shielding film which is formed by using the alkali-soluble resin.

*(F-2) Colorant*

The radiation sensitive composition of the present invention may contain (F-2) a colorant other than the inorganic pigment, such as a known organic pigment or dye, for the purpose of achieving the desired light-shielding properties.

Concerning the (F-2) colorant which can be used in combination, examples of the organic pigment include pigments described in paragraphs [0030] to [0044] of JP-A No. 2008-224982, pigments which are prepared by changing the Cl substituent to OH in C. I. Pigment Green 58 and C. I. Pigment Blue 79, and the like. Among them, preferable examples of the usable pigment may include the following pigments. However, the (F-2) colorant which can be used in the present invention is not limited to these examples.

C. I. Pigment Yellow 11, 24, 108, 109, 110, 138, 139, 150, 151, 154, 167, 180, 185;
C. I. Pigment Orange 36, 38, 62, 64;
C. I. Pigment Red 122, 150, 171, 175, 177, 209, 224, 242, 254, 255;
C. I. Pigment Violet 19, 23, 29, 32;
C. I. Pigment Blue 15:1, 15:3, 15:6, 16, 22, 60, 66;
C. I. Pigment Green 7, 36, 37, 58; and
C. I. Pigment Black 1

Further, the dye which can be used as the (F-2) colorant is not particularly limited, and known dyes may be appropriately selected and used. Examples thereof include dyes described in JP-A Nos. 64-90403, 64-91102, 1-94301, and 6-11614, Japanese Patent No. 2592207, U.S. Patent Nos. 4,808,501, 5,667,920, and 5,059,500, and JP-A Nos. 5-333207, 6-35183, 6-51115, 6-194828, 8-211599, 4-249549, 10-123316, 11-302283, 7-286107, 2001-4823, 8-15522, 8-29771, 8-146215, 11-343437, 8-62416, 2002-14220, 2002-14221, 2002-14222, 2002-14223, 8-302224, 8-73758, 8-179120, and 8-151531.

Examples of a chemical structure of the dye include chemical structures of pyrazole azo, anilino azo, triphenylmethane, anthraquinone, anthrapyridone, benzylidene, oxonol, pyrazolotriazole azo, pyridone azo, cyanine, phenothazine, pyrrolopyrazole azomethine, xanthene, phthalocyanine, benzopyran, indigo, pyromethene, or the like.

In the radiation sensitive composition of the present invention, in a case in which the (F-2) colorant is used in combination with the (A) substance to be dispersed which is incorporated in the composition as an essential component, the (F-2) colorant is preferably one or more types of organic pigments selected from the group consisting of orange pigments, red pigments, and violet pigments, from the viewpoint of achieving both the curing property and the light-shielding properties. A combination with a red pigment is most preferable.

As the orange pigment, red pigment, or violet pigment, which is used in combination with the substance to be dispersed in the present invention, for example, a pigment that belongs to the above exemplified "C. I. Pigment Orange", "C. I. Pigment Red", or "C. I. Pigment Violet" may be selected as appropriate depending on the intended light-shielding property. From the viewpoint of enhancing the light-shielding properties, C. I. Pigment Violet 29, C. I. Pigment Orange 36, 38, 62, and 64, C. I. Pigment Red 177, 254, and 255, and the like are preferable.

*(F-3) Sensitizer*

The radiation sensitive composition of the present invention may contain (F-3) a sensitizer for the purposes of enhancing the efficiency of radical generation of the (E) photopolymerization initiator and lengthening the wavelength

of the photosensitive wavelength.

The (F-3) sensitizer is preferably a sensitizer that is capable of sensitizing the (E) photopolymerization initiator to be used according to an electron transfer mechanism or an energy transfer mechanism.

Preferable examples of the (F-3) sensitizer include the compounds described in paragraphs [0085] to [0098] in JP-A No. 2008-214395.

The content of the (F-3) sensitizer is preferably in a range of from 0.1% by mass to 30% by mass, more preferably in a range of from 1% by mass to 20% by mass, and even more preferably in a range of from 2% by mass to 15% by mass, with respect to the total content of solids in the radiation sensitive composition, from the viewpoints of the sensitivity and the storage stability.

*(F-4) Polymerization Inhibitor*

The radiation sensitive composition of the invention preferably contains a small amount of (F-4) a polymerization inhibitor, for the purpose of inhibiting unnecessary thermal polymerization of the polymerizable compound during the production or storage of the composition.

Examples of the (F-4) polymerization inhibitor which may be used in the present invention include hydroquinone, p-methoxyphenol, di-t-butyl-p-cresol, pyrogallol, t-butylcatechol, benzoquinone, 4,4'-thiobis(3-methyl-6-t-butylphenol), 2,2'-methylenebis(4-methyl-6-t-butylphenol), and N-nitrosophenylhydroxyamine cerous salt. Among them, p-methoxyphenol is preferable.

The addition amount of the polymerization inhibitor is preferably from about 0.01% by mass to about 5% by mass, with respect to the total content of solids in the radiation sensitive composition.

From the viewpoint of preventing the polymerization inhibition caused by oxygen, if necessary, a higher fatty acid derivative or the like such as behenic acid or behenamide may be added to the composition, so that the higher fatty acid derivative or the like locally exists on the surface of the coating film during the drying process after coating. The addition amount of the higher fatty acid derivative is preferably from about 0.5% by mass to about 10% by mass of the total composition.

*(F-5) Adhesion Improver*

The radiation sensitive composition of the invention may contain (F-5) an adhesion improver, in order to improve the adhesiveness of the composition to a hard surface of glass or the like.

Examples of the (F-5) adhesion improver include a silane coupling agent and a titanium coupling agent.

Preferable examples of the silane coupling agent include $\gamma$-methacryloyloxy propyl trimethoxysilane, $\gamma$-methacryloyloxy propyl triethoxysilane, $\gamma$-acryloyloxy propyl trimethoxysilane, $\gamma$-acryloyloxy propyl triethoxysilane, $\gamma$-mercaptopropyl trimethoxysilane, $\gamma$-aminopropyl triethoxysilane, and phenyltrimethoxysilane. Among them, $\gamma$-methacryloyloxy propyl trimethoxysilane is more preferable.

The content of the (F-5) adhesion improver is preferably from 0.5% by mass to 30% by mass, and more preferably from 0.7% by mass to 20% by mass, with respect to the total content of solids in the radiation sensitive composition.

*(F-6) Surfactant*

Various surfactants may be added to the radiation sensitive composition of the present invention from the viewpoint of further improving the coatability. As the surfactant, various surfactants such as a fluorosurfactant, a nonionic surfactant, a cationic surfactant, an anionic surfactant, or a silicone-containing surfactant may be used. Among these surfactants, a fluorosurfactant is preferable.

In particular, by incorporating a fluorosurfactant, when the radiation sensitive composition of the invention is prepared as a coating liquid, the liquid characteristics (especially, fluidity) are further improved, and thus uniformity of the coating thickness or liquid saving property is further improved.

That is, in a case in which a film is formed by using a coating liquid which is prepared by using a radiation sensitive composition containing a fluorosurfactant, the interfacial tension between the surface to be coated and the coating liquid is lowered, and as a result, the wettability to the surface to be coated may be improved, and coatability onto the surface to be coated may be enhanced. For this reason, even in a case in which a thin film having a thickness of about several micrometers is formed with a small amount of the liquid, the fluorosurfactant is effective in that formation of a film having uniform thickness with less thickness unevenness can be more suitably carried out.

The fluorine content in the fluorosurfactant is preferably from 3% by mass to 40% by mass, more preferably from 5% by mass to 30% by mass, and particularly preferably from 7% by mass to 25% by mass. A fluorosurfactant having the fluorine content within the ranges is effective in terms of the uniformity in thickness of the coating film or the

liquid saving property, and has good solubility in the radiation sensitive composition.

Examples of the fluorosurfactant include MEGAFACE F171, MEGAFACE F172, MEGAFACE F173, MEGAFACE F176, MEGAFACE F177, MEGAFACE F141, MEGAFACE F142, MEGAFACE F143, MEGAFACE F 144, MEGAFACE R30, MEGAFACE F437, MEGAFACE F475, MEGAFACE F479, MEGAFACE F482, MEGAFACE F554, MEGAFACE F780, and MEGAFACE F781 (all trade names, manufactured by DIC Corporation), FLUORAD FC430, FLUORAD FC431, and FLUORAD FC171 (all trade names, manufactured by Sumitomo 3M Limited), and SURFLON S-382, SURFLON SC-101, SURFLON SC-103, SURFLON SC-104, SURFLON SC-105, SURFLON SC1068, SURFLON SC-381, SURFLON SC-383, SURFLON S393, and SURFLON KH-40 (all trade names, manufactured by Asahi Glass Co., Ltd.).

Specific examples of the nonionic surfactant include glycerol, trimethylolpropane, trimethylolethane and ethoxylates or propoxylates thereof (for example, glycerol propoxylate, glycerin ethoxylate, or the like), polyoxyethylene lauryl ether, polyoxyethylene stearyl ether, polyoxyethylene oleyl ether, polyoxyethylene octyl phenyl ether, polyoxyethylene nonyl phenyl ether, polyethylene glycol dilaurate, polyethylene glycol distearate, and sorbitan fatty acid esters (for example, PLURONIC L10, L31, L61, L62, 10R5, 17R2, or 25R2, TETRONIC 304, 701, 704, 901, 904, or 150R1 (all trade names, manufactured by BASF Corporation), or the like).

Examples of the cationic surfactant include a phthalocyanine derivative (trade name: EFKA-745, available from Morishita & Co., Ltd.), an organosiloxane polymer KP341 (trade name, manufactured by Shin-Etsu Chemical Co., Ltd.), (meth)acrylic acid (co)polymers POLYFLOWNo. 75, No. 90, and No. 95 (all trade names, manufactured by Kyoeisha Chemical Co., Ltd.), and W001 (trade name, available from Yusho Co., Ltd.).

Specific examples of the anionic surfactant include W004, W005, and W017 (all trade names, available from Yusho Co., Ltd.).

Examples of the silicone-containing surfactant include "TORAY SILICONE DC3PA", "TORAY SILICONE SH7PA", "TORAY SILICONE DC11PA", "TORAY SILICONE SH21PA", "TORAY SILICONE SH28PA", "TORAY SILICONE SH29PA", "TORAY SILICONE SH30PA", and "TORAY SILICONE SH8400" (all trade names, manufactured by Dow Corning Toray Co., Ltd.), "TSF-4440", "TSF-4300", "TSF-4445", "TSF-4460", and "TSF-4452" (all trade names, manufactured by Momentive Performance Materials Inc.), "KP341", "KF6001", and "KF6002" (all trade names, manufactured by Shin-Etsu Silicone Chemical Co., Ltd.), and "BYK307", "BYK323", and "BYK330" (all trade names, manufactured by BYK Japan KK).

One of the surfactants may be used alone, or two or more of them may be used in combination.

The amount of the surfactant to be added to the radiation sensitive composition is preferably from 0.001 % by mass to 2.0% by mass, and more preferably from 0.005% by mass to 1.0% by mass, with respect to the total mass of the radiation sensitive composition.

*(F-7) Other Additives*

The radiation sensitive composition may contain a co-sensitizer for the purpose of further improving the sensitivity of the sensitizing dye or the initiator to actinic radiations, suppressing the polymerization inhibition of a photopolymerizable compound caused by oxygen, or the like. Moreover, in order to improve the physical properties of the cured film, known additives such as a diluent, a plasticizer, or a fat sensitizer may be added, as necessary.

*Preparation of Titanium Black Dispersion Composition*

There is no particular limitation as to the preparation method of the titanium black dispersion composition of the present invention. For example, the titanium black dispersion composition of the invention may be prepared by subjecting the (A) substance to be dispersed, the (B) dispersant, and the (C) organic solvent to a dispersion treatment using a stirrer, a homogenizer, a high pressure emulsifler, a wet grinder, a wet disperser, or the like, but the invention is not limited thereto.

The dispersion treatment may be performed by carrying out a dispersion treatment twice or more times (multistage dispersion).

*Preparation of Black Radiation Sensitive Composition*

There is no particular limitation also as to the preparation method of the black radiation sensitive composition of the present invention. For example, the radiation sensitive composition may be prepared by mixing the titanium black dispersion composition of the present invention, the (D) polymerizable compound, and the (E) photopolymerization initiator, and if necessary, various additives.

The black radiation sensitive composition prepared as described above may be used after being subjected to filtration using a filter preferably having a pore size of from about 0.01 μm to about 3.0 μm, and more preferably having a pore size of from about 0.05 μm to about 0.5 μm, or the like.

*Formation of Light-Shielding Film*

Next, the light-shielding film in the present invention and the method for producing the light-shielding film are described.
The light-shielding film in the present invention is a light-shielding film is formed on a silicone substrate using the black radiation sensitive composition of the present invention.
The silicone substrate may be a substrate in which an imaging element has been previously formed on one side, or an imaging element may be formed after the formation of the light-shielding film.
Further, a colored pixel may be formed after the formation of the light-shielding film or a colored pixel may be formed before the formation of the light-shielding film.
The black radiation sensitive composition of the present invention may preferably be used for forming a light-shielding film which is disposed at a peripheral edge of an effective pixel region (imaging unit) of a solid state imaging element.
The film thickness of the light-shielding film is not particularly limited, but from the viewpoint of more effectively obtaining the effect of the invention, the film thickness after drying is preferably in a range of from 0.3 $\mu$m to 10 $\mu$m, more preferably in a range of from 0.5 $\mu$m to 8 $\mu$m, and even more preferably in a range of from 0.7 $\mu$m to 5 $\mu$m.
The size (length of each side) of the light-shielding film after pattern formation is not particularly limited, but from the viewpoint of more effectively obtaining the effect of the invention, the size is preferably in a range of from 0.5 mm to 35 mm, more preferably in a range of from 1 mm to 30 mm, and even more preferably in a range of from 5 mm to 25 mm.
A preferable method for producing the light-shielding film according to the present invention includes: coating the black radiation sensitive composition of the present invention on a silicone substrate to form a black radiation sensitive composition layer thereon (hereinafter, suitably abbreviated as a "radiation sensitive composition layer forming process"); exposing the black radiation sensitive composition layer in a pattern shape (hereinafter, suitably abbreviated as an "exposure process"); and developing the black radiation sensitive composition layer that has been subjected to exposure, to form a pattern (hereinafter, suitably abbreviated as a "developing process").
Hereinafter, each of the processes in the method for producing the light-shielding film according to the present invention is described.

*Black Radiation Sensitive Composition Layer Forming Process*

First, the substrate used in the radiation sensitive composition layer forming process is explained.
Examples of the substrate used for a color filter include photoelectric conversion element substrates used for solid state imaging elements or the like, such as a silicone substrate or a plastic substrate.
Plastic substrates preferably have, on their surfaces, a gas barrier layer and/or a solvent resistant layer.
In the radiation sensitive composition layer forming process, the method of forming a radiation sensitive composition layer on a substrate is not particularly limited, but a method using a slit nozzle such as a spin coating method, a slit-and-spin method, a spinless coating method, or the like is preferable.
When a coating film is formed on a substrate by using a radiation sensitive composition, with regard to the light-shielding film for a solid state imaging element, the thickness of the coating film (after a prebake treatment) is preferably in a range of from 0.5 $\mu$m to 3 $\mu$m.
In the radiation sensitive composition layer forming process, a prebake treatment is usually performed after the coating. According to need, a vacuum treatment may be performed before the prebaking.
The conditions for vacuum drying are such that the degree of vacuum is usually from 0.1 Torr to 1.0 Torr, and preferably from about 0.2 Torr to about 0.5 Torr.
Further, the prebake treatment may be performed using a hot plate, an oven, or the like, under such conditions as a temperature range of from 50°C to 140°C, preferably from about 70°C to about 110°C. for 10 seconds to 300 seconds. A high-frequency treatment or the like may be conducted together with the prebake treatment. Alternatively, the high-frequency treatment may also be conducted alone.

*Exposure Process*

In the exposure process, the radiation sensitive composition layer formed from the radiation sensitive composition produced as described above is subjected to light exposure through a predetermined mask pattern. The radiation used for the exposure is preferably any one of ultraviolet rays such as g-lines, h-lines, i-lines, or j-lines.
Particularly, in a case in which a light-shielding film for a solid state imaging element is to be produced, it is preferable to mainly use i-lines with a stepper exposure apparatus.

*Development Process*

In the development process, the unexposed portions (uncured portions) of the radiation sensitive composition layer that has been subjected to light exposure are eluted into a developing solution, and as a result, only the cured portions remain on the substrate. The development temperature is usually from 20°C to 30°C, and the development time is from 20 seconds to 90 seconds. As the developing solution, any developing solution may be used as far as it dissolves the uncured portions of the coating film formed by using the radiation sensitive composition while not dissolving the cured portions. Specifically, a combination of various organic solvents, or an alkaline aqueous solution may be used.
Examples of the organic solvent used in the development include the above (C) organic solvents which can be used in the preparation of the radiation sensitive composition in the present invention.
Examples of the alkaline aqueous solution include alkaline aqueous solutions prepared by dissolving an alkaline compound such as sodium hydroxide, potassium hydroxide, sodium carbonate, sodium hydrogencarbonate, sodium silicate, sodium metasilicate, aqueous ammonia, ethylamine, diethylamine, dimethylethanolamine, tetramethylammonium hydroxide, tetraethylammonium hydroxide, choline, pyrrole, piperidine, or 1,8-diazabicyclo-[5,4,0]-7-undecene, so as to give a concentration of from 0.001% by mass to 10% by mass, and preferably from 0.01% by mass to 1% by mass.
An organic alkaline aqueous solution is preferable. To the alkaline aqueous solution, for example, a water-soluble organic solvent such as methanol or ethanol, a surfactant, or the like may be added in an appropriate amount.
The development system may be any of a paddle system, a dip system, a shower system, a spray system, or the like, which may be combined with a swing system, a spin system, an ultrasonic system, or the like. It is also possible to previously wet the surface to be developed with water or the like, before allowing the surface to contact with a development solution, to prevent development unevenness. Further, it is also possible to perform development while tilting the substrate.

*Post- Curing Process*

After the process of forming a pattern by development as described above, it is preferable to carry out a post-curing process of further curing the obtained pattern. The post-curing process is carried out by means of heating and/or light exposure (using ultraviolet irradiation), whereby the obtained pattern is further cured. As a result, dissolution or the like of the pattern in the pattern forming process in the colored pixel formation may be prevented, and solvent resistance of the pixels in the light-shielding film having a pattern formed thereon may be enhanced. The post-curing process is preferably performed by ultraviolet irradiation.
The post-curing process by a heating treatment (post-heating, post-bake) may be carried out after carrying out drying, via a rinsing treatment for washing and removing excess developing solution. In the rinsing treatment, usually pure water is used, but, for saving pure water, it is also possible to use a method of using pure water at the final washing while using used pure water at the initial stage of washing, washing while tilting the substrate, or using ultrasonic irradiation in combination.
After the rinsing treatment, water is drained, and drying is performed, and thereafter, a heating treatment is carried out usually at about 200°C to about 250°C. The heating treatment (post-bake) may be performed for the coating film that has been subjected to development, using a heating means, such as a hot plate, a convection oven (hot air circulating drier), or a high-frequency heating machine, so as to give the above conditions, in a continuous system or a batch system. The time for heating treatment is preferably from 30 seconds to 30,000 seconds, and more preferably from 60 seconds to 1,000 seconds.
The post-curing process (ultrasonic irradiation process) by exposure (post-exposure) may be carried out using g-lines, h-lines, i-lines, KrF, ArF, ultraviolet light, an electron beam, X-rays, or the like, but g-lines, h-lines, i-lines, and UV light are preferable, and ultraviolet light is particularly preferable. It is desirable to irradiate the pattern that has been subjected to the development process with ultraviolet light such that the irradiation luminous energy is 10 times or more of the exposure amount in the previous exposure process. The irradiation luminous energy of the ultraviolet light is preferably from 12 times to 200 times of the exposure amount in the previous exposure process, and more preferably from 15 times to 100 times. As the light source, for example, a high-pressure mercury lamp, a low-pressure mercury lamp, or the like may be used.
In the post-curing process, post-exposure and post-heating may be used in combination, and in this case, either of them may be performed first, but it is preferable to carry out post-exposure before post-heating. The reason for this is as follows. Namely, by accelerating the curing with post-exposure, thermal sagging of a pattern or deformation due to hemming bottom, which may be seen during post-heating, may be suppressed.
On the silicone substrate having a shielding film obtained in this way, a colored pixel for color separation is formed, and used as a solid state imaging element. The colored pixel is configured to include pixels of plural hues, and by repeating the above pattern forming process (and, as necessary, the post-curing process) for a number corresponding to the number of colors, a color filter for color separation which is configured to have a desired number of hues can be

prepared.

*Solid State Imaging Element*

The solid state imaging element in the present invention has at least a color filter having the light-shielding film (black matrix) described above and, as necessary, a patterned film including pixels of other colors (three colors or four colors).

In the solid state imaging element in the present invention, lowering of light-shielding ability in the peripheral portion is suppressed, and the amount of residues of the obtained pattern are reduced, and in addition, since the linearity of the pattern is good, the noise is reduced and color reproducibility is enhanced.

The solid state imaging element in the present invention is equipped with the light-shielding film (black matrix) described above. The configuration of the solid state imaging element in the present invention is not particularly limited as far as it functions as a solid state imaging element. For example, the solid state imaging element of the present invention has, on a substrate, a light-receiving element including plural photodiodes, polysilicon, and the like, to constitute a light-receiving area of the solid state imaging element (CCD image sensor, CMOS image sensor, or the like), and has a black matrix according to the present invention on the side of the substrate opposite from the face formed thereon the light-receiving element.

Further, the radiation sensitive composition of the present invention may be also preferably used for forming a light-shielding film disposed at a peripheral edge of an effective pixel region (imaging unit) of a solid state imaging element.

EXAMPLES

Hereinafter, the present invention is described in more detail with reference to Examples. However, the invention is by no means limited to the following Examples unless they are beyond the spirit of the invention. Unless otherwise specifically stated, "part" is mass basis, and "room temperature" indicates 25°C.

*Preparation of Titanium Black*

First, 100 g of titanium oxide MT-10EX (trade name, manufactured by Tayca Corporation) having a particle diameter of 10 nm, 15 g of silica particles AEROSIL (registered trademark) 300 SP (trade name, manufactured by Evonik) having a BET specific surface area of 300 $m^2/g$, and 100 g of DISPERBYK 190 (trade name, manufactured by BYK Chemie) were weighed, and 71 g of electrically deionized water were added thereto. Then, the resulting mixture was treated using MAZERSTAR KK-400W (trade name, manufactured by KURABO) at a rotation of 1,360 rpm and a revolution of 1,047 rpm for 60 minutes, to obtain a homogeneous mixture aqueous solution. This aqueous solution was charged in a quartz container and heated using a mini rotary kiln (manufactured by MOTOYAMA CO., LTD.) in an oxygen atmosphere at 910°C. Thereafter, the atmosphere was substituted with nitrogen, and ammonia gas was let to flow at the same temperature and at 100 mL/min for 5 hours. Then, the obtained powder was pulverized using a mortar, thereby obtaining titanium black A (substance to be dispersed) having a specific surface area of 84 $m^2/g$ in the form of powder.

Further, in a similar manner except that changing the amount of silica particles to 12.5 g, 10 g, 8 g, and 25 g, respectively, titanium black B, titanium black C, titanium black D, and titanium black E, each of these being a substance to be dispersed, were obtained.

*Synthesis of Dispersant 1*

Separately, 600.0 g of ε-caprolactone and 22.8 g of 2-ethyl-1-hexanol were introduced into a 500 mL three-necked flask, and stirred and dissolved while blowing nitrogen into the flask. Then, 0.1 g of monobutyl tin oxide were added thereto, followed by heating to 100°C. After 8 hours, it was confirmed that the raw materials were lost by means of gas chromatography, and then the mixture was cooled to 80°C. Then, 0.1 g of 2,6-di-t-butyl-4-methylphenol were added thereto, and then 27.2 g of 2-methacryloyloxyethyl isocyanate were added thereto. After 5 hours, it was confirmed that the raw materials were eliminated by means of $^1H$-NMR, and then the resulting mixture was cooled to room temperature. In this way, 200 g of precursor M1 [the following structure] were obtained in the form of a solid. It was confirmed that the synthesized compound was M1 by means of $^1H$-NMR, IR, and mass spectrometry.

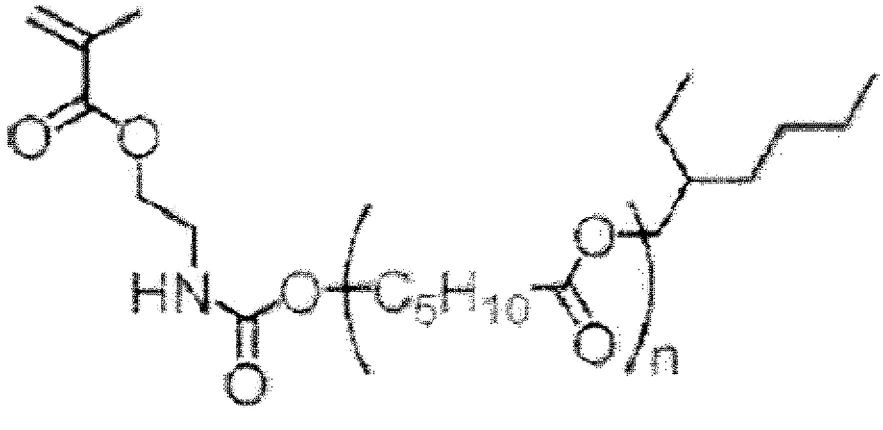

M1

Next, 30.0 g of the precursor M1, 70.0 g of NK ESTER CB-1 (trade name, manufactured by Shin-Nakamura Chemical Co., Ltd.; 2-methacryloyloxyethyl phthalate), 2.3 g of dodecylmercaptan, and 233.3 g of propylene glycol monomethyl ether acetate were introduced into a three-necked flask in which the atmosphere inside the flask had been replaced with nitrogen. The resulting mixture was stirred using a stirrer (trade name: THREE-ONE MOTOR, manufactured by Shinto Scientific Co., Ltd.), and while blowing nitrogen into the flask, the mixture was heated to 75°C. Then, 0.2 g of dimethyl 2,2-azobis(2-methylpropionate) (trade name: V-601, manufactured by Wako Pure Chemical Industries, Ltd.) were added thereto, followed by heating and stirring at 75°C for 2 hours. Two hours later, 0.2 g of V-601 were further added thereto, and the mixture thus obtained was heated and stirred for 3 hours. In this way, a 30% solution of dispersant 1 having the following structure was obtained.

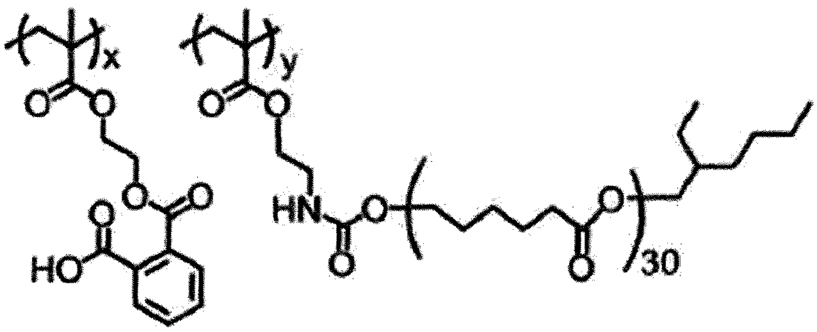

Dispersant 1

The composition ratio, the acid value, and the weight average molecular weight (Mw) of the dispersant 1 were as described below.

Here, the weight average molecular weight is a value which is measured using gel permeation chromatography (GPC) and is calculated in terms of polystyrene. For the GPC, HLC-8020 GPC (trade name, manufactured by Tosoh Corp.) was used, and TSK GEL SUPER HZM-H, TSK GEL SUPER HZ4000, and TSK GEL SUPER HZ200 (all trade names, manufactured by Tosoh Corp.) were used as the columns.

- Composition ratio : x = 33 (% by mass), y = 67 (% by mass)
- Acid value : 85 mgKOH/g
- Mw : 35,000

*Example 1 (not part of the claimed invention)*

*Preparation of Titanium Black Dispersion Composition*

The components shown in the following composition 1 were mixed for 15 minutes using a stirrer (trade name: EUROSTAR, manufactured by IKA) to obtain a dispersion mixture.

(Composition 1)

| | |
|---|---|
| • (A) Substance to be dispersed: titanium black A (powder) | 25 parts |
| • (B) Dispersant: 30% solution of dispersant 1 | 50 parts |
| • (C) Organic solvent: propylene glycol monomethyl ether acetate | 15 parts |
| • (C) Organic solvent: butyl acetate | 10 parts |

The dispersion mixture thus obtained was subjected to a dispersion treatment under the following conditions, by using BEAD MILL NPM (trade name, manufactured by Sinmaru Enterprises Corporation), recirculating piping, and a charging tank, thereby obtaining 2,000 g of titanium black dispersion composition A.

Dispersion Conditions

- Bead diameter: φ0.05 mm
- Bead filling rate: 60% by volume
- Mill peripheral speed: 10 m/sec
- Amount of the mixed liquid to be subjected to the dispersion treatment: 5000 g
- Circulation flow rate (pump supply amount): 30 kg/hour
- Temperature of treatment liquid: 25°C to 30°C
- Cooling water: tap water
- Treatment time: 30 passes

*Preparation of Black Radiation Sensitive Composition*

The components in the following composition 2 were mixed using a stirrer, to obtain black radiation sensitive composition A.

(Composition 2)

| | |
|---|---|
| • Titanium black dispersion composition A | 24 parts |
| • (F-1) Alkali-soluble resin: benzyl methacrylate/methyl methacrylate/hydroxyethyl methacrylate/acrylic acid copolymer (50/15/5/30 [mole ratio], Mw: 8000) | 1.6 parts |
| • (D) Polymerizable compound: dipentaerythritol hexaacrylate | 2.0 parts |
| • (D) Polymerizable compound: pentaerythritol triacrylate | 1.0 parts |
| • (E) Photopolymerization initiator: compound having the following structure | 0.3 parts |
| • (C) Organic solvent: propylene glycol monomethyl ether acetate | 10 parts |
| • (C) Organic solvent: ethyl 3-ethoxypropionate | 8 parts |

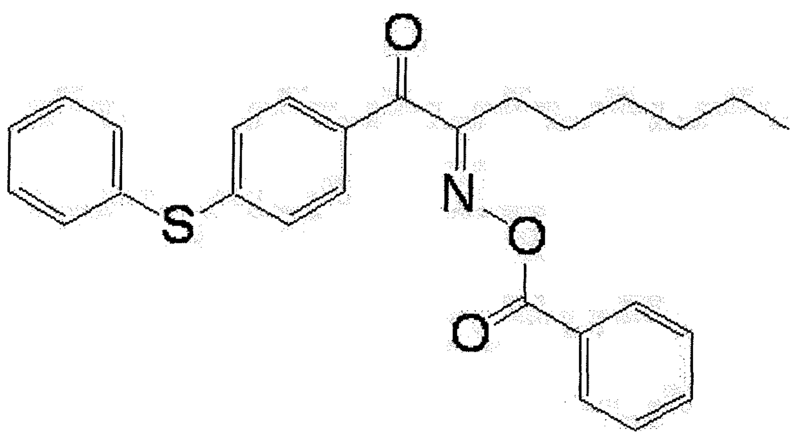

*Examples 2 and 3 (not part of the claimed invention), and Comparative Examples 1 to 3*

*Preparation of Titanium Black Dispersion Compositions*

Titanium black dispersion composition B, titanium black dispersion composition C, titanium black dispersion composition D, titanium black dispersion composition E, and titanium black dispersion composition F were produced in the same manner as in the preparation of the titanium black dispersion composition in Example 1, except that the titanium black A (i.e., the substance to be dispersed) used in the preparation of the titanium black dispersion composition in Example 1 was changed to the titanium black B (i.e., a substance to be dispersed), the titanium black C (i.e., a substance to be dispersed); the titanium black D (i.e., a substance to be dispersed), the titanium black E (i.e., a substance to be dispersed), and 13M-T (trade name, manufactured by Mitsubishi Materials Corporation), respectively.

*Preparation of Black Radiation Sensitive Compositions*

Black radiation sensitive compositions B, C, D, E, and F were produced in the same manner as in the preparation of the black radiation sensitive composition A, except that the titanium black dispersion composition A used in the preparation of the black radiation sensitive composition in Example 1 was changed to the titanium black dispersion composition B, the titanium black dispersion composition C, the titanium black dispersion composition D, the titanium black dispersion composition E, and the titanium black dispersion composition F, respectively.
The type of the black radiation sensitive composition used in each of the Examples and Comparative Examples are shown in Table 1.

*Evaluation of Light-Shielding Ability and Dispersion Stability*

The titanium black dispersion compositions obtained in Examples 1 to 3 and Comparative Examples 1 to 3 were each placed in a 2 L plastic container and were stored while standing still at room temperature for 6 months. The dispersion compositions before and after the standing storage were each coated on a glass substrate using a spin coater such that the thickness after drying was 3.0 μm to obtain a light-shielding film. With regard to the obtained light-shielding films, the absorbance at a wavelength of 550 nm was measured by using a spectroscope UV3600 (trade name, manufactured by Shimadzu Corporation). The dispersion stability (the following equation) was evaluated according to the ratio of the absorbances before and after the standing storage. Further, the light-shielding ability was evaluated according to the absorbance at the wavelength of 550 nm. The results are shown in Table 1.

$$\text{Dispersion Stability (\%)} = \{1 - (\text{Absorbance at 550 nm After Standing}/\text{Absorbance at 550 nm Before Standing})\} \times 100$$

*Measurement of BET Specific Surface Area*

The specific surface area ($m^2/g$) of the substance to be dispersed in the light-shielding film obtained by using each of the titanium black dispersion compositions of Examples 1 to 3 and Comparative Examples 1 to 3 before the standing storage used in the evaluation of dispersion stability was measured as follows.
The light-shielding film was chipped off from the substrate by using a spatula, and the powder thus obtained was treated in an electric furnace under an $O_2$ atmosphere at 600°C for 3 hours, whereby organic components, such as a dispersant or the like, were removed by thermal decomposition. Then, using AUTOSURB IMP (trade name, manufactured by Quantachrome Instruments), 0.2 g of the obtained powder were pre-dried using a mantle heater at 200°C for 12 hours, and then the measurement of specific surface area was carried out in accordance with the BET three-point method using $N_2$ as the atmosphere gas. The results are shown in Table 1.

*Si/Ti Ratio*

Further, the Si/Ti ratio in the light-shielding film obtained by using each of the titanium black dispersion compositions of Examples 1 to 3 and Comparative Examples 1 to 3 before the standing storage, which were used in the evaluation of dispersion stability, was measured as follows.
The light-shielding film was chipped off from the substrate by using a spatula, and the black powder thus obtained was treated in an electric furnace under an $O_2$ atmosphere at 600°C for 3 hours, whereby organic components, such as a dispersant or the like, were removed by thermal decomposition. Then, the atom% of Si atoms and Ti atoms

in the obtained powder was measured from the peak caused by the existence of 2p bonds of Ti atoms and the peak caused by the existence of 2p bonds of Si atoms, by using an X-ray photoelectron spectrometer, PHI 5400MC (trade name, manufactured by Perkin-Elmer Corporation), whereby the Si/Ti (= atom% of Si atoms/atom% of Ti atoms) was obtained. The results are shown in Table 1.

*Evaluation of Resistance to Development Solution*

Preparation of a light-shielding film was conducted in a manner substantially similar to that in the evaluation of dispersion stability, except that a silicone substrate was used instead of using a glass substrate as the substrate, and each of the black radiation sensitive compositions was used as the coating liquid. The radiation sensitive composition layer thus obtained was subjected to pattern exposure using an i-line stepper via a mask capable of making a line-and-space of 10 μm/10 μm, at an exposure amount of 100 $mJ/cm^2$, 200 $mJ/cm^2$, 300 $mJ/cm^2$, 400 $mJ/cm^2$, and 500 $mJ/cm^2$, respectively.

Then, the radiation sensitive composition layer that had been subjected to exposure was subjected to a paddle development, using a 0.3% aqueous solution of tetramethylammonium hydroxide, at room temperature for 60 seconds. Thereafter, the resulting layer was rinsed by spin showering, washed with pure water, and then subjected to a curing treatment on a hot plate at 200°C for 5 minutes. In this way, a pattern-formed light-shielding film was obtained.

The pattern-formed light-shielding film obtained as described above was subjected to a paddle development, using a 0.3% aqueous solution of tetramethylammonium hydroxide, at room temperature for 60 seconds, for the second time. Thereafter, the resulting layer was rinsed by spin showering and further washed with pure water.

The surface of the light-shielding film obtained in the manner as described above was observed using SEM S-3400N (trade name, manufactured by Hitachi High-Technologies Corporation) at 15.000X magnification, and the surface roughness was evaluated.

Table 1

| | Dispersion Composition or Radiation Sensitive Composition | BET Specific Surface Area ($m^2/g$) | Si/Ti Ratio | Light-Shielding Ability | Dispersion Stability (%) | Surface Roughness |
|---|---|---|---|---|---|---|
| Example 1 | A | 84 | 0.41 | 3.1 | 5 | Not exist |
| Example 2 | B | 60 | 0.35 | 3.0 | 3 | Not exist |
| Example 3 | C | 55 | 0.20 | 3.0 | 4 | Not exist |
| Comparative Example 1 | D | 72 | 0.18 | 2.7 | 24 | Not exist |
| Comparative Example 2 | E | 94 | 0.45 | 2.0 | 2 | Exist |
| Comparative Example 3 | F | 30 | 0 | 2.8 | 60 | Exist |

From the results shown in Table 1, it was understood that the light-shielding films prepared by using the dispersion compositions of Examples 1 to 3 exhibited an excellent light-shielding ability and a good dispersion stability, as compared with the light-shielding films obtained by using the dispersion compositions of Comparative Examples.

Further, it was understood that the light-shielding films prepared by using the radiation sensitive compositions of Examples 1 to 3 did not have roughness in the pattern when a pattern was formed, and thus, it was understood that the radiation sensitive compositions of the present invention were superior to the radiation sensitive compositions of Comparative Examples.

It is thought that the surface roughness of a pattern may be generated during the development process or during the re-development process after the curing process.

*Example 4 (not part of the claimed invention)*

A light-shielding film was formed at the peripheral edge of an effective pixel region (imaging unit) of a solid state imaging element, by using the black radiation sensitive composition in Example 1. As a result, an excellent solid state imaging element was obtained.

*Example 5*

Dispersant 2 (which is indicated as (J-1) in the scheme shown below) was synthesized in accordance with the synthesis example 2 described below. A dispersion composition and a radiation-sensitive composition were produced in the same manner as in Example 1, except that the dispersant 2 was used instead of using the dispersant 1 used in Example 1. The dispersion composition and the radiation-sensitive composition thus obtained were evaluated in a manner substantially similar to that in Example 1.

As a result, the obtained dispersion composition and radiation-sensitive composition exhibited an excellent light-shielding ability and a good dispersion stability, as in Example 1, and further, surface roughness was not observed in the light-shielding film prepared by using the same.

*Synthesis Example 2: Synthesis of Dispersant 2*

The dispersant 2, that is, (J-1), was synthesized as follows.

First, 55 g of a macromonomer (the following structure N-1) (weight average molecular weight according to GPC (as converted in terms of polystyrene): 3,500), 35 g of a monomer (the following structure B-1), 10 g of methacrylic acid, and 6 g of dodecanethiol were added to 233 g of propylene glycol monomethyl ether, followed by stirring in a nitrogen atmosphere at 75°C for one hour. Then, 0.5 g of V-601 (trade name, manufactured by Wako Pure Chemical Industries, Ltd.) were added thereto, followed by heating for 2 hours. Then, 0.5 g of V-601 were further added thereto, followed by heating for 2 hours. Thereafter, the mixture was heated at 90°C for 2 hours, and cooled, thereby obtaining a 30% solution of (J-1), which is the dispersant 2.

The scheme is shown below.

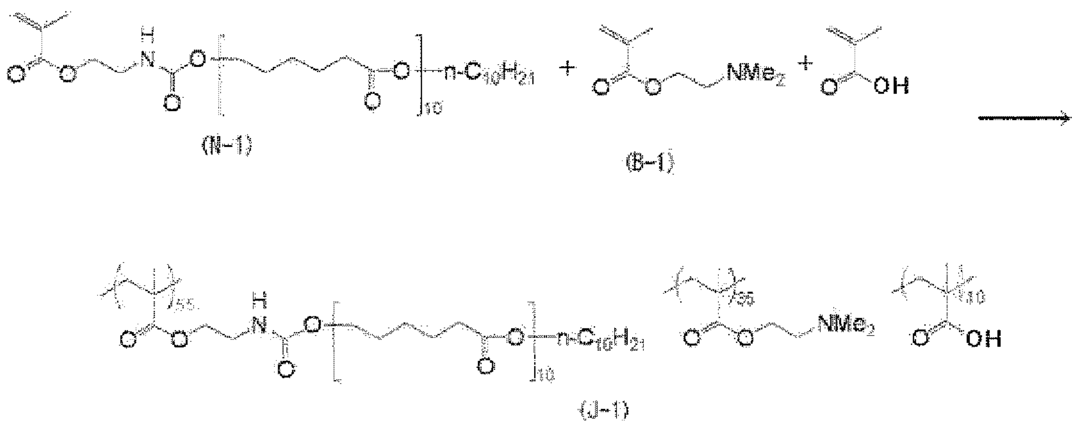

(N-1) (B-1) (J-1)

*Examples 6 to 22 and Comparative Examples 4 to 5*

Dispersants 3 to 19 (which are indicated as (J-2) to (J-9) and (J-12) to (J-20) in the table shown below, respectively) and comparative dispersants 1 and 2 (which are indicated as (J-10) and (J-11) in the table shown below, respectively) were synthesized in accordance with Synthesis Examples 3 to 19 and Comparative Synthesis Examples 1 and 2 described below. Dispersion compositions and radiation-sensitive compositions were produced in the same manner as in Example 1, except that the dispersant 1 used in Example 1 was changed to the dispersants 3 to 19 and comparative dispersants 1 and 2, respectively. The dispersion compositions and the radiation-sensitive compositions thus obtained were evaluated in a manner substantially similar to that in Example 1.

As a result, the obtained dispersion compositions and radiation-sensitive compositions which contained the dispersants 3 to 19, respectively, exhibited excellent light-shielding ability and good dispersion stability, as in Example 1, and further, surface roughness was not observed in the light-shielding films prepared by using the same.

*Synthesis Examples 3 to 19 and Comparative Synthesis Examples 1 and 2 Synthesis of resins (J-2) to (J-20)*

Resins (J-2) to (J-9) and (J-12) to (J-20), which are specific resins in the present invention, and comparative resins (J-10) and (J-11) were obtained in the same manner as in Synthesis Example 2 mentioned above, except that the macromonomer N-1, monomer B-1, and methacrylic acid used in Synthesis Example 2 were changed to the macromonomers and monomers shown in Table 2 below, respectively.

In Table 2, macromonomer N-2 was AA-6 (trade name, manufactured by Toa Gosei Co., Ltd.; Mw measured

by GPC in terms of polystyrene: 6,500), macromonomer N-3 was PLACCEL FA10L (trade name, manufactured by Daicel Chemical Industries, Ltd.; Mw measured by GPC in terms of polystyrene: 3,000), and macromonomers N-4 (Mw in terms of polystyrene: 13,000) and N-5 (Mw in terms of polystyrene: 21,000) were the macromonomers shown below.

In Table 2, monomers M-7, M-17, M-37, M-40, M-47, and M-48 shown were monomers mentioned above as specific examples of the monomer (b-1), and monomer M-28 was a monomer mentioned above as a specific example of the monomer (b-2).

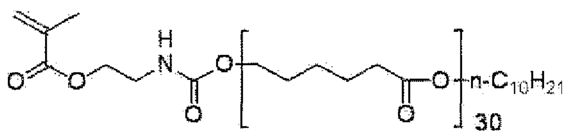

(N-4)

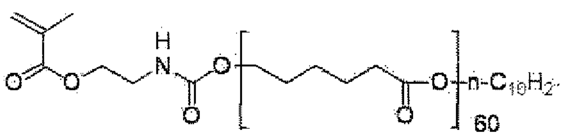

(N-5)

Table 2

| | Resin | Macromonomer | | Monomer 1 | | Monomer 2 | |
|---|---|---|---|---|---|---|---|
| Synthesis Example 2 | (J-1) | N-1 | 55 g | 2-Dimethylaminoethyl methacrylate | 35 g | Methacrylic acid | 10 g |
| Synthesis Example 3 | (J-2) | N-1 | 85 g | 2-Dimethylaminoethyl methacrylate | 10 g | Methacrylic acid | 5 g |
| Synthesis Example 4 | (J-3) | N-1 | 25 g | 2-Dimethylaminoethyl methacrylate | 55 g | Methacrylic acid | 20 g |
| Synthesis Example 5 | (J-4) | N-1 | 45 g | 3-Dimethylaminopropyl methacrylamide | 35 g | 1-(2-hydroxyethyl)-2-(2-methacryloyloxyethyl) phthalate | 20 g |
| Synthesis Example 6 | (J-5) | N-1 | 55 g | M-7 | 35 g | M-28 | 10 g |
| Synthesis Example 7 | (J-6) | N-1 | 55 g | M-17 | 35 g | Acrylic acid | 10 g |
| Synthesis Example 8 | (J-7) | N-1 | 55 g | 2-(tert-butylamino)ethyl methacrylate | 35 g | Methacrylic acid | 10 g |
| Synthesis Example 9 | (J-8) | N-2 | 55 g | 2-Dimethylaminoethyl methacrylate | 35 g | Methacrylic acid | 10 g |
| Synthesis Example 10 | (J-9) | N-3 | 55 g | 2-Dimethylaminoethyl methacrylate | 35 g | Methacrylic acid | 10 g |
| Synthesis Example 11 | (J-12) | N-1 | 55 g | 4-Vinylpyridine | 35 g | Methacrylic acid | 10 g |
| Synthesis Example 12 | (J-13) | N-1 | 55 g | N-Vinylimidazole | 35 g | Methacrylic acid | 10 g |
| Synthesis Example 13 | (J-14) | N-4 | 55 g | 2-Dimethylaminoethyl methacrylate | 35 g | Methacrylic acid | 10 g |
| Synthesis Example 14 | (J-15) | N-5 | 55 g | 2-Dimethylaminoethyl methacrylate | 35 g | Methacrylic acid | 10 g |
| Synthesis Example 15 | (J-16) | N-1 | 55 g | M-37 | 25 g | Methacrylic acid | 10 g |
| | | | | 2-Dimethylaminoethyl methacrylate | 10 g | | |
| Synthesis Example 16 | (J-17) | N-1 | 55 g | M-38 | 25 g | Methacrylic acid | 10 g |
| | | | | 2-Dimethylaminoethyl methacrylate | 10 g | | |

(continued)

| | Resin | Macromonomer | | Monomer 1 | | Monomer 2 | |
|---|---|---|---|---|---|---|---|
| Synthesis Example 17 | (J-18) | N-1 | 55 g | M-47 | 25 g | Methacrylic acid | 10 g |
| | | | | 2-Dimethylaminoethyl methacrylate | 10 g | | |
| Synthesis Example 18 | (J-19) | N-1 | 55 g | M-48 | 25 g | Methacrylic acid | 10 g |
| | | | | 2-Dimethylaminoethyl methacrylate | 10 g | | |
| Synthesis Example 19 | (J-20) | N-1 | 55 g | M-48 | 35 g | Methacrylic acid | 10 g |
| Comparative Synthesis Example 1 | (J-10) | N-1 | 55 g | 2-Dimethylaminoethyl methacrylate | 35 g | Methyl methacrylate | 10 g |
| Comparative Synthesis Example 2 | (J-11) | N-1 | 55 g | Methyl methacrylate | 35 g | Methacrylic acid | 10 g |

Table 3 below shows the physical values (such as weight average molecular weight (Mw), amine value, and acid value) of the resins (J-1) to (J-20) obtained in Synthesis Examples 2 to 19 and Comparative Synthesis Examples 1 and 2.

Table 3

| Resin | Mw | Amine value (mgKOH/g) | Acid value (mgKOH/g) |
|---|---|---|---|
| (J-1) | 14,000 | 125 | 65 |
| (J-2) | 32,000 | 35 | 31 |
| (J-3) | 8,000 | 192 | 135 |
| (J-4) | 13,000 | 113 | 40 |
| (J-5) | 11,000 | 120 | 36 |
| (J-6) | 13,000 | 194 | 79 |
| (J-7) | 15,000 | 106 | 63 |
| (J-8) | 21,000 | 124 | 64 |
| (J-9) | 15,000 | 125 | 65 |
| (J-10) | 15,000 | 125 | 0 |
| (J-11) | 14,000 | 0 | 66 |
| (J-12) | 13,000 | 187 | 65 |
| (J-13) | 15,000 | 0 | 65 |
| (J-14) | 34,000 | 125 | 65 |
| (J-15) | 56,000 | 125 | 65 |
| (J-16) | 18,000 | 32 | 64 |
| (J-17) | 15,000 | 36 | 65 |
| (J-18) | 16,000 | 35 | 66 |
| (J-19) | 15,000 | 34 | 65 |
| (J-20) | 17,000 | 0 | 64 |

## Claims

**1.** A titanium black dispersion composition for a solid state imaging element, the composition comprising:

(A) particles, or aggregates of particles, which comprise Si atoms and titanium black in the form of black particles having titanium atoms, the particles or aggregates of particles having a BET specific surface area in the range of from 55 $m^2/g$ to 84 $m^2/g$, and a ratio of Si atoms to Ti atoms (Si atoms/Ti atoms) in the range from 0.20-0.41:1 measured in accordance with the method set out in the section headed "Si/Ti Ratio" in the Examples section of the description;
(B) an amphoteric copolymer dispersant of a monomer (b-1) having at least one group selected from an amino group or a nitrogen-containing heterocyclic group, a monomer (b-2) having a carboxyl group, and a macromonomer (b-3) having a weight average molecular weight of from 1,000 to 50,000; and
(C) an organic solvent.

**2.** A titanium black dispersion composition according to Claim 1, wherein the macromonomer (b-3) is a polyester macromonomer represented by the formula:

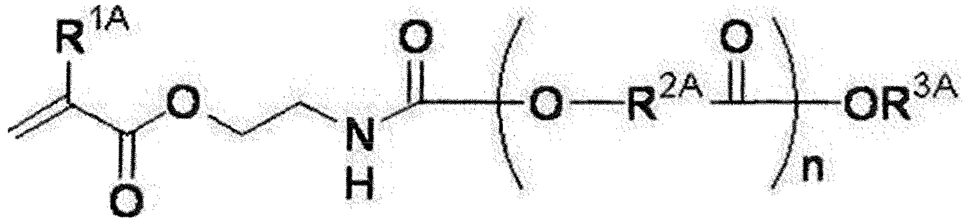

wherein $R^{1A}$ represents a hydrogen atom or a methyl group; $R^{2A}$ represents an alkylene group; $R^{3A}$ represents an alkyl group; n represents an integer of 5 to 100; and plural $R^{2A}$'s present in a molecule may be the same as or different from each other.

**3.** A black radiation-sensitive composition for a solid state imaging element, the composition comprising:

the titanium black dispersion composition as defined in Claim 1 or Claim 2;

(D) a polymerizable compound; and
(E) a photopolymerization initiator.

**4.** The use of the black radiation-sensitive composition as defined in Claim 3 for forming a black cured film.

**5.** A method of producing a black cured film comprising the steps of:

applying the black radiation-sensitive composition as defined in Claim 3 onto a silicone substrate to form a black radiation-sensitive composition layer;
subjecting the black radiation-sensitive composition layer to pattern light exposure; and
developing the black radiation-sensitive composition layer after the light exposure to form a pattern.

**Patentansprüche**

**1.** Titanschwarz-Dispersionszusammensetzung für ein Festkörper-Bildgebungselement, wobei die Zusammensetzung umfasst:

(A) Partikel oder Aggregate von Partikeln, die Si-Atome und Titanschwarz in der Form von schwarzen Partikeln, die Titanatome aufweisen, umfassen, wobei die Partikel oder die Aggregate der Partikel eine spezifische BET-Oberfläche im Bereich von 55 $m^2/g$ bis 84 $m^2/g$ und ein Verhältnis von Si-Atomen zu Ti-Atomen (Si-Atome/Ti-Atome) im Bereich von 0,20 bis 0,41:1 aufweisen, gemessen gemäß dem Verfahren, das in dem Abschnitt mit der Überschrift "Si/Ti-Verhältnis" im Beispielsabschnitt der Beschreibung beschrieben ist;
(B) ein amphoteres Copolymer-Dispergiermittel aus einem Monomer (b-1), das zumindest eine Gruppe aufweist, ausgewählt aus einer Aminogruppe oder einer stickstoffhaltigen heterocyclischen Gruppe, einem Monomer (b-2) mit einer Carboxylgruppe und einem Makromonomer (b-3) mit einem gewichtsgemittelten Molekulargewicht von 1.000 bis 50.000; und
(C) ein organisches Lösungsmittel.

**2.** Titanschwarz-Dispersionszusammensetzung gemäß Anspruch 1, worin das Makromonomer (b-3) ein durch die Formel dargestelltes Polyester-Makromonomer ist:

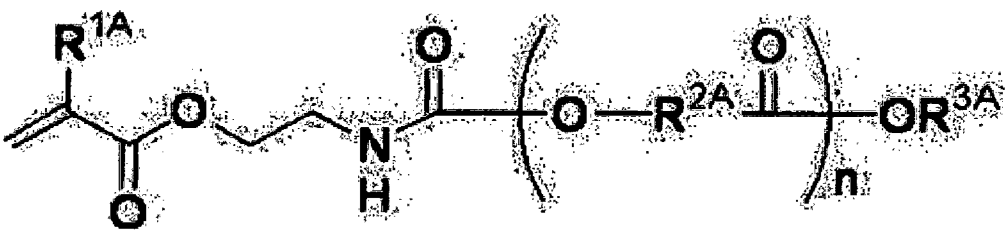

worin $R^{1A}$ ein Wasserstoffatom oder eine Methylgruppe darstellt; $R^{2A}$ eine Alkylengruppe darstellt; $R^{3A}$ eine Alkylgruppe darstellt; n eine ganze Zahl von 5 bis 100 darstellt; und mehrere in einem Molekül vorliegende $R^{2A}$ gleich oder voneinander verschieden sein können.

**3.** Schwarze, strahlungsempfindliche Zusammensetzung für ein Festkörper-Bildgebungselement, wobei die Zusammensetzung umfasst:

eine wie in Anspruch 1 oder Anspruch 2 definierte Titanschwarz-Dispersionszusammensetzung;

(D) eine polymerisierbare Verbindung; und
(E) einen Fotopolymerisationsinitiator.

**4.** Verwendung der wie in Anspruch 3 definierten schwarzen, strahlungsempfinglichen Zusammensetzung zum Bilden eines schwarzen, gehärteten Films.

**5.** Verfahren zur Herstellung eines schwarzen, gehärteten Films, umfassend die Schritte:

Auftragen der wie in Anspruch 3 definierten schwarzen, strahlungsempfindlichen Zusammensetzung auf ein Silikonsubstrat, um eine schwarze strahlungsempfindliche Zusammensetzungsschicht zu bilden;
Unterziehen der schwarzen, strahlungsempfindlichen Zusammensetzungsschicht unter eine Musterbelichtung; und
Entwickeln der schwarzen, strahlungsempfindlichen Zusammensetzungsschicht nach der Belichtung, um ein Muster zu bilden.

## Revendications

**1.** Composition de dispersion au noir de titane pour un élément d'imagerie à semi-conducteur, la composition comprenant :

(A) des particules, ou des agrégats de particules, qui comprennent des atomes de Si et du noir de titane sous la forme de particules noires ayant des atomes de titane, les particules ou les agrégats de particules ayant une superficie spécifique BET dans la plage de 55 $m^2/g$ à 84 $m^2/g$, et un rapport d'atomes de Si sur atomes de Ti (atomes de Si / atomes de Ti) dans la plage de 0,20 à 0,41:1 mesuré selon le procédé exposé dans la section intitulée « Rapport Si/Ti » dans la section Exemples de la description ;
(B) un dispersant copolymère amphotère d'un monomère (b-1) ayant au moins un groupe sélectionné à partir d'un groupe d'amino ou d'un groupe hétérocyclique contenant de l'azote, d'un monomère (b-2) ayant un groupe carboxyle, et d'un macromonomère (b-3) ayant une masse moléculaire moyenne en poids de 1000 à 50 000 ; et
(C) un solvant organique.

**2.** Composition de dispersion au noir de titane selon la revendication 1, dans laquelle le macromonomère (b-3) est un macromonomère de polyester représenté par la formule :

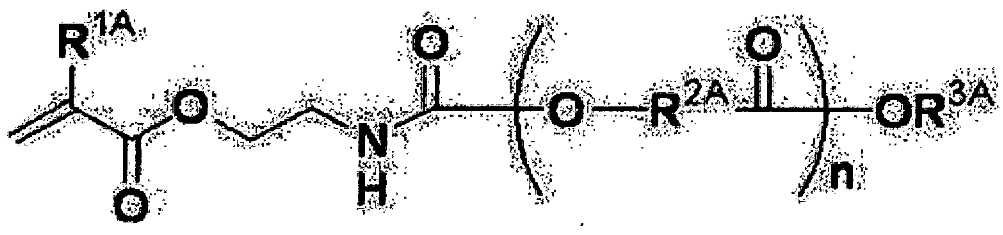

dans laquelle $R^{1A}$ représente un atome d'hydrogène ou un groupe méthyle ; $R^{2A}$ représente un groupe alkylène ; $R^{3A}$ représente un groupe alkyle ; n représente un entier de 5 à 100 ; et plusieurs $R^{2A}$ présents dans une molécule peuvent être les mêmes ou différents les uns des autres.

**3.** Composition sensible au rayonnement noir pour un élément d'imagerie à semi-conducteur, la composition comprenant :

la composition de dispersion au noir de titane selon la revendication 1 ou la revendication 2 ;

(D) un composé pouvant être polymérisé ; et
(E) un initiateur de photopolymérisation.

**4.** Utilisation de la composition sensible au rayonnement noir selon la revendication 3 pour former un film durci noir.

**5.** Procédé de production d'un film durci noir comprenant les étapes :

d'application de la composition sensible au rayonnement noir selon la revendication 3 sur un substrat de silicone pour former une couche de composition sensible au rayonnement noir;
soumission de la couche de composition sensible au rayonnement noir à une exposition à de la lumière de formation de motif; et
développement de la couche de composition sensible au rayonnement noir après l'exposition à de la lumière pour former un motif.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2007115921 A
- JP 2002285007 A
- JP 2007302836 A
- WO 2011049090 A
- EP 2492716 A
- JP 2006182627 A
- JP 2008266045 A
- JP 49005432 A
- JP 57205322 A
- JP 60065069 A
- JP 61201610 A
- JP 2272009 A
- JP 2009288705 A
- JP 48041708 B
- JP 50006034 B
- JP 51037193 A
- JP 48064183 A
- JP 49043191 B
- JP 52030490 B
- JP 2010160418 A
- JP 2010129825 A
- JP 4364216 B
- JP 2008292970 A
- JP 2007269779 A
- JP 10062986 A
- JP 2032293 B
- JP 2016765 B
- JP 58049860 B
- JP 56017654 B
- JP 62039417 B
- JP 62039418 B
- JP 63277653 A
- JP 63260909 A
- JP 1105238 A
- GB 1388492 A
- JP 53133428 A
- DE 3337024
- JP 62058241 A
- JP 5281728 A
- JP 5034920 A
- US 4212976 A
- JP 5019475 A
- JP 7271028 A
- JP 2002363206 A
- JP 2002363207 A
- JP 2002363208 A
- JP 2002363209 A
- JP 57001819 B
- JP 57006096 B
- US 3615455 A
- JP 10291969 A
- JP 4225898 B
- JP 2009191179 A
- JP 2001233842 A
- JP 2000080068 A
- JP 2006342156 A
- JP 2000066385 A
- JP 2004534797 A
- JP 2006342166 A
- JP 2009519904 A
- US 7626957 B
- JP 2010015025 A
- US 2009292039 A
- WO 2009131189 A
- US 7556910 B
- JP 2009221114 A
- JP 2007231000 A
- JP 2007322744 A
- JP 2010032985 A
- JP 2010185072 A
- JP 2009242469 A
- JP 2009191061 A
- JP 10300922 A
- JP 2002229207 A
- JP 2003335814 A
- JP 7140654 A
- JP 2008224982 A
- JP 6490403 A
- JP 6491102 A
- JP 1094301 A
- JP 6011614 A
- JP 2592207 B
- US 4808501 A
- US 5667920 A
- US 5059500 A
- JP 5333207 A
- JP 6035183 A
- JP 6051115 A
- JP 6194828 A
- JP 8211599 A
- JP 4249549 A
- JP 10123316 A
- JP 11302283 A
- JP 7286107 A
- JP 2001004823 A
- JP 8015522 A
- JP 8029771 A
- JP 8146215 A

- JP 11343437 A
- JP 8062416 A
- JP 2002014220 A
- JP 2002014221 A
- JP 2002014222 A
- JP 2002014223 A
- JP 8302224 A
- JP 8073758 A
- JP 8179120 A
- JP 8151531 A
- JP 2008214395 A

**Non-patent literature cited in the description**


- **WAKABAYASHI.** *Bull. Chem. Soc. Japan,* 1969, vol. 42, 2924
- **F. C. SCHAEFER.** *J. Org. Chem.,* 1964, vol. 29, 1527
- *J. C. S. Perkin II,* 1979, 1653-1660
- *J. C. S. Perkin II,* 1979, 156-162
- *Journal of Photopolymer Science and Technology,* 1995, 202-232